# EUROPÄISCHE PATENTSCHRIFT

(11) **EP 3 238 286 B1**
(45) Veröffentlichungstag und Bekanntmachung des Hinweises auf die Patenterteilung: **17.01.2024**
(21) Anmeldenummer: 15805398.3
(22) Anmeldetag: 08.12.2015
(51) Int. Cl.: H10K 85/60, H10K 50/155, H10K 10/46, H10K 30/00

(54) **MATERIALIEN FÜR ELEKTRONISCHE VORRICHTUNGEN**
MATERIALS FOR ELECTRONIC DEVICES
MATÉRIAUX POUR DISPOSITIFS ÉLECTRONIQUES

(30) Priorität: 22.12.2014 EP 14004355
(43) Veröffentlichungstag der Anmeldung: 01.11.2017
(73) Patentinhaber: Merck Patent GmbH, 64293 Darmstadt (DE)
(72) Erfinder: PFISTER, Jochen, 64342 Seeheim-Jugenheim (DE); STIEBER, Frank, 64683 Einhausen (DE); MONTENEGRO, Elvira, 69469 Weinheim (DE); MUJICA-FERNAUD, Teresa, 64293 Darmstadt (DE)
(74) Vertreter: Merck Patent Association
(86) Internationale Anmeldenummer: PCT/EP2015/002475
(87) Internationale Veröffentlichungsnummer: WO 2016/102048

(56) Entgegenhaltungen:
- EP-A1- 2 799 515
- WO-A1-2013/120577
- WO-A1-2014/129846

## Beschreibung

Die vorliegenden Anmeldung betrifft ein Spirobifluoren-Derivat einer im Folgenden definierten Formel (I), welches sich zur Verwendung in elektronischen Vorrichtungen, insbesondere organischen Elektrolumineszenzvorrichtungen (OLEDs) eignet.

Unter elektronischen Vorrichtungen im Sinne dieser Anmeldung werden sogenannte organische elektronische Vorrichtungen verstanden (organic electronic devices), welche organische Halbleitermaterialien als Funktionsmaterialien enthalten. Insbesondere werden darunter OLEDs verstanden.

Der Aufbau von OLEDs, in denen organische Verbindungen als funktionelle Materialien eingesetzt werden, ist beispielsweise in US 4539507, US 5151629, EP 0676461 und WO 98/27136 beschrieben. Allgemein werden unter der Bezeichnung OLEDs elektronische Vorrichtungen verstanden, welche eine oder mehrere Schichten enthaltend organische Verbindungen aufweisen und unter Anlegen von elektrischer Spannung Licht emittieren.

Bei elektronischen Vorrichtungen, insbesondere OLEDs, besteht großes Interesse an der Verbesserung der Leistungsdaten, insbesondere Lebensdauer, Effizienz und Betriebsspannung. In diesen Punkten konnte noch keine vollständig zufriedenstellende Lösung gefunden werden.

Einen großen Einfluss auf die Leistungsdaten von elektronischen Vorrichtungen haben Schichten mit lochtransportierender Funktion, wie beispielsweise lochinjizierende Schichten, Lochtransportschichten, Elektronenblockierschichten und auch emittierende Schichten. Zur Verwendung in diesen Schichten werden kontinuierlich neue Materialien mit lochtransportierenden Eigenschaften gesucht.

Es ist im Stand der Technik bekannt, Triarylamine als Materialien mit lochtransportierenden Eigenschaften in diesen Schichten einzusetzen. Die Triarylamine können Mono-Triarylamine darstellen, wie beispielsweise in JP 1995/053955, WO 2006/123667 und JP 2010/222268 beschrieben, oder Bis- oder andere Oligoamine darstellen, wie beispielsweise in US 7504163 oder US 2005/0184657 beschrieben. Bekannte Beispiele für Triarylamin-Verbindungen als Materialien mit lochtransportierenden Eigenschaften für OLEDs sind unter anderem Tris-p-biphenyl-amin, N,N'-Di-1-naphthyl-N,N'-diphenyl-1,1'-biphenyl-4,4'-diamin (NPB) und 4,4',4"-Tris-(3-methylphenyl-phenylamino)triphenylamin (MTDATA).

Weiterhin im Stand der Technik bekannt ist die Verwendung von Spirobifluoren-Arylaminoverbindungen in OLEDs, unter anderem als Lochtransportmaterialien (EP 2799515, WO 2012/034627, WO 2013/120577 und WO 2014/129846).

Im Rahmen von Untersuchungen zu neuartigen Materialien zur Verwendung in OLEDs wurde nun überraschend gefunden, dass sich Verbindungen mit Arylamin- oder Carbazolgruppe, die eine Spirobifluoren-Einheit ankondensiert an eine Benzothiophen-Einheit aufweisen, hervorragend zur Verwendung in OLEDs eignen, insbesondere als Materialien mit lochtransportierender Funktion.

Die gefundenen Verbindungen weisen eine oder mehrere Eigenschaften gewählt aus sehr guten lochleitenden Eigenschaften, sehr guten elektronenblockierenden Eigenschaften, hoher Glasübergangstemperatur, hoher Oxidationsstabilität, guter Löslichkeit und hoher Temperaturstabilität auf. Bei der Verwendung der gefundenen Verbindungen in OLEDs, insbesondere in lochtransportierender Funktion, werden sehr gute Device-Performance-Daten, insbesondere sehr gute Lebensdauer und Quanteneffizienz der Vorrichtungen beobachtet.

Gegenstand der vorliegenden Erfindung ist daher eine Verbindung der Formel (I) 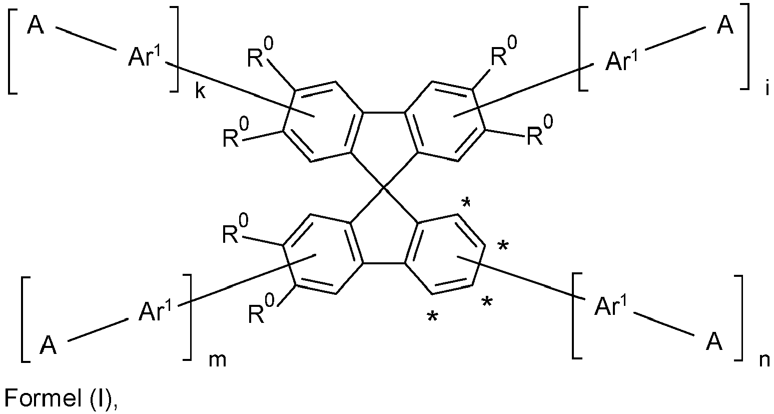
- die eine Gruppe der Formel (T) 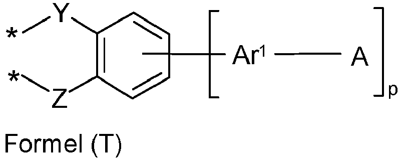 gebunden an zwei benachbarten mit * markierten Positionen an der Grundstruktur gemäß Formel (I) aufweist, wobei die Ankondensation derart ist, dass eine mit * markierte Bindung in Formel (T) jeweils an eine mit * markierte Position an der Grundstruktur gemäß Formel (I) anknüpft;
- die an einer oder mehreren unsubstituiert dargestellten Positionen an der Grundstruktur gemäß Formel (I) und der Gruppe der Formel (T) mit einem Rest R¹ substituiert sein kann; und
- die die folgenden Definitionen der Variablen aufweist:
   - A: ist bei jedem Auftreten gleich oder verschieden eine Gruppe der Formel (A1), (A2) oder (A3), die über die mit # markierte Bindung gebunden ist, und die an einer oder mehreren unsubstituiert dargestellten Positionen mit einem Rest R² substituiert sein kann;

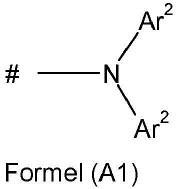

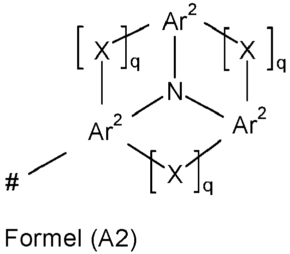

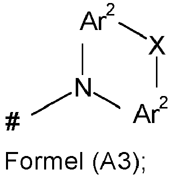

- Ar¹: ist bei jedem Auftreten gleich oder verschieden eine Einfachbindung oder ein aromatisches oder heteroaromatisches Ringsystem mit 6 bis 30 aromatischen Ringatomen, das mit einem oder mehreren Resten R² substituiert sein kann;
- Ar²: ist bei jedem Auftreten gleich oder verschieden ein aromatisches oder heteroaromatisches Ringsystem mit 6 bis 30 aromatischen Ringatomen, das mit einem oder mehreren Resten R² substituiert sein kann;
- X: ist bei jedem Auftreten gleich oder verschieden eine Einfachbindung oder eine Gruppe gewählt aus BR², C(R²)₂, Si(R²)₂, C=O, O, S, S=O, SO₂, NR², PR² oder P(=O)R²;
- Y: ist gewählt aus O, S und Se;

- Z: ist gewählt aus O, S, Se und einer Einfachbindung, wobei Z nicht eine Einfachbindung ist, wenn Y gleich O ist;
- R⁰: ist H;

- R¹: ist bei jedem Auftreten gleich oder verschieden gewählt aus H, D, F, C(=O)R³, CN, Si(R³)₃, P(=O)(R³)₂, OR³, S(=O)R³, S(=O)₂R³, gerad-kettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und hetero-aromatischen Ringsystemen mit 5 bis 40 aromatischen Ringatomen; wobei zwei oder mehr Reste R¹ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³), -O-, -S-, SO oder SO₂ ersetzt sein können;
- R²: ist bei jedem Auftreten gleich oder verschieden gewählt aus H, D, F, C(=O)R³, CN, Si(R³)₃, N(R³)₂, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxygruppen mit 3 bis 20 CAtomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R² miteinander verknüpft sein können und einen Ring bilden können; wobei die genannten Alkyl, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³), -O-, -S-, SO oder SO₂ ersetzt sein können;
- R³: ist bei jedem Auftreten gleich oder verschieden gewählt aus H, D, F, C(=O)R⁴, CN, Si(R⁴)₃, N(R⁴)₂, P(=O)(R⁴)₂, OR⁴, S(=O)R⁴, S(=O)₂R⁴, geradkettigen Alkyl- oder Alkoxygruppen mit 1 bis 20 C-Atomen, verzweigten oder cyclischen Alkyl- oder Alkoxygruppen mit 3 bis 20 CAtomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ bzw. R² miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R⁴ substituiert sein können; und wobei eine oder mehrere CH₂-Gruppen in den genannten Alkyl-, Alkoxy-, Alkenyl- und Alkinylgruppen durchR⁴C=CR⁴-, -C=C-, Si(R⁴)₂, C=O, C=NR⁴, -C(=O)O-, -C(=O)NR⁴-, NR⁴, P(=O)(R⁴), -O-, -S-, SO oder SO₂ ersetzt sein können;
- R⁴: ist bei jedem Auftreten gleich oder verschieden gewählt aus H, D, F, CN, Alkylgruppen mit 1 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R⁴ miteinander verknüpft sein können und einen Ring bilden können; und wobei die genannten Alkylgruppen, aromatischen Ringsysteme und heteroaromatischen Ringsysteme mit F oder CN substituiert sein können;
- q: ist bei jedem Auftreten gleich oder verschieden 0 oder 1, wobei mindestens ein q in Formel (A2) gleich 1 ist;
i, k, m, n und p sind bei jedem Auftreten gleich oder verschieden 0 oder 1, wobei mindestens einer dieser Indices gleich 1 ist und wobei die Gruppen in eckigen Klammern mit Index i, k, m, n und p nur in solchen Positionen am Spirobifluoren-Grundgerüst gebunden sein können, die unsubstituiert gekennzeichnet sind.

Die Gruppen in eckigen Klammern mit Index i, k, m, n und p können generell, auch für die folgenden Strukturen, nur in solchen Positionen am Spirobifluoren-Grundgerüst gebunden sein, die unsubstituiert gezeichnet sind. Insbesondere können sie nicht in Positionen gebunden sein, die einen Rest R⁰ tragen.

Eine Arylgruppe im Sinne dieser Erfindung enthält 6 bis 40 aromatische Ringatome, von denen keines ein Heteroatom darstellt. Unter einer Arylgruppe im Sinne dieser Erfindung wird entweder ein einfacher aromatischer Cyclus, also Benzol, oder ein kondensierter aromatischer Polycyclus, beispielsweise Naphthalin, Phenanthren oder Anthracen, verstanden. Ein kondensierter aromatischer Polycyclus besteht im Sinne der vorliegenden Anmeldung aus zwei oder mehr miteinander kondensierten einfachen aromatischen Cyclen. Unter Kondensation zwischen Cyclen ist dabei zu verstehen, dass die Cyclen mindestens eine Kante miteinander teilen.

Eine Heteroarylgruppe im Sinne dieser Erfindung enthält 5 bis 40 aromatische Ringatome, von denen mindestens eines ein Heteroatom darstellt. Die Heteroatome der Heteroarylgruppe sind bevorzugt ausgewählt aus N, O und S. Unter einer Heteroarylgruppe im Sinne dieser Erfindung wird entweder ein einfacher heteroaromatischer Cyclus, beispielsweise Pyridin, Pyrimidin oder Thiophen, oder ein kondensierter heteroaromatischer Polycyclus, beispielsweise Chinolin oder Carbazol, verstanden. Ein kondensierter heteroaromatischer Polycyclus besteht im Sinne der vorliegenden Anmeldung aus zwei oder mehr miteinander kondensierten einfachen heteroaromatischen Cyclen. Unter Kondensation zwischen Cyclen ist dabei zu verstehen, dass die Cyclen mindestens eine Kante miteinander teilen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Triphenylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Ein aromatisches Ringsystem im Sinne dieser Erfindung enthält 6 bis 40 C-Atome im Ringsystem und umfasst keine Heteroatome als aromatische Ringatome. Ein aromatisches Ringsystem im Sinne dieser Erfindung enthält daher keine Heteroarylgruppen. Unter einem aromatischen Ringsystem im Sinne dieser Erfindung soll ein System verstanden werden, das nicht notwendigerweise nur Arylgruppen enthält, sondern in dem auch mehrere Arylgruppen durch eine Einfachbindung oder durch eine nicht-aromatische Einheit, wie beispielsweise ein oder mehrere wahlweise substituierte C-, Si-, N-, O- oder S-Atome, verbunden sein können. Dabei umfasst die nicht-aromatische Einheit bevorzugt weniger als 10 % der von H verschiedenen Atome, bezogen auf die Gesamtzahl der von H verschiedenen Atome des Systems. So sollen beispielsweise auch Systeme wie 9,9'-Spirobifluoren, 9,9'-Diarylfluoren, Triarylamin, Diarylether und Stilben als aromatische Ringsysteme im Sinne dieser Erfindung verstanden werden, und ebenso Systeme, in denen zwei oder mehr Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Arylgruppen über Einfachbindungen miteinander verknüpft sind, als aromatische Ringsysteme im Sinne dieser Erfindung verstanden, wie beispielsweise Systeme wie Biphenyl und Terphenyl.

Ein heteroaromatisches Ringsystem im Sinne dieser Erfindung enthält 5 bis 40 aromatische Ringatome, von denen mindestens eines ein Heteroatom darstellt. Die Heteroatome des heteroaromatischen Ringsystems sind bevorzugt ausgewählt aus N, O und/oder S. Ein heteroaromatisches Ringsystem entspricht der oben genannten Definition eines aromatischen Ringsystems, weist jedoch mindestens ein Heteroatom als eines der aromatischen Ringatome auf. Es unterscheidet sich dadurch von einem aromatischen Ringsystem im Sinne der Definition der vorliegenden Anmeldung, welches gemäß dieser Definition kein Heteroatom als aromatisches Ringatom enthalten kann.

Unter einem aromatischen Ringsystem mit 6 bis 40 aromatischen Ringatomen oder einem heteroaromatischen Ringsystem mit 5 bis 40 aromatischen Ringatomen, werden insbesondere Gruppen verstanden, die abgeleitet sind von den oben unter Arylgruppen und Heteroarylgruppen genannten Gruppen sowie von Biphenyl, Terphenyl, Quaterphenyl, Fluoren, Spirobifluoren, Dihydrophenanthren, Dihydropyren, Tetrahydropyren, Indenofluoren, Truxen, Isotruxen, Spirotruxen, Spiroisotruxen, Indenocarbazol, oder von Kombinationen dieser Gruppen.

Im Rahmen der vorliegenden Erfindung werden unter einer geradkettigen Alkylgruppe mit 1 bis 20 C-Atomen bzw. einer verzweigten oder cyclischen Alkylgruppe mit 3 bis 20 C-Atomen bzw. einer Alkenyl- oder Alkinylgruppe mit 2 bis 40 C-Atomen, in der auch einzelne H-Atome oder CH₂-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neo-Pentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden.

Unter einer Alkoxy- oder Thioalkylgruppe mit 1 bis 20 C-Atomen, in der auch einzelne H-Atome oder CH₂-Gruppen durch die oben bei der Definition der Reste genannten Gruppen substituiert sein können, werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet.

Es ist bevorzugt, dass A eine Gruppe der Formel (A-1) oder (A-3) ist, besonders bevorzugt eine Gruppe der Formel (A-1).

Es ist bevorzugt, dass Ar¹ bei jedem Auftreten gleich oder verschieden gewählt ist aus einer Einfachbindung oder einer divalenten Gruppe abgeleitet von wahlweise mit Resten R² substituiertem Benzol, Biphenyl, Terphenyl, Fluoren, Spirobifluoren, Indenofluoren, Carbazol, Dibenzofuran, Dibenzothiophen, oder einer Kombination von zwei oder mehr dieser Gruppen, wobei jedoch nicht mehr als 30 aromatische Ringatome in Ar¹ vorliegen dürfen.

Gruppen Ar¹ sind bevorzugt gewählt aus Gruppen der folgenden Formeln: 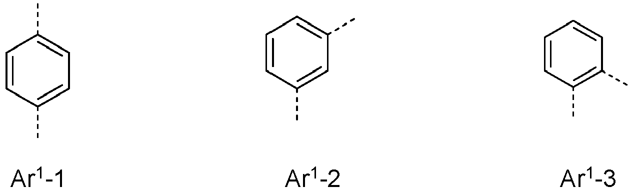 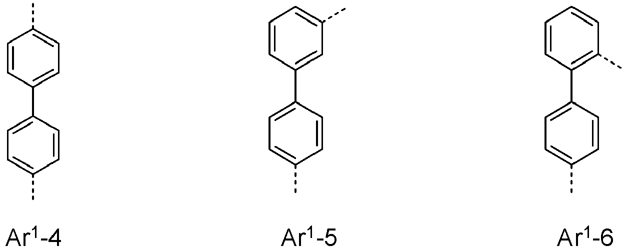 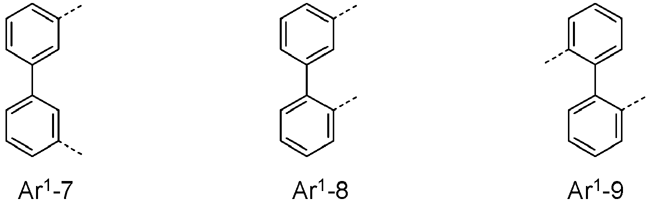 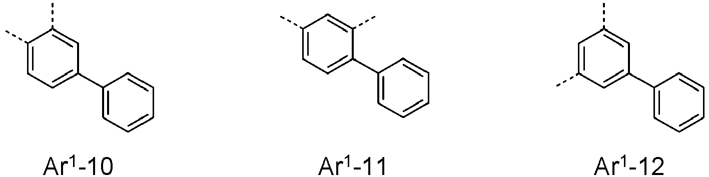 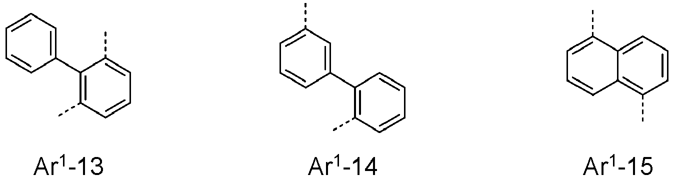 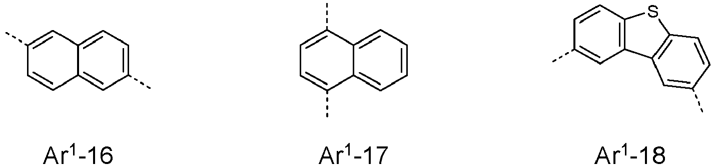 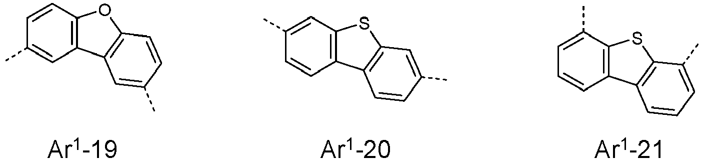 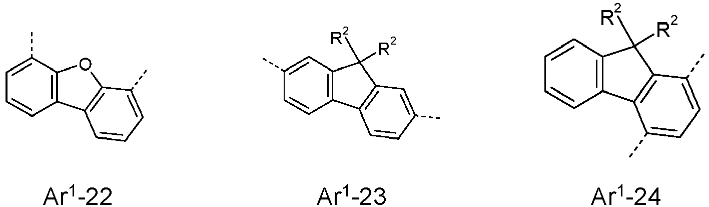 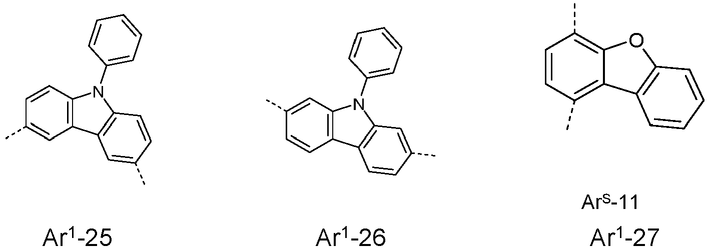 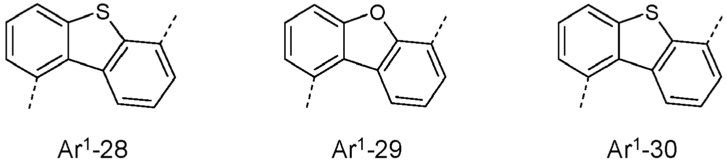 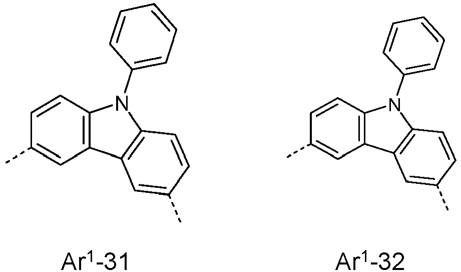 wobei die gestrichelten Bindungen die Bindungen an den Rest der Verbindung darstellen und die Gruppen an den freien Positionen durch einen oder mehrere Reste R² substituiert sein können, bevorzugt an den freien Positionen aber unsubstituiert sind.

Dabei steht R² in den Gruppen der Formeln (Ar¹-23) und (Ar¹-24) bevorzugt gleich oder verschieden für eine Alkylgruppe mit 1 bis 10 C-Atomen, insbesondere für Methyl, oder für eine Phenylgruppe, die mit einem oder mehreren Resten R³ substituiert sein kann und bevorzugt unsubstituiert ist. Zwei Alkylgruppen R² können dabei auch unter Ausbildung einer Spiro-Gruppe einen Ring bilden, bevorzugt einen Cyclohexylring oder einen Cyclopentylring.

Es ist bevorzugt, dass Ar² bei jedem Auftreten gleich oder verschieden gewählt ist aus einem aromatischen oder heteroaromatischen Ringsystem mit 6 bis 25 aromatischen Ringatomen, das mit einem oder mehreren Resten R² substituiert sein kann. Besonders bevorzugt sind Phenyl, Biphenyl, Terphenyl, Fluorenyl, Spirobifluorenyl, Indenofluorenyl, Naphthyl, Phenanthrenyl, Furanyl, Benzofuranyl, Dibenzofuranyl, Thiophenyl, Benzothiophenyl, Dibenzothiophenyl, Carbazolyl, Indolocarbazolyl und Indenocarbazolyl, welche jeweils mit einem oder mehreren Resten R² substituiert sein können.

Gruppen Ar² sind bevorzugt gleich oder verschieden bei jedem Auftreten gewählt aus Gruppen der folgenden Formeln:

| | | |
|---|---|---|
| 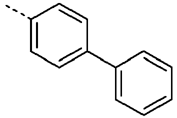 | 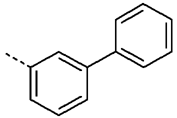 | 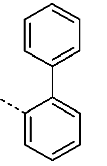 |
| Ar²-1 | Ar²-2 | Ar²-3 |
| | | |
| 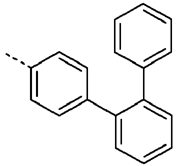 | 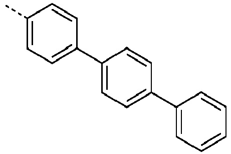 | 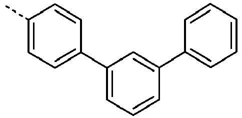 |
| Ar²-4 | Ar²-5 | Ar²-6 |
| | | |
| 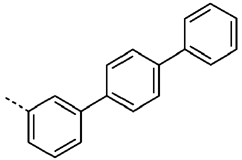 | 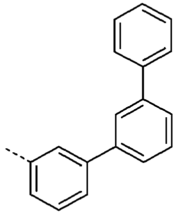 | 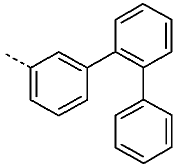 |
| Ar²-7 | Ar²-8 | Ar²-9 |
| | | |
| 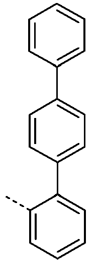 | 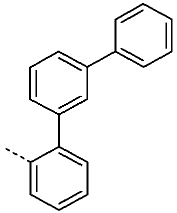 | 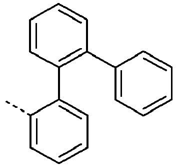 |
| Ar²-10 | Ar²-11 | Ar²-12 |
| | | |
| 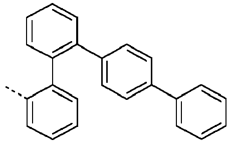 | 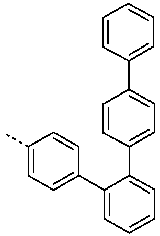 | 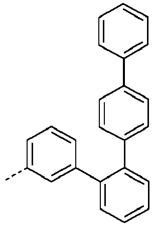 |
| Ar²-13 | Ar²-14 | Ar²-15 |
| | | |
| 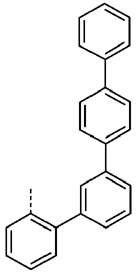 | 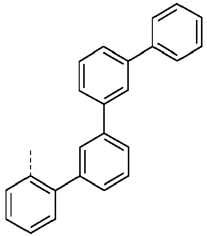 | 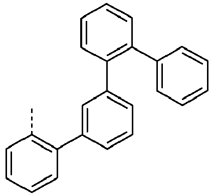 |
| Ar²-16 | Ar²-17 | Ar²-18 |
| | | |
| 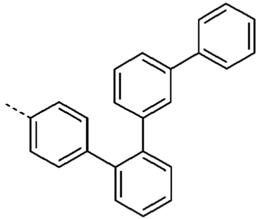 | 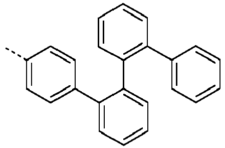 | 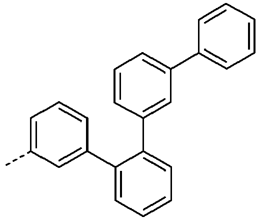 |
| Ar²-19 | Ar²-20 | Ar²-21 |
| | | |
| 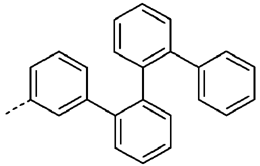 | 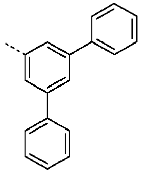 | 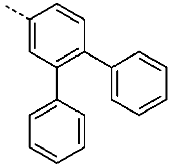 |
| Ar²-22 | Ar²-23 | Ar²-24 |
| | | |
| 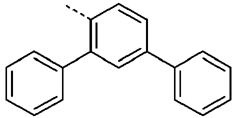 | 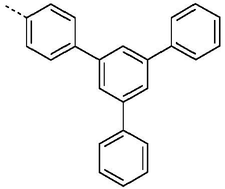 | 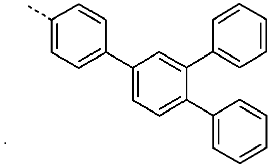 |
| Ar²-25 | Ar²-26 | Ar²-27 |
| | | |
| 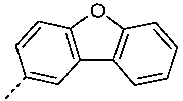 | 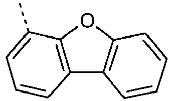 | 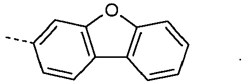 |
| Ar²-28 | Ar²-29 | Ar²-30 |
| | | |
| 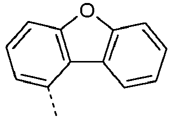 | 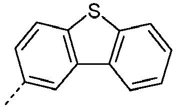 | 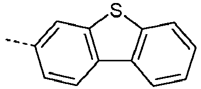 |
| Ar²-31 | Ar²-32 | Ar²-33 |
| | | |
| 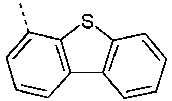 | 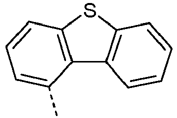 | 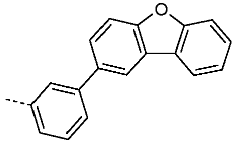 |
| Ar²-34 | Ar²-35 | Ar²-36 |
| | | |
| 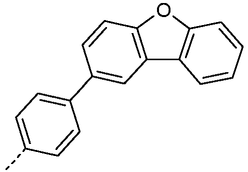 | 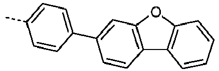 | 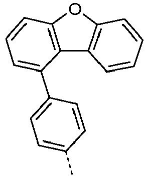 |
| Ar²-37 | Ar²-38 | Ar²-39 |
| | | |
| 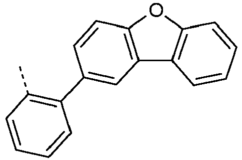 | 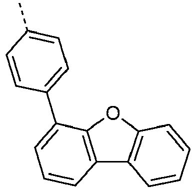 | 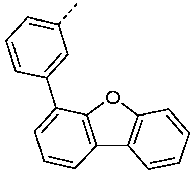 |
| Ar²-40 | Ar²-41 | Ar²-42 |
| | | |
| 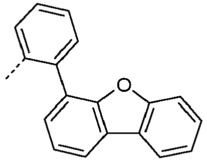 | 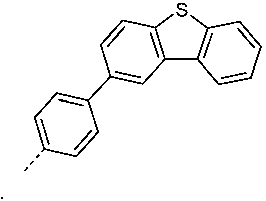 | 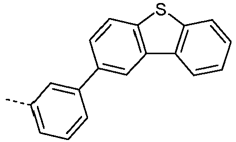 |
| Ar²-43 | Ar²-44 | Ar²-45 |
| | | |
| 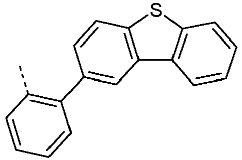 | 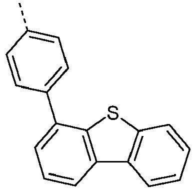 | 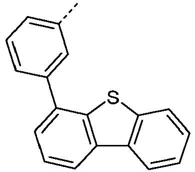 |
| Ar²-46 | Ar²-47 | Ar²-48 |
| | | |
| 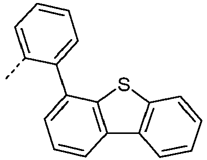 | 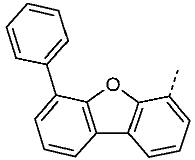 | 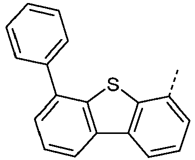 |
| Ar²-49 | Ar²-50 | Ar²-51 |
| | | |
| 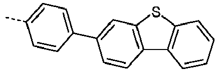 | 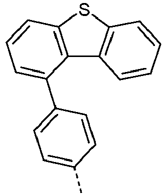 | 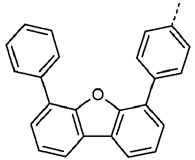 |
| Ar²-52 | Ar²-53 | Ar²-54 |
| | | |
| 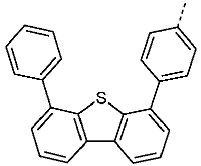 | 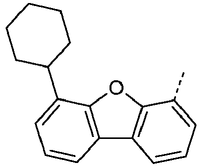 | 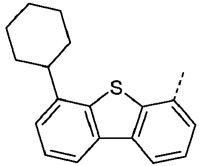 |
| Ar²-55 | Ar²-56 | Ar²-57 |
| | | |
| 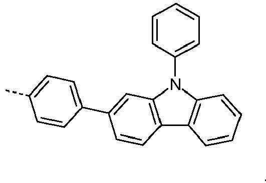 | 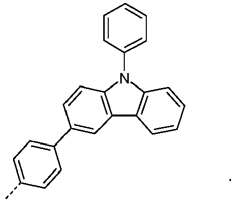 | 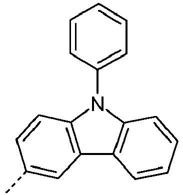 |
| Ar²-58 | Ar²-59 | Ar²-60 |
| | | |
| 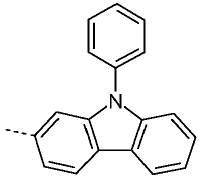 | 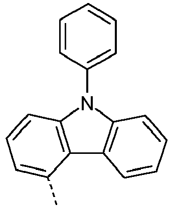 | 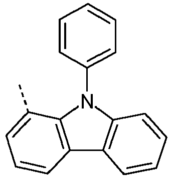 |
| Ar²-61 | Ar²-62 | Ar²-63 |
| | | |
| 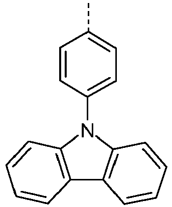 | 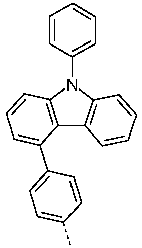 | 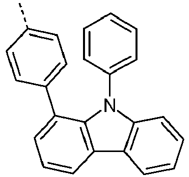 |
| Ar²-64 | Ar²-65 | Ar²-66 |
| | | |
| 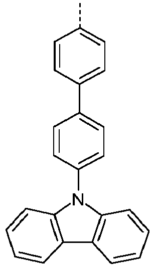 | 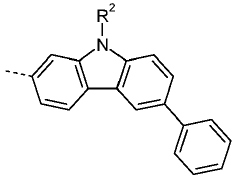 | 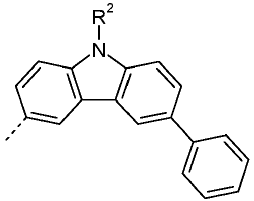 |
| Ar²-67 | Ar²-68 | Ar²-69 |
| | | |
| 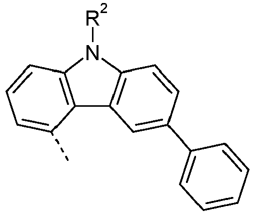 | 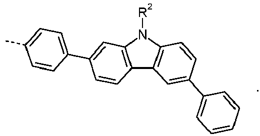 | 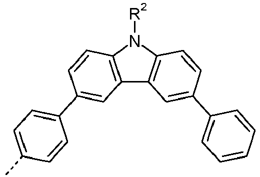 |
| Ar²-70 | Ar²-71 | Ar²-72 |
| | | |
| 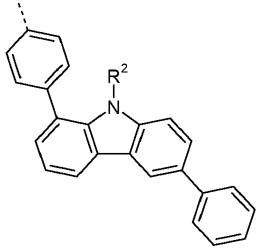 | 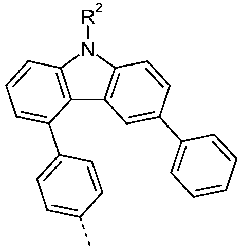 | 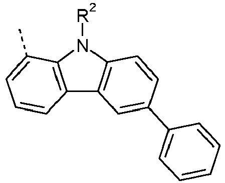 |
| Ar²-73 | Ar²-74 | Ar²-75 |
| | | |
| 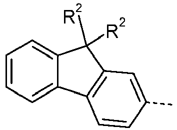 | 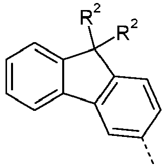 | 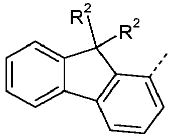 |
| Ar²-76 | Ar²-77 | Ar²-78 |
| | | |
| 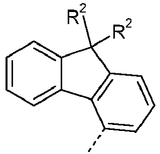 | 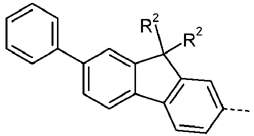 | 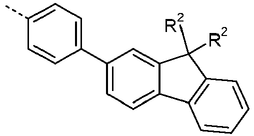 |
| Ar²-79 | Ar²-80 | Ar²-81 |
| | | |
| 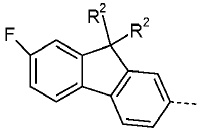 | 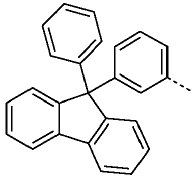 | 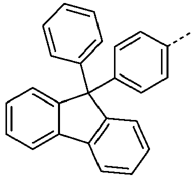 |
| Ar²-82 | Ar²-83 | Ar²-84 |
| | | |
| 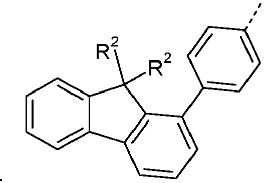 | 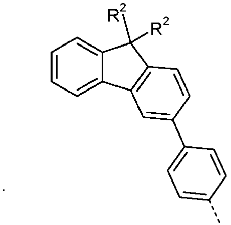 | 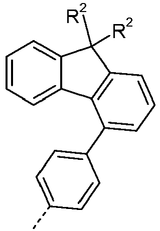 |
| Ar²-85 | Ar²-86 | Ar²-87 |
| | | |
| 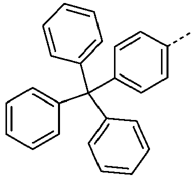 | 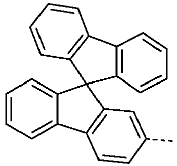 | 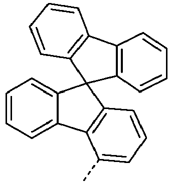 |
| Ar²-88 | Ar²-89 | Ar²-90 |
| | | |
| 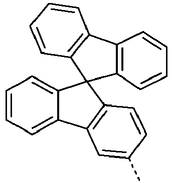 | 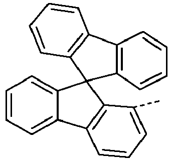 | 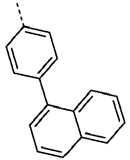 |
| Ar²-91 | Ar²-92 | Ar²-93 |
| | | |
| 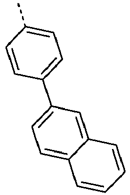 | 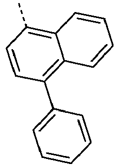 | 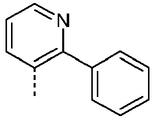 |
| Ar²-94 | Ar²-95 | Ar²-96 |
| | | |
| 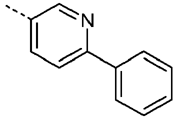 | 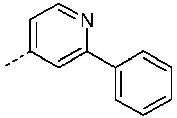 | 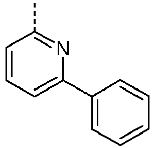 |
| Ar²-97 | Ar²-98 | Ar²-99 |
| | | |
| 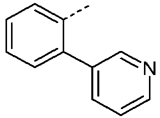 | 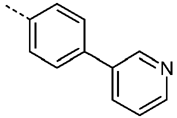 | 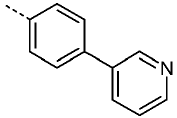 |
| Ar²-100 | Ar²-101 | Ar²-102 |
| | | |
| 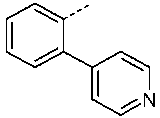 | 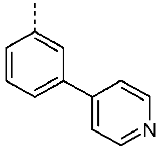 | 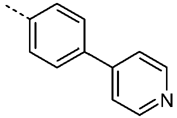 |
| Ar²-103 | Ar²-104 | Ar²-105 |
| | | |
| 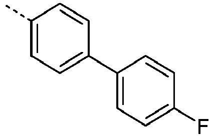 | 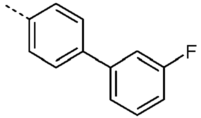 | 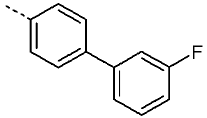 |
| Ar²-106 | Ar²-107 | Ar²-108 |
| | | |
| 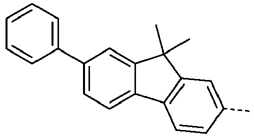 | 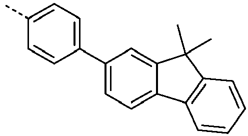 | 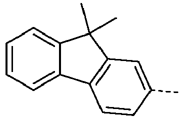 |
| Ar²-109 | Ar²-110 | Ar²-111 |
| | | |
| 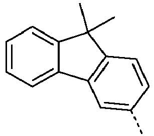 | 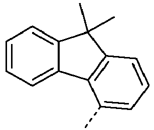 | 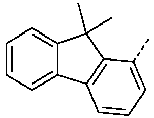 |
| Ar²-112 | Ar²-113 | Ar²-114 |
| | | |
| 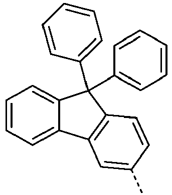 | 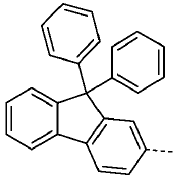 | 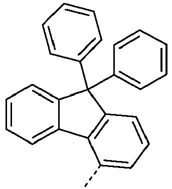 |
| Ar²-115 | Ar²-116 | Ar²-117 |
| | | |
| 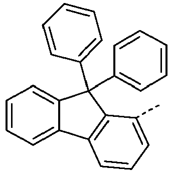 | 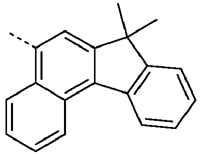 | 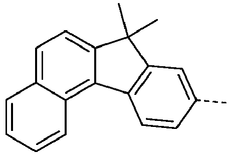 |
| Ar²-118 | Ar²-119 | Ar²-120 |
| | | |
| 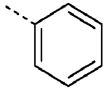 | 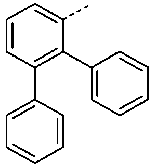 | 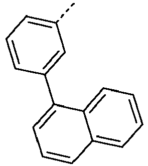 |
| Ar²-121 | Ar²-122 | Ar²-123 |
| | | |
| 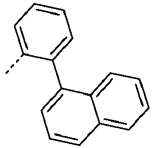 | 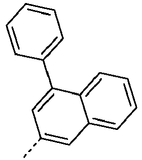 | 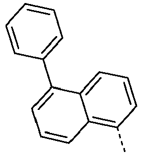 |
| Ar²-124 | Ar²-125 | Ar²-126 |
| | | |
| 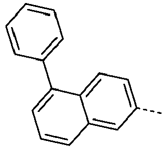 | 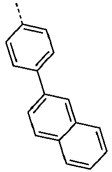 | 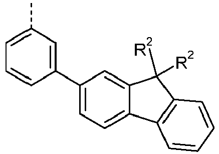 |
| Ar²-127 | Ar²-128 | Ar²-129 |
| | | |
| 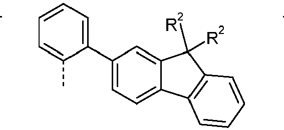 | 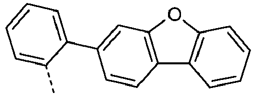 | 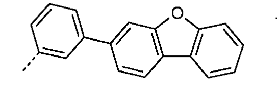 |
| Ar²-130 | Ar²-131 | Ar²-132 |
| | | |
| 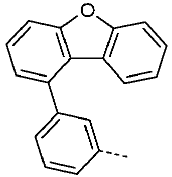 | 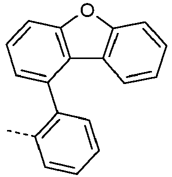 | |
| Ar²-133 | Ar²-134 | |

wobei die gestrichelte Bindung die Bindung an den Stickstoff darstellt und die Gruppen an den freien Positionen durch einen oder mehrere Reste R² substituiert sein können, bevorzugt an den freien Positionen aber unsubstituiert sind.

Dabei steht R² in den Gruppen der Formeln (Ar²-68) bis (Ar²-82), (Ar²-85) bis (Ar²-87), (Ar²-129) und (Ar²-130) bevorzugt gleich oder verschieden für eine Alkylgruppe mit 1 bis 10 C-Atomen, insbesondere für Methyl, oder eine Phenylgruppe, die mit einem oder mehreren Resten R³ substituiert sein kann und bevorzugt unsubstituiert ist. Zwei Alkylgruppen R² können dabei auch unter Ausbildung einer Spiro-Gruppe einen Ring bilden, bevorzugt einen Cyclohexylring oder einen Cyclopentylring.

Es ist bevorzugt, dass X bei jedem Auftreten gleich oder verschieden gewählt ist aus einer Einfachbindung oder einer Gruppe gewählt aus C(R²)₂, C=O, O, S und NR², besonders bevorzugt ist X eine Einfachbindung.

Bevorzugt ist R¹ und R² bei jedem Auftreten gleich oder verschieden H, D, F, CN, Si(R³)₃, eine geradkettige Alkyl- oder Alkoxygruppe mit 1 bis 10 C-Atomen, eine verzweigte oder cyclische Alkyl- oder Alkoxygruppe mit 3 bis 10 C-Atomen, oder ein aromatisches oder heteroaromatisches Ringsystem mit 6 bis 30 aromatischen Ringatomen, wobei zwei oder mehr Reste R¹ bzw. R² miteinander verknüpft sein können und einen Ring bilden können, wobei die genannten Alkyl- und Alkoxygruppen und die genannten aromatischen und heteroaromatischen Ringsysteme jeweils mit einem oder mehreren Resten R³ substituiert sein können, und wobei in den genannten Alkyl- und Alkoxygruppen eine oder mehrere CH₂-Gruppen durch -C=C-, -R³C=CR³-, Si(R³)₂, C=O, C=NR³, -NR³-, -O-, -S-, -C(=O)O- oder -C(=O)NR³- ersetzt sein können.

Besonders bevorzugt ist R¹ und R² bei jedem Auftreten gleich oder verschieden H, D, F, CN, eine geradkettige Alkylgruppe mit 1 bis 10 C-Atomen oder eine verzweigte oder cyclische Alkylgruppe mit 3 bis 10 C-Atomen, oder ein aromatisches oder heteroaromatisches Ringsystem mit 6 bis 25 aromatischen Ringatomen, wobei die genannten Alkyl- und Alkoxygruppen und die genannten aromatischen oder heteroaromatischen Ringsysteme jeweils mit einem oder mehreren Resten R³ substituiert sein können. Ganz besonders bevorzugt sind R¹ und R² bei jedem Auftreten gleich oder verschieden H, F, CN, Methyl, tert-Butyl, Phenyl, Biphenyl, Dibenzofuran, Dibenzothiophen oder Carbazol.

Bevorzugt ist R³ bei jedem Auftreten gleich oder verschieden H, D, F, CN, Si(R⁴)₃, N(R⁴)₂, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, oder ein aromatisches oder heteroaromatisches Ringsystem mit 5 bis 30 aromatischen Ringatomen, wobei zwei oder mehr Reste R³ miteinander verknüpft sein können und einen Ring bilden können, wobei die genannten Alkyl- und Alkyoxygruppen und die genannten aromatischen oder heteroaromatischen Ringsysteme jeweils mit einem oder mehreren Resten R⁴ substituiert sein können, und wobei in den genannten Alkyl- und Alkyoxygruppen eine oder mehrere CH₂-Gruppen durch -C=C-, -R⁴C=CR⁴-, Si(R⁴)₂, C=O, C=NR⁴, -NR⁴-, -O-, -S-, -C(=O)O- oder -C(=O)NR⁴- ersetzt sein können. Besonders bevorzugt ist R³ bei jedem Auftreten gleich oder verschieden H, D, F, CN, N(R⁴)₂, eine geradkettige Alkylgruppe mit 1 bis 10 C-Atomen oder eine verzweigte oder cyclische Alkylgruppe mit 3 bis 10 C-Atomen, oder ein aromatisches oder heteroaromatisches Ringsystem mit 6 bis 25 aromatischen Ringatomen, wobei die genannten Alkyl- und Alkyoxygruppen und die genannten aromatischen oder heteroaromatischen Ringsysteme jeweils mit einem oder mehreren Resten R⁴ substituiert sein können.

Es ist bevorzugt, dass p gleich 1 ist. In diesem Fall ist es weiterhin bevorzugt, dass alle anderen Indices k, i, m und n gleich 0 sind.

Es ist bevorzugt, dass k gleich 1 ist. In diesem Fall ist es weiterhin bevorzugt, dass alle anderen Indices i, m, n und p gleich 0 sind.

Es ist weiterhin bevorzugt, dass die Summe der Indices i, k, m, n und p gleich 1 oder 2 ist, besonders bevorzugt gleich 1.

Bevorzugt ist die Gruppe Y gleich S, und die Gruppe Z ist gleich O, S oder eine Einfachbindung. Besonders bevorzugt ist die Gruppe Y gleich S, und die Gruppe Z ist eine Einfachbindung.

Bevorzugte Ausführungsformen der Verbindungen der Formel (I) entsprechen den folgenden Formeln:

| | |
|---|---|
| 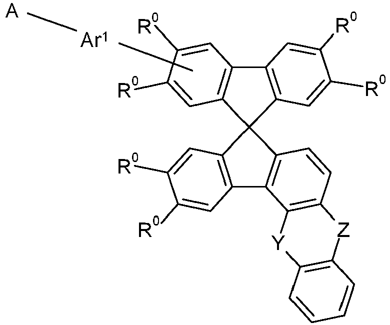 | 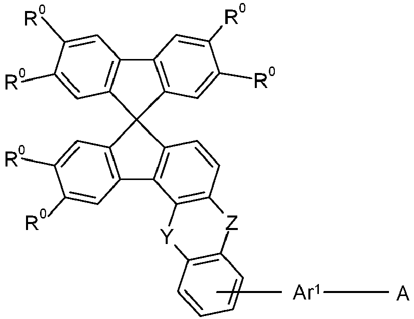 |
| Formel (I-1) | Formel (I-2) |
| 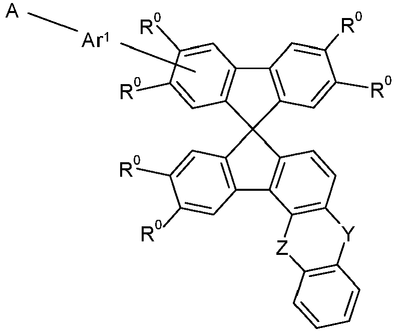 | 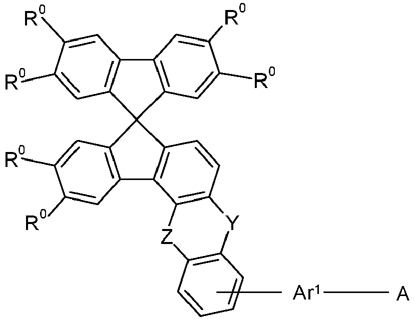 |
| Formel (I-3) | Formel (I-4) |
| 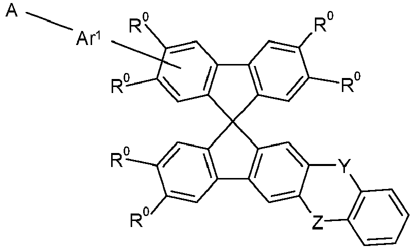 | 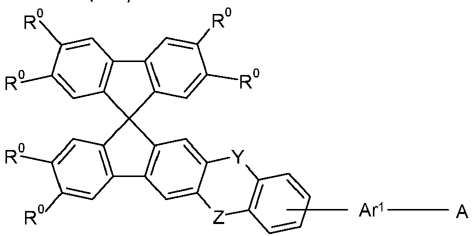 |
| Formel (I-5) | Formel (I-6) |
| 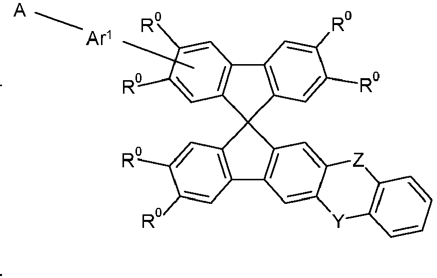 | 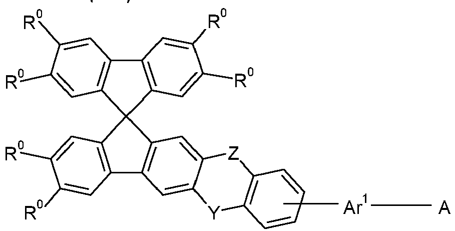 |
| Formel (I-7) | Formel (I-8) |
| 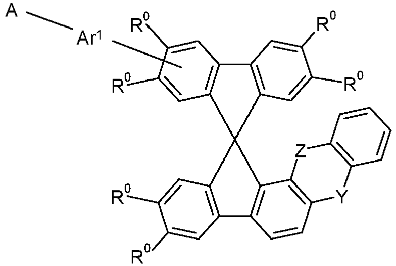 | 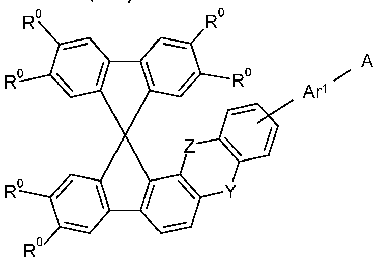 |
| Formel (I-9) | Formel (I-10) |
| 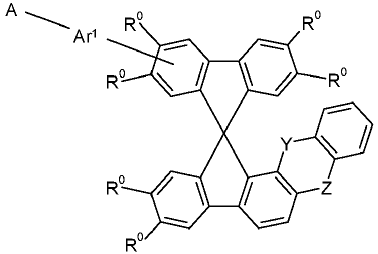 | 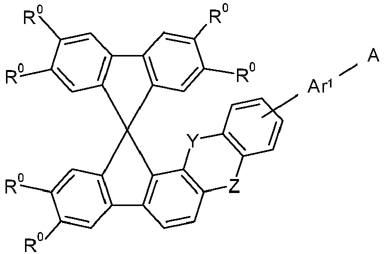 |
| Formel (I-11) | Formel (I-12) |
| 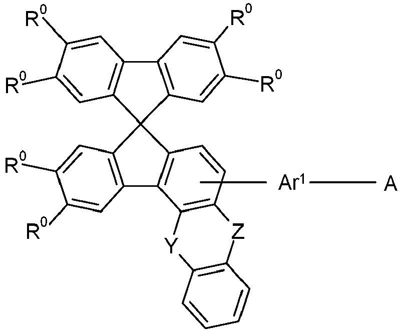 | 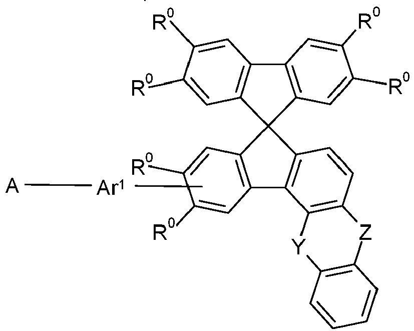 |
| Formel (I-13) | Formel (I-14) |
| 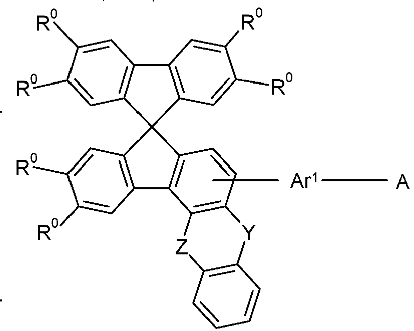 | 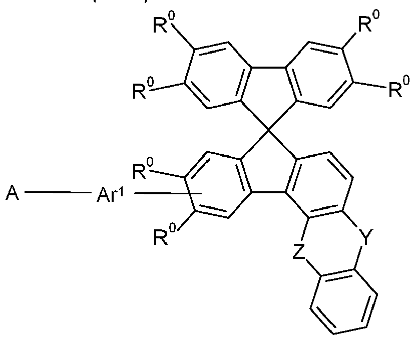 |
| Formel (I-15) | Formel (I-16) |
| 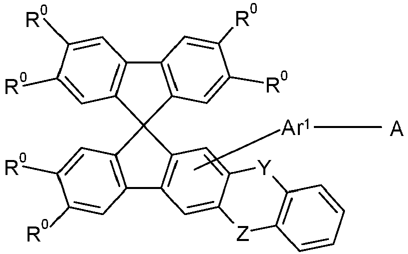 | 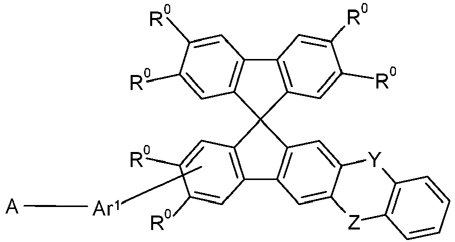 |
| Formel (I-17) | Formel (I-18) |
| 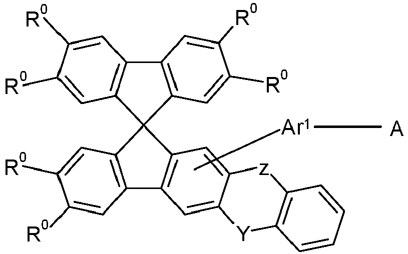 | 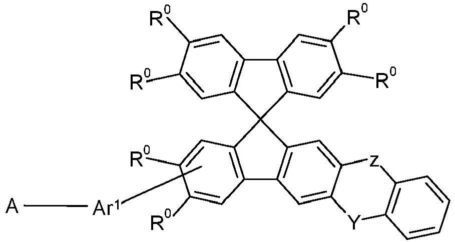 |
| Formel (I-19) | Formel (I-20) |
| 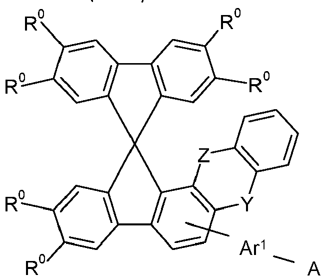 | 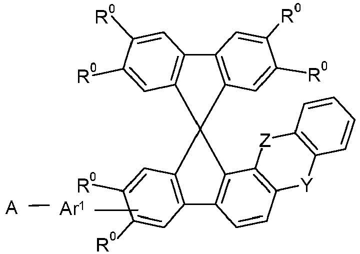 |
| Formel (I-21) | Formel (I-22) |
| 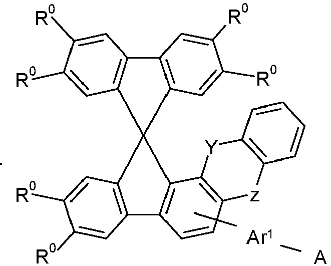 | 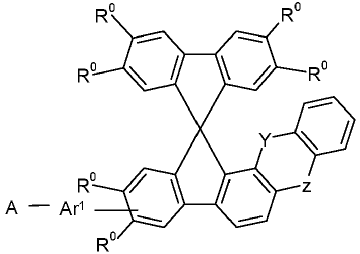 |
| Formel (I-23) | Formel (I-24) |

wobei die auftretenden Symbole wie oben definiert sind, und die Verbindungen an unsubstituiert dargestellten Positionen mit Resten R¹ substituiert sein können.

Besonders bevorzugt sind unter den genannten Formeln die Formeln (I-1) bis (I-12).

Es gelten für Formeln (I-1) bis (I-24) insbesondere die bevorzugten Ausführungsformen von R⁰, Ar¹ und A. Bevorzugt ist für Formeln (I-1) bis (I-24) die Gruppe Y gleich S, und die Gruppe Z ist O, S oder eine Einfachbindung; besonders bevorzugt ist die Gruppe Y gleich S, und die Gruppe Z ist eine Einfachbindung. Weiterhin insbesondere bevorzugt ist es für die oben genannten Formeln, dass R⁰ gleich H ist.

Ganz besonders bevorzugt sind unter den Formeln (I-1), (I-3), (I-5), (I-7), (I-9) und (I-11) die folgenden Formeln

| | |
|---|---|
| 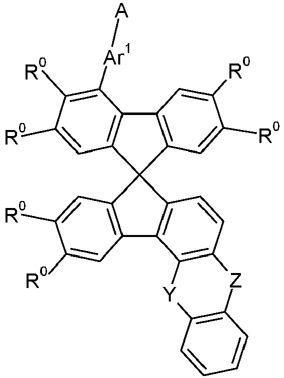 | 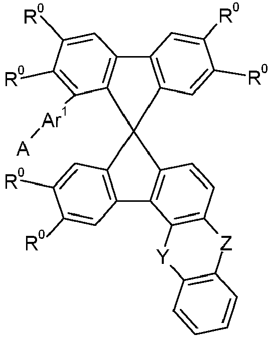 |
| Formel (I-1A) | Formel (I-1B) |
| 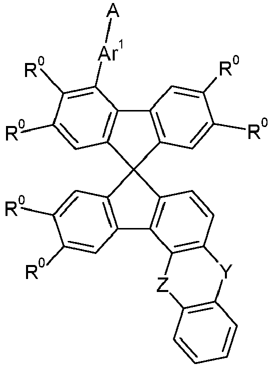 | 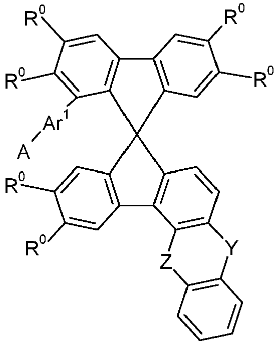 |
| Formel (I-3A) | Formel (I-3B) |
| 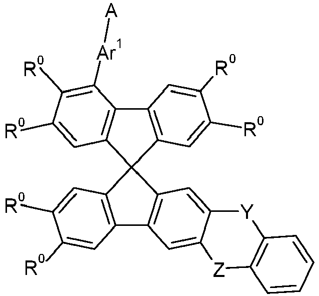 | 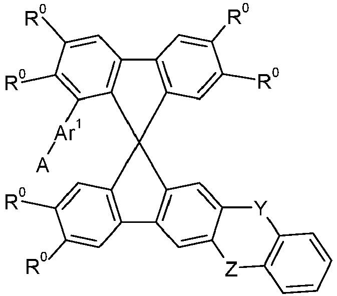 |
| Formel (I-5A) | Formel (I-5B) |
| 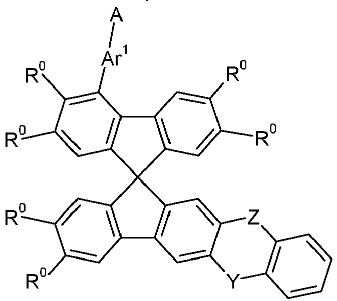 | 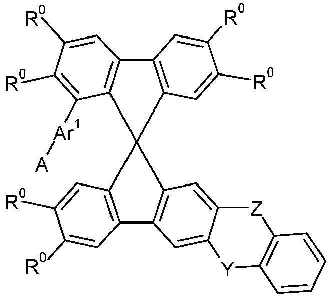 |
| Formel (I-7A) | Formel (I-7B) |
| 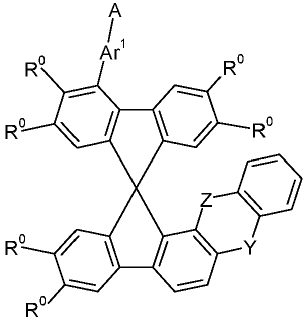 | 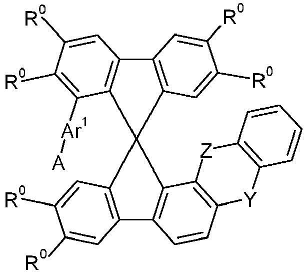 |
| Formel (I-9A) | Formel (I-9B) |
| 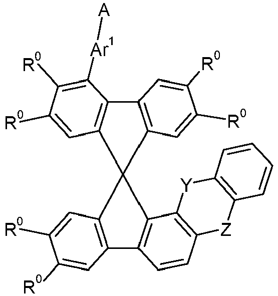 | 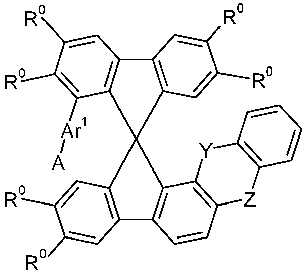 |
| Formel (I-11A) | Formel (I-11B) |

wobei die auftretenden Symbole wie oben definiert sind, und die Verbindungen an unsubstituiert dargestellten Positionen mit Resten R¹ substituiert sein können.

Es gelten für die gerade zuvor genannten Formeln insbesondere die bevorzugten Ausführungsformen von R⁰, Ar¹ und A. Bevorzugt ist die Gruppe Y gleich S, und die Gruppe Z ist O, S oder eine Einfachbindung; besonders bevorzugt ist die Gruppe Y gleich S, und die Gruppe Z ist eine Einfachbindung. Weiterhin insbesondere bevorzugt ist es für die oben genannten Formeln, dass R⁰ gleich H ist.

Die folgenden expliziten Verbindungen sind bevorzugte Ausführungsformen der Verbindungen der Formel (I) mit Ausnahme der Verbindungen 99, 100, 111, 114, 115, 124 und 126, welche nicht unter Formel (I) fallen:

| | | |
|---|---|---|
| 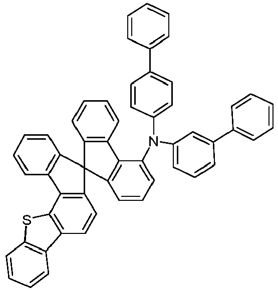 | 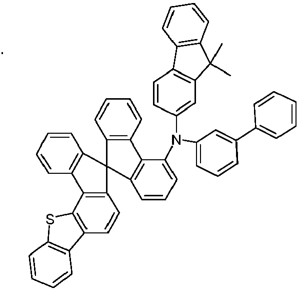 | 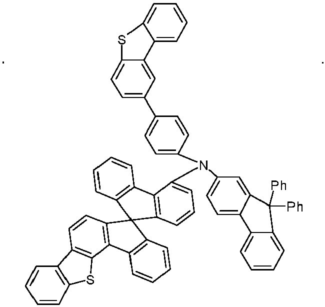 |
| 1 | 2 | 3 |
| 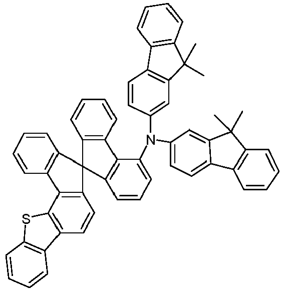 | 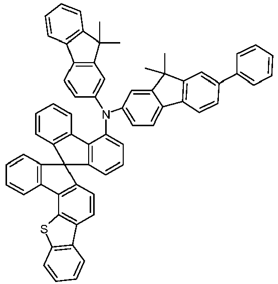 | 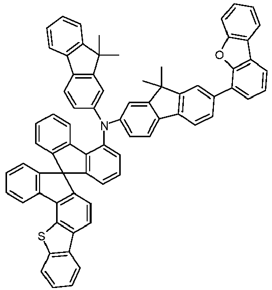 |
| 4 | 5 | 6 |
| 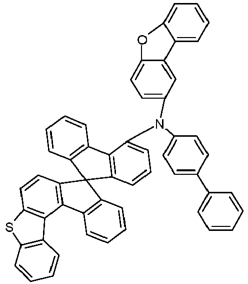 | 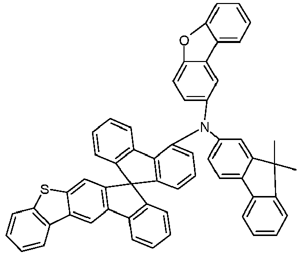 | 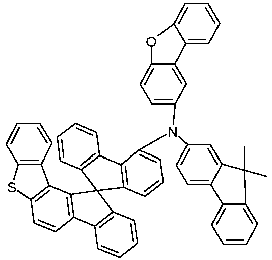 |
| 7 | 8 | 9 |
| 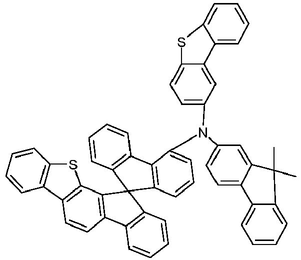 | 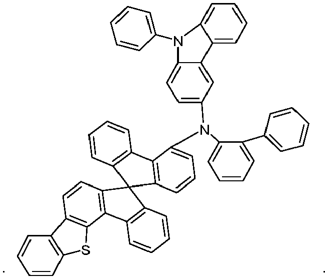 | 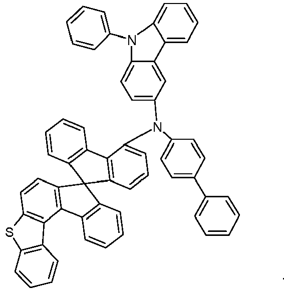 |
| 10 | 11 | 12 |
| 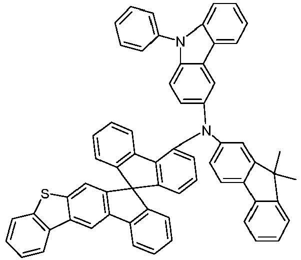 | 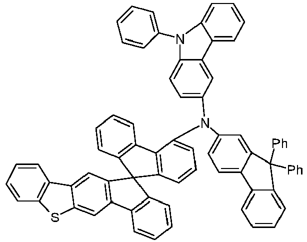 | 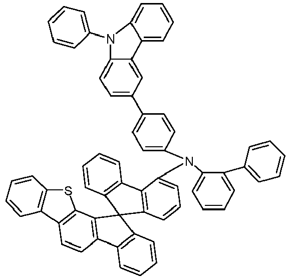 |
| 13 | 14 | 15 |
| 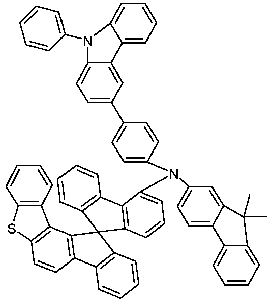 | 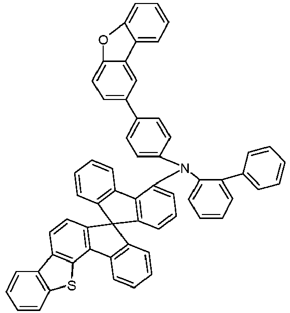 | 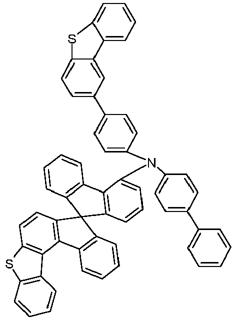 |
| 16 | 17 | 18 |
| 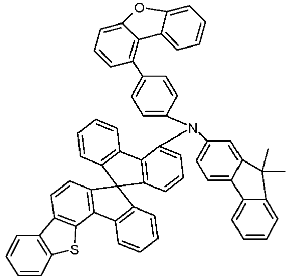 | 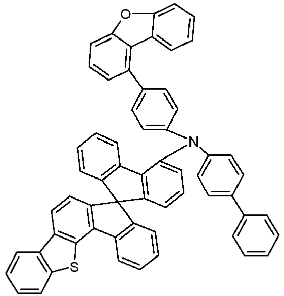 | 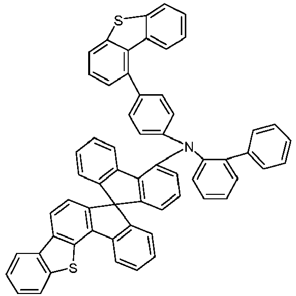 |
| 19 | 20 | 21 |
| 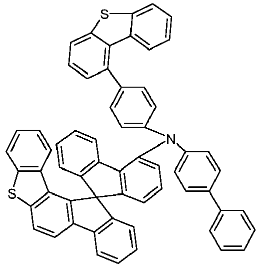 22 | 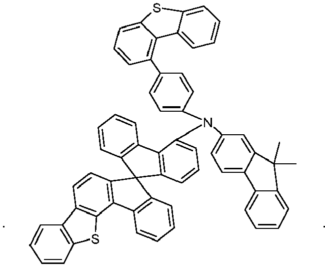 23 | 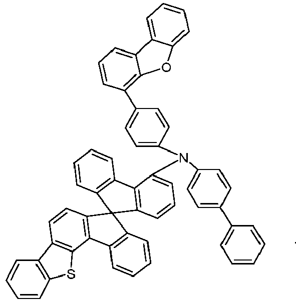 24 |
| 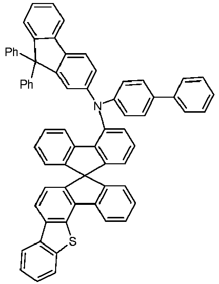 | 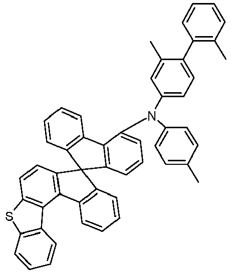 | 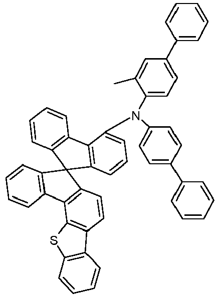 |
| 25 | 26 | 27 |
| 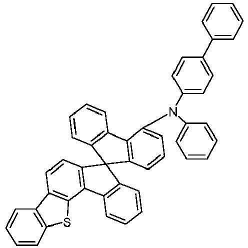 | 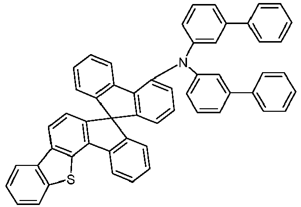 | 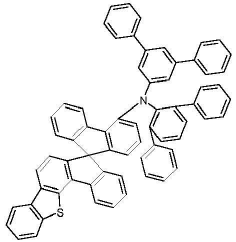 |
| 28 | 29 | 30 |
| 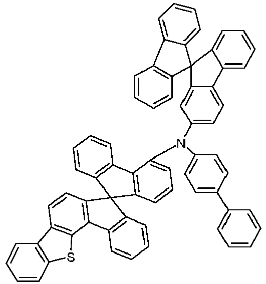 | 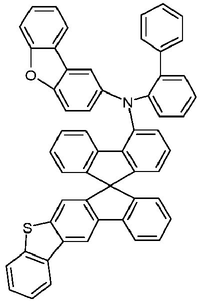 | 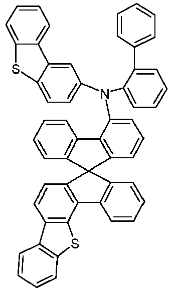 |
| 31 | 32 | 33 |
| 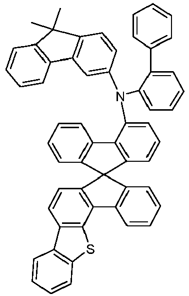 | 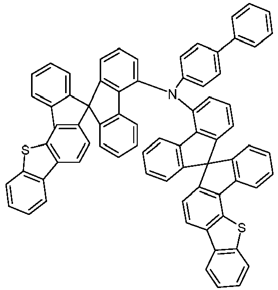 | 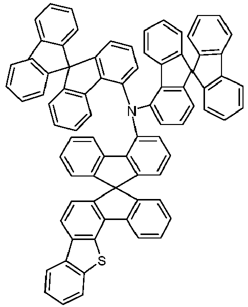 |
| 34 | 35 | 36 |
| 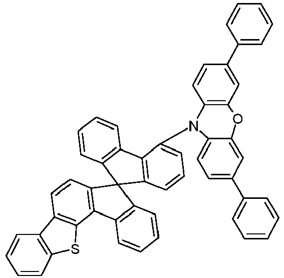 | 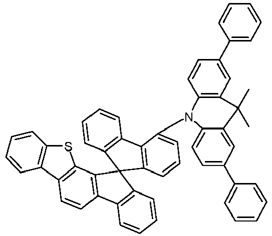 | 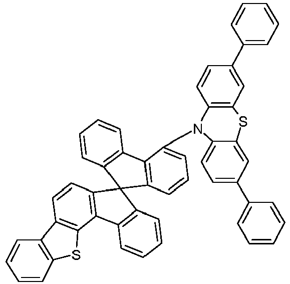 |
| 37 | 38 | 39 |
| 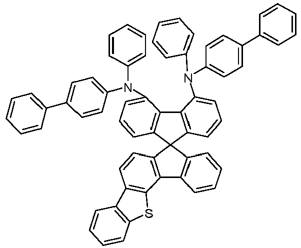 | 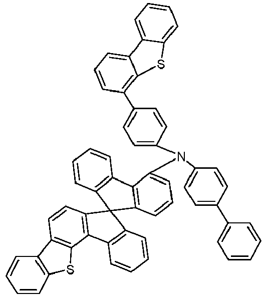 | 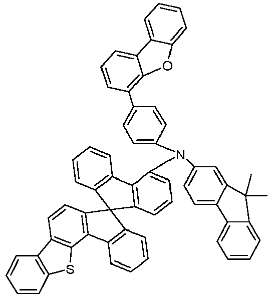 |
| 40 | 41 | 42 |
| 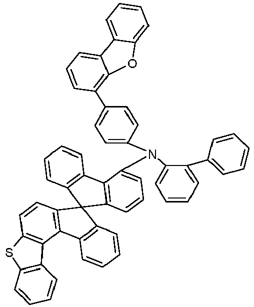 | 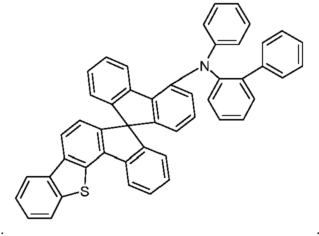 | 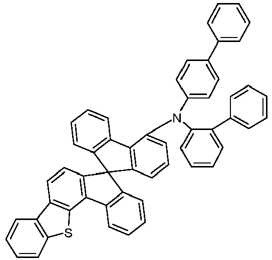 |
| 43 | 44 | 45 |
| 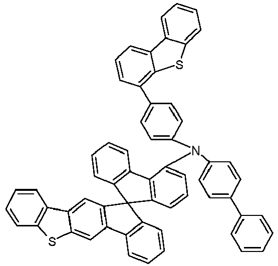 | 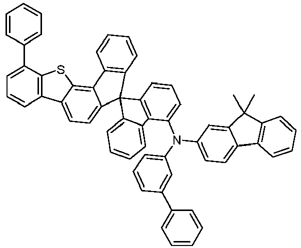 | 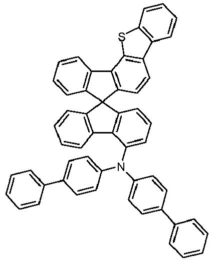 |
| 46 | 47 | 48 |
| 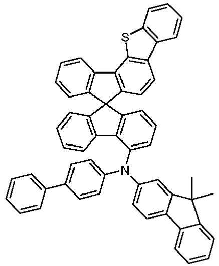 | 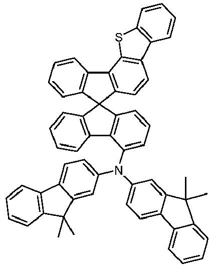 | 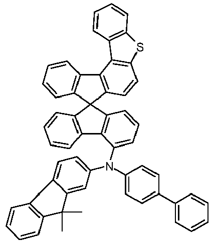 |
| 49 | 50 | 51 |
| 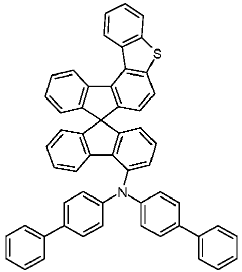 | 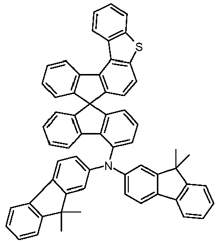 | 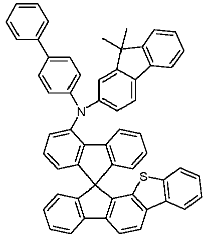 |
| 52 | 53 | 54 |
| 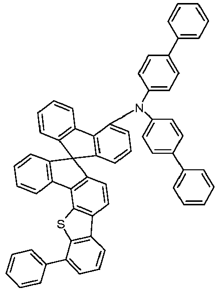 | 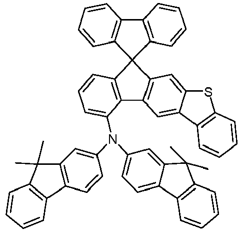 | 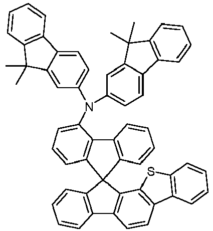 |
| 55 | 56 | 57 |
| 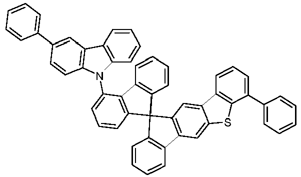 | 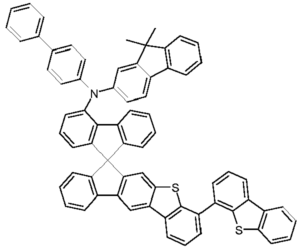 | 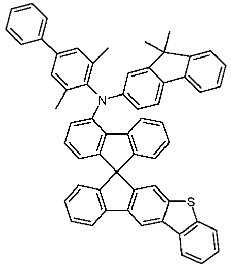 |
| 58 | 59 | 60 |
| 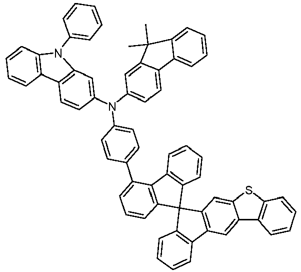 | 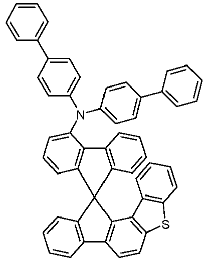 | 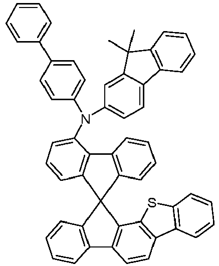 |
| 61 | 62 | 63 |
| 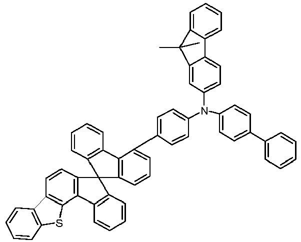 | 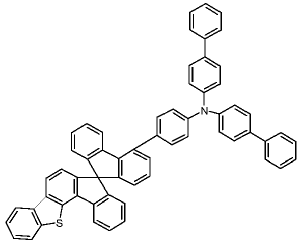 | 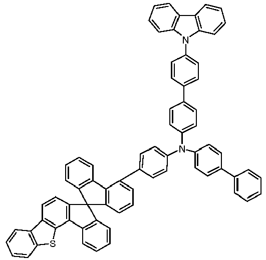 |
| 64 | 65 | 66 |
| 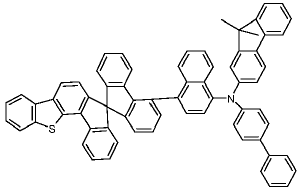 | 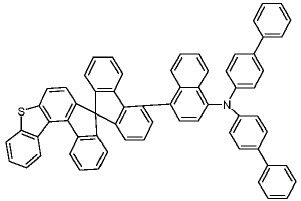 | 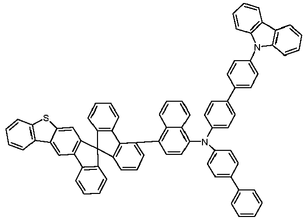 |
| 67 | 68 | 69 |
| 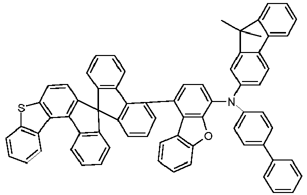 | 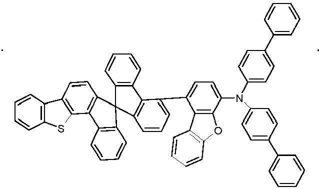 | 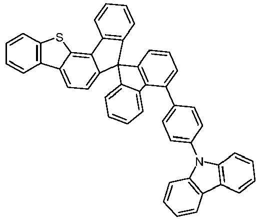 |
| 70 | 71 | 72 |
| 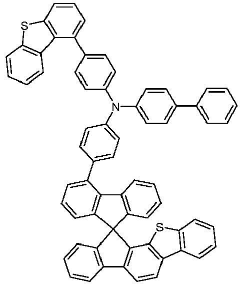 | 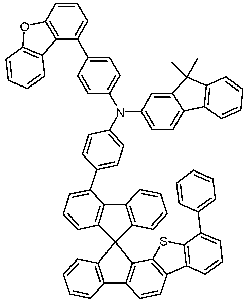 | 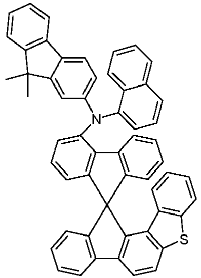 |
| 73 | 74 | 75 |
| 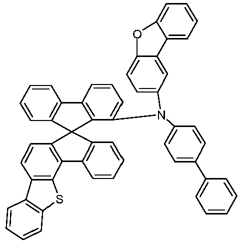 | 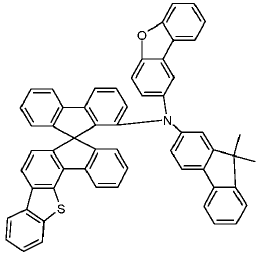 | 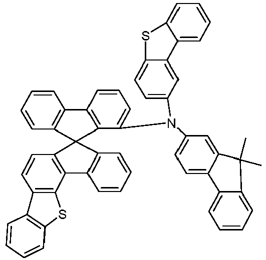 |
| 76 | 77 | 78 |
| 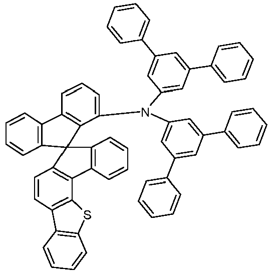 | 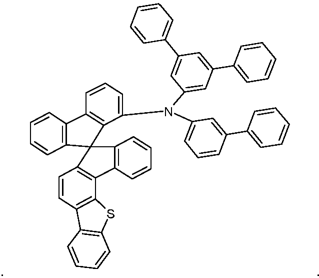 | 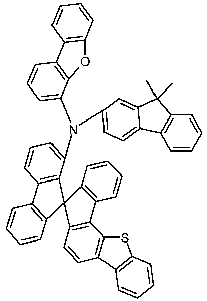 |
| 79 | 80 | 81 |
| 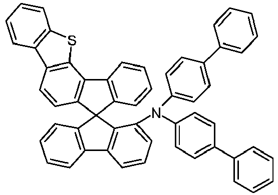 | 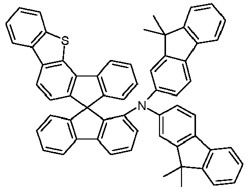 | 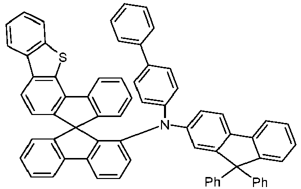 |
| 82 | 83 | 84 |
| 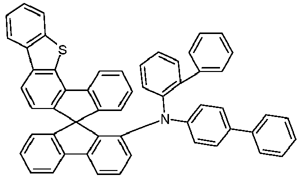 | 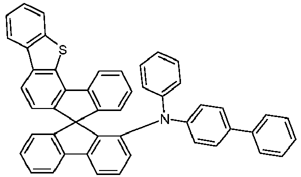 | 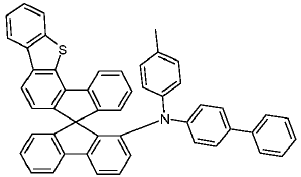 |
| 85 | 86 | 87 |
| 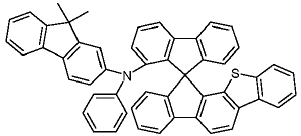 | 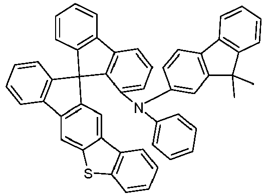 | 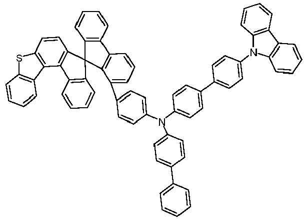 |
| 88 | 89 | 90 |
| 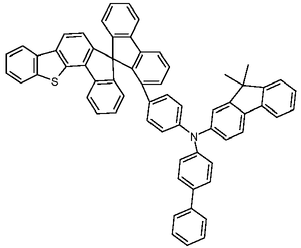 | 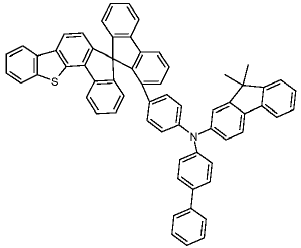 | 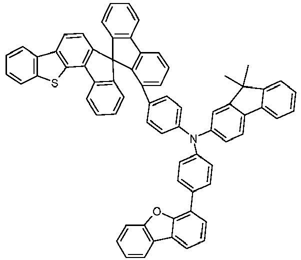 |
| 91 | 92 | 93 |
| 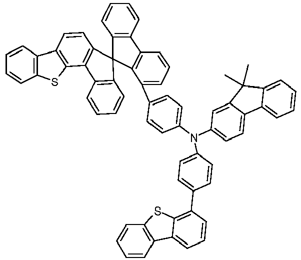 | 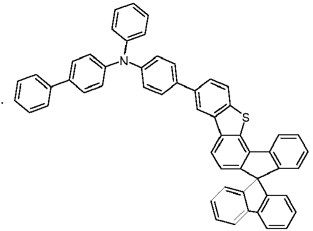 | 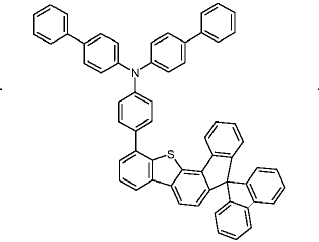 |
| 94 | 95 | 96 |
| 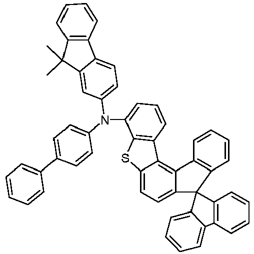 | 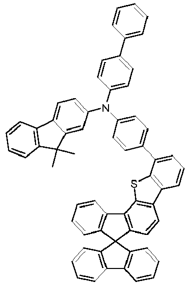 | 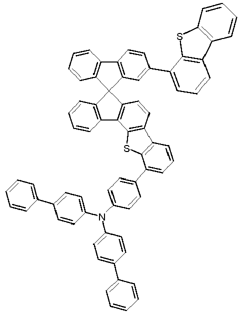 |
| 97 | 98 | 99 |
| 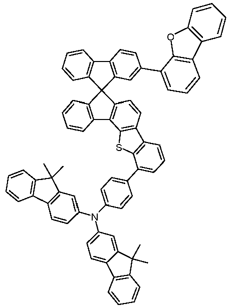 | 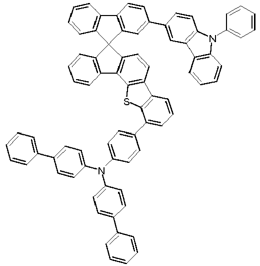 | 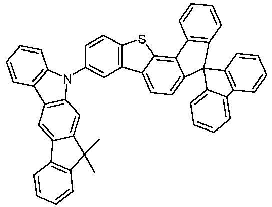 |
| 100 | 101 | 102 |
| 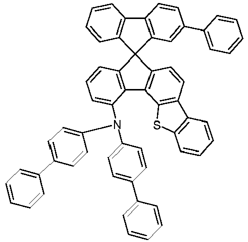 | 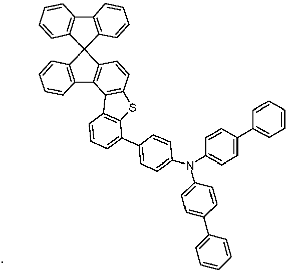 | 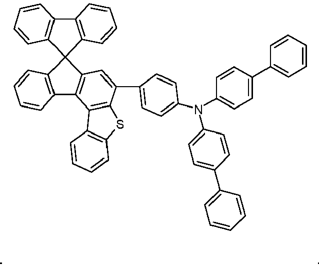 |
| 103 | 104 | 105 |
| 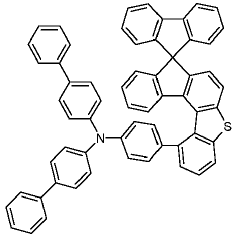 | 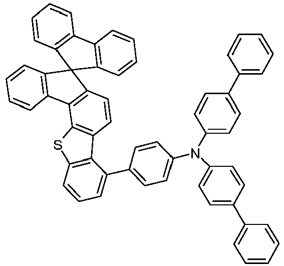 | 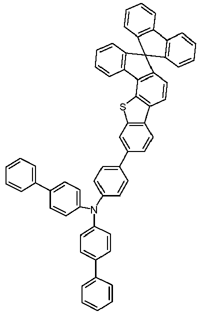 |
| 106 | 107 | 108 |
| 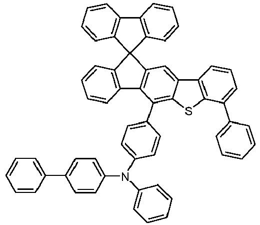 | 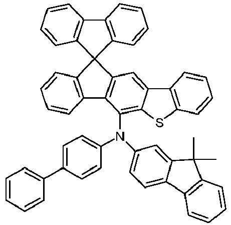 | 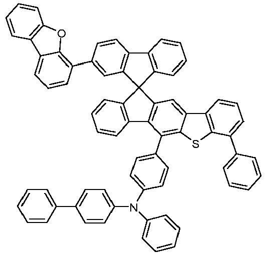 |
| 109 | 110 | 111 |
| 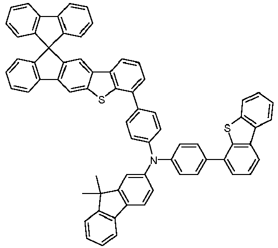 | 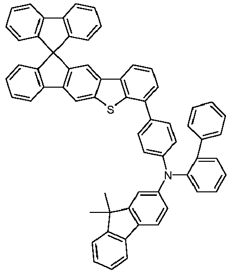 | 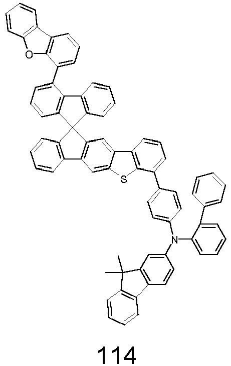 |
| 112 | 113 | |
| 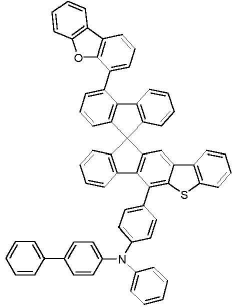 | 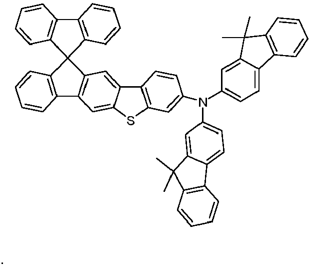 | 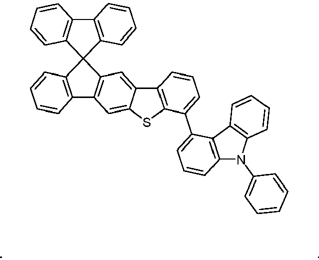 |
| 115 | 116 | 117 |
| 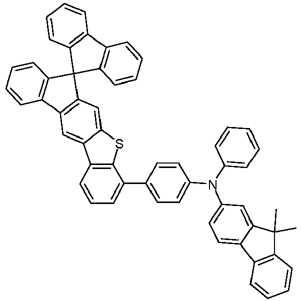 | 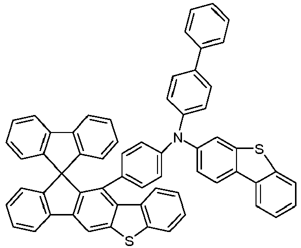 | 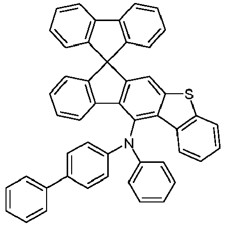 |
| 118 | 119 | 120 |
| 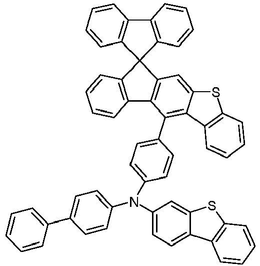 | 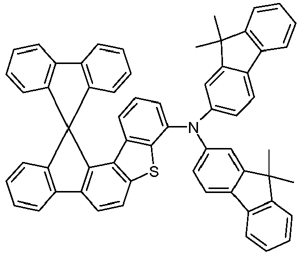 | 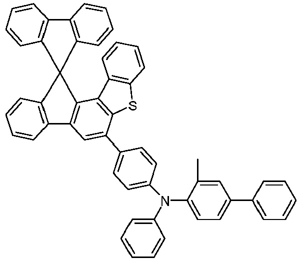 |
| 121 | 122 | 123 |
| 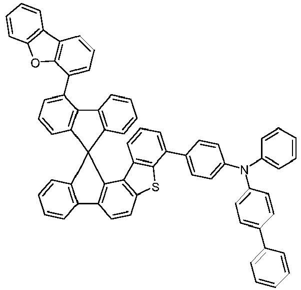 | 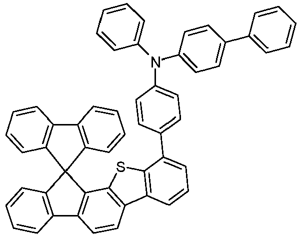 | 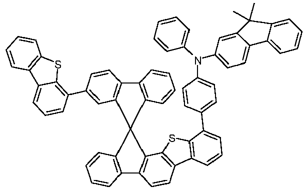 |
| 124 | 125 | 126 |
| 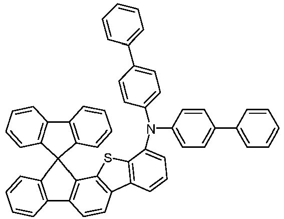 | | |
| 127 | | |

Die Synthese der Verbindungen gemäß Formel (I) kann unter Einsatz von Verfahren und Reaktionstypen durchgeführt werden, die im Stand der Technik bekannt sind, beispielsweise Halogenierung, metallorganische Addition, Buchwald-Kupplung und Suzuki-Kupplung.

Schemata 1 bis 8 zeigen mögliche Synthesewege zur Herstellung der erfindungsgemäßen Verbindungen. Sie dienen zur Erläuterung der Erfindung für den Fachmann, und sind nicht einschränkend auszulegen. Der Fachmann kann im Rahmen seines allgemeinen Fachwissens die gezeigten Synthesewege abwandeln, oder andere Wege entwickeln, falls dies vorteilhafter erscheint.

In allen folgenden Syntheseschemata sind die Verbindungen unsubstituiert gezeigt. Dies schließt das Vorhandensein von beliebigen Substituenten in den Verfahren nicht aus.

In Schema 1 ist eine geeignete Synthese für die Zwischenstufe gemäß Formel (Z-1) gezeigt.

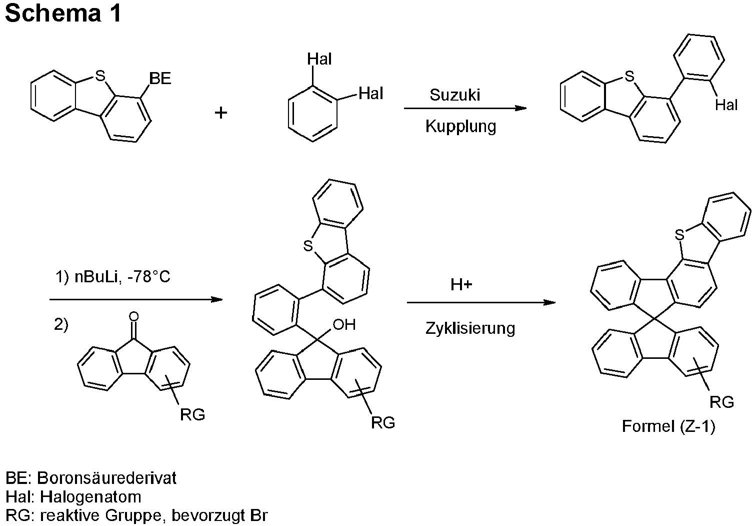

In Schema 2 ist eine geeignete Synthese für die Zwischenstufe gemäß Formel (Z-2) gezeigt.

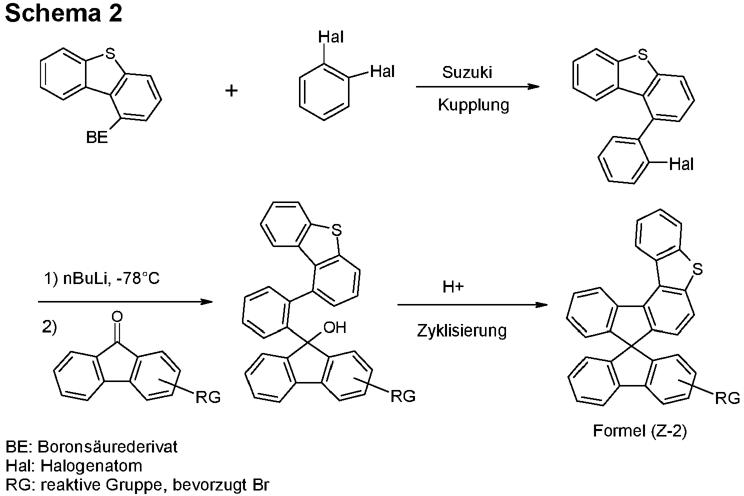

In Schema 3 ist eine geeignete Synthese für Zwischenstufen gemäß Formeln (Z-3) und (Z-4) gezeigt.

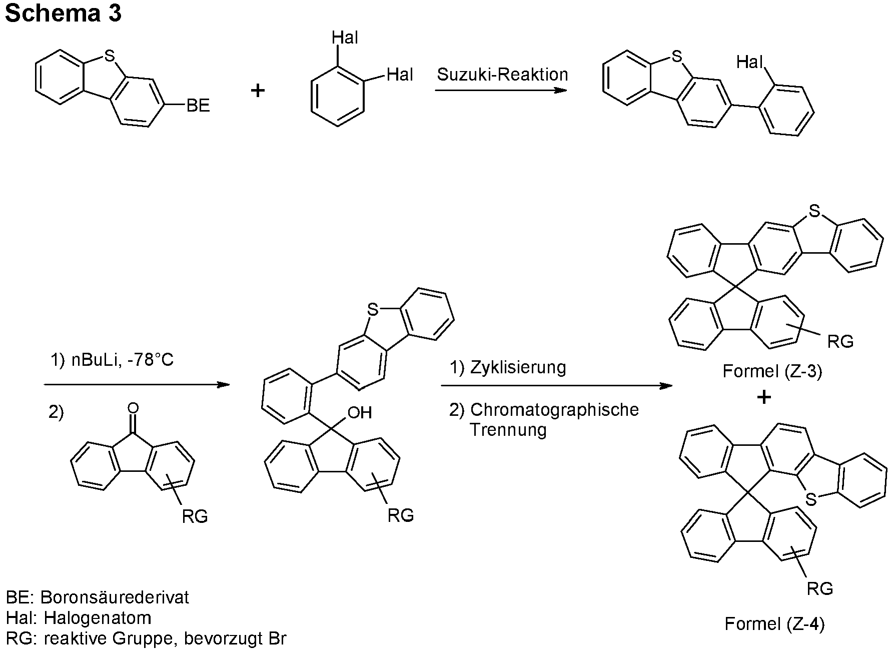

In Schema 4 ist eine geeignete alternative Synthese für Zwischenstufen gemäß Formeln (Z-5) und (Z-6) gezeigt.

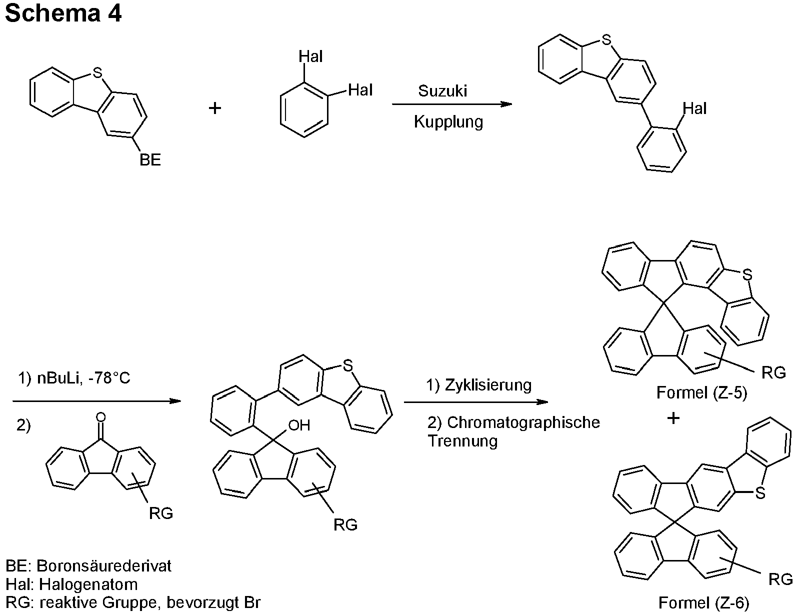

Die oben gezeigten Bausteine können an der Benzothiophen-Einheit mit einer reaktiven Gruppe, wie beispielsweise Brom, versehen werden, wie das folgende Schema zeigt (Formel (Z-7)):

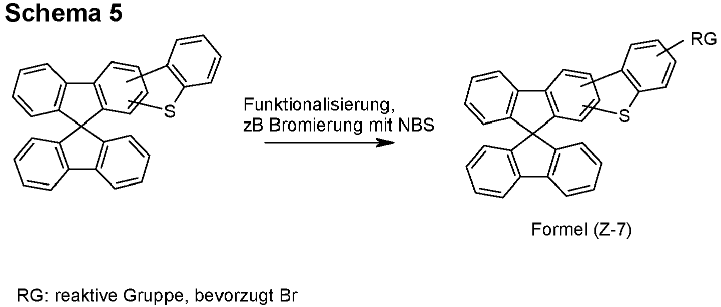

Die mit reaktiven Gruppen versehenen Zwischenstufen gemäß den Formeln (Z-1) bis (Z-7), wie oben gezeigt, sind vielseitige Bausteine, die zu Verbindungen der Formel (I) umgesetzt werden können, wie das folgende Schema zeigt:

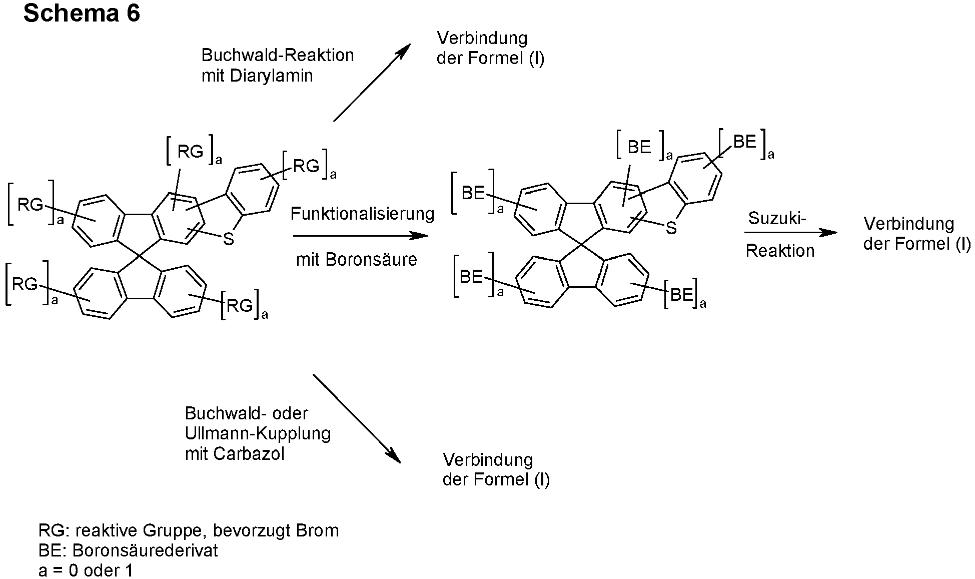

Das in Schema 6 gezeigte Verfahren über die Funktionalisierung mit Boronsäure (Mitte) ist insbesondere geeignet, Verbindungen herzustellen, in denen ein Diarylamin oder ein Carbazol über einen Arylen- oder Heteroarylen-Spacer mit der Spirobifluoren-Einheit verbunden ist.

Gemäß einem alternativen Verfahren zur Herstellung der erfindungsgemäßen Verbindungen (Schema 7) wird analog zu Schemata 1 bis 4 vorgegangen, nur dass anstelle der reaktiven Gruppe RG am Fluorenon-Derivat eine Diarylaminogruppe vorliegt. In Schema 7 ist dabei nur die zu Schema 1 analoge Reaktion gezeigt. Es lassen sich jedoch auch gleichermaßen die Verfahren gemäß Schemata 2 bis 4 abwandeln, jeweils durch Austausch der Gruppe RG durch eine entsprechende Diarylaminogruppe.

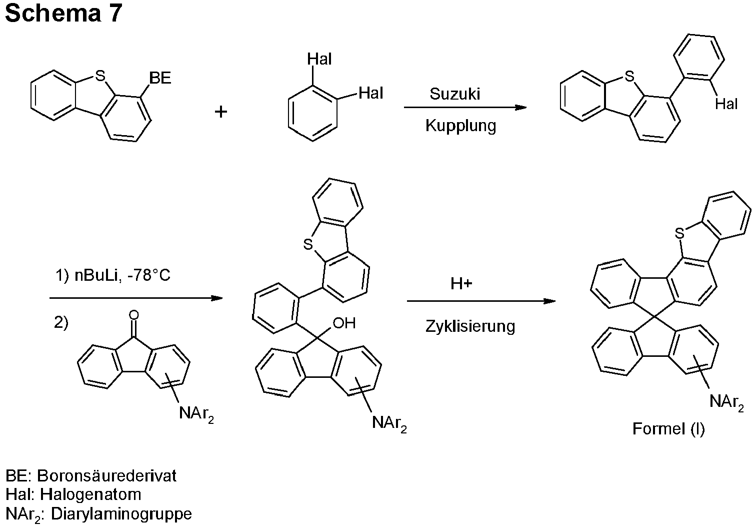

Gemäß einer Abwandlung der in Schemata 1 bis 4 und 7 gezeigten Verfahren können in der Synthese des Grundgerüsts statt Dibenzothiophen-Derivaten auch analoge Verbindungen, wie beispielsweise Thianthren-Derivate, eingesetzt werden. Dies ist exemplarisch in Schema 8 gezeigt. Erneut sind Abwandlungen, entsprechend den Schemata 2 bis 5, möglich.

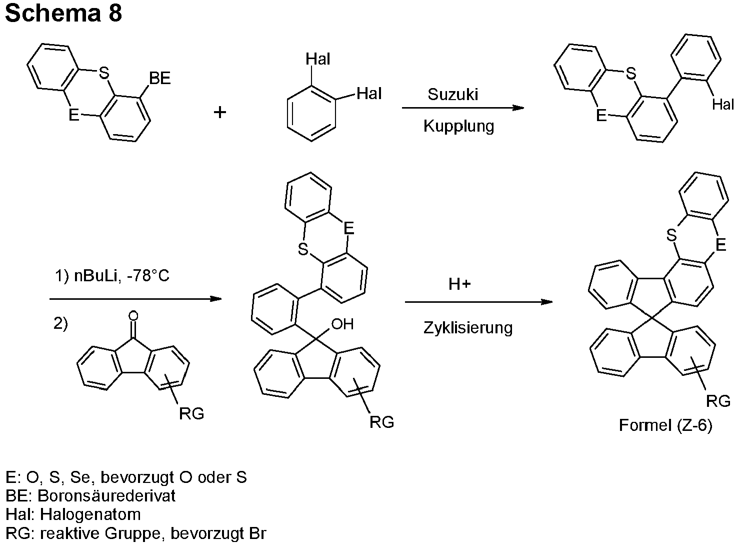

Die erhaltenen Verbindungen der Formel (Z-6) können, wie in Schema 6 gezeigt, weiter zu den Endverbindungen gemäß Formel (I) umgesetzt werden. Auch können mit den Thianthren-Derivaten Abwandlungen der Synthese gemäß Schema 7 durchgeführt werden.

Gegenstand der vorliegenden Anmeldung ist somit ein Verfahren zur Herstellung einer Verbindung der Formel (I), dadurch gekennzeichnet, dass entweder
A) zunächst das mit einer reaktiven Gruppe substituierte Spirobifluoren-Grundgerüst durch Reaktion eines Dibenzothiophenyl-Derivats mit einem Fluorenon-Derivat, welches die reaktive Gruppe trägt, hergestellt wird, und in einem späteren Schritt über eine metallorganische Kupplungsreaktion eine Diarylamino- oder eine Carbazolgruppe oder eine Aryl- oder Heteroarylgruppe, die mit einer Diarylamino- oder Carbazolgruppe substituiert ist, an der Position der reaktiven Gruppe eingeführt wird, oder
B) die Reaktion eines Dibenzothiophenyl-Derivats mit einem Fluorenon, welches eine Diarylamino- oder eine Carbazolgruppe oder eine Aryl- oder Heteroarylgruppe, die mit einer Diarylamino- oder Carbazolgruppe substituiert ist, trägt, umfasst ist, oder
C) zunächst ein Spirobifluoren-Grundgerüst durch Reaktion eines Dibenzothiophenyl-Derivats mit einem Fluorenon-Derivat hergestellt wird, dieses dann mit einer reaktiven Gruppe funktionalisiert wird, und in einem späteren Schritt über eine metallorganische Kupplungsreaktion eine Diarylamino- oder eine Carbazolgruppe oder eine Aryl- oder Heteroarylgruppe, die mit einer Diarylamino- oder Carbazolgruppe substituiert ist, an der Position der reaktiven Gruppe eingeführt wird.

Die reaktive Gruppe ist dabei bevorzugt ein Halogenatom, besonders bevorzugt Br. Die metallorganische Kupplungsreaktion ist dabei bevorzugt eine Buchwald-Kupplung oder eine Suzuki-Kupplung.

Die oben beschriebenen Verbindungen, insbesondere Verbindungen, welche mit reaktiven Abgangsgruppen, wie Brom, lod, Chlor, Boronsäure oder Boronsäureester, substituiert sind, können als Monomere zur Erzeugung entsprechender Oligomere, Dendrimere oder Polymere Verwendung finden. Geeignete reaktive Abgangsgruppen sind beispielsweise Brom, lod, Chlor, Boronsäuren, Boronsäureester, Amine, Alkenyl- oder Alkinylgruppen mit endständiger C-C-Doppelbindung bzw. C-C-Dreifachbindung, Oxirane, Oxetane, Gruppen, die eine Cycloaddition, beispielsweise eine 1,3-dipolare Cycloaddition, eingehen, wie beispielsweise Diene oder Azide, Carbonsäurederivate, Alkohole und Silane.

Weiterer Gegenstand der Erfindung sind daher Oligomere, Polymere oder Dendrimere, enthaltend eine oder mehrere Verbindungen gemäß Formel (I), wobei die Bindung(en) zum Polymer, Oligomer oder Dendrimer an beliebigen, in Formel (I) mit R⁰, R¹ oder R² substituierten Positionen lokalisiert sein können. Je nach Verknüpfung der Verbindung gemäß Formel (I) ist die Verbindung Bestandteil einer Seitenkette des Oligomers oder Polymers oder Bestandteil der Hauptkette. Unter einem Oligomer im Sinne dieser Erfindung wird eine Verbindung verstanden, welche aus mindestens drei Monomereinheiten aufgebaut ist. Unter einem Polymer im Sinne der Erfindung wird eine Verbindung verstanden, die aus mindestens zehn Monomereinheiten aufgebaut ist. Die erfindungsgemäßen Polymere, Oligomere oder Dendrimere können konjugiert, teilkonjugiert oder nicht-konjugiert sein. Die erfindungsgemäßen Oligomere oder Polymere können linear, verzweigt oder dendritisch sein. In den linear verknüpften Strukturen können die Einheiten gemäß Formel (I) direkt miteinander verknüpft sein oder sie können über eine bivalente Gruppe, beispielsweise über eine substituierte oder unsubstituierte Alkylengruppe, über ein Heteroatom oder über eine bivalente aromatische oder heteroaromatische Gruppe miteinander verknüpft sein. In verzweigten und dendritischen Strukturen können beispielsweise drei oder mehrere Einheiten gemäß Formel (I) über eine trivalente oder höhervalente Gruppe, beispielsweise über eine trivalente oder höhervalente aromatische oder heteroaromatische Gruppe, zu einem verzweigten bzw. dendritischen Oligomer oder Polymer verknüpft sein.

Für die Wiederholeinheiten gemäß Formel (I) in Oligomeren, Dendrimeren und Polymeren gelten dieselben Bevorzugungen wie oben für Verbindungen gemäß Formel (I) beschrieben.

Zur Herstellung der Oligomere oder Polymere werden die erfindungsgemäßen Monomere homopolymerisiert oder mit weiteren Monomeren copolymerisiert.

Geeignete und bevorzugte Comonomere sind gewählt aus Fluorenen (z. B. gemäß EP 842208 oder WO 2000/22026), Spirobifluorenen (z. B. gemäß EP 707020, EP 894107 oder WO 2006/061181), Paraphenylenen (z. B. gemäß WO 1992/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689 oder WO 2007/006383), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere enthalten üblicherweise noch weitere Einheiten, beispielsweise emittierende (fluoreszierende oder phosphoreszierende) Einheiten, wie z. B. Vinyltriarylamine (z. B. gemäß WO 2007/068325) oder phosphoreszierende Metallkomplexe (z. B. gemäß WO 2006/003000), und/oder Ladungstransporteinheiten, insbesondere solche basierend auf Triarylaminen.

Die erfindungsgemäßen Polymere und Oligomere werden in der Regel durch Polymerisation von einer oder mehreren Monomersorten hergestellt, von denen mindestens ein Monomer im Polymer zu Wiederholungseinheiten der Formel (I) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind die SUZUKI-Polymerisation, die YAMAMOTO-Polymerisation; die STILLE-Polymerisation; und die HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in WO 2003/048225, WO 2004/037887 und WO 2004/037887, im Detail beschrieben.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösemittel.

Gegenstand der Erfindung ist daher weiterhin eine Formulierung, insbesondere eine Lösung, Dispersion oder Emulsion, enthaltend mindestens eine Verbindung gemäß Formel (I) oder mindestens ein Polymer, Oligomer oder Dendrimer enthaltend mindestens eine Einheit gemäß Formel (I) sowie mindestens ein Lösungsmittel, bevorzugt ein organisches Lösungsmittel. Wie solche Lösungen hergestellt werden können, ist dem Fachmann bekannt und beispielsweise in WO 2002/072714, WO 2003/019694 und der darin zitierten Literatur beschrieben.

Die erfindungsgemäßen Verbindungen eignen sich für den Einsatz in elektronischen Vorrichtungen, insbesondere in organischen Elektrolumineszenzvorrichtungen (OLEDs). Abhängig von der Substitution werden die Verbindungen in unterschiedlichen Funktionen und Schichten eingesetzt.

Weiterer Gegenstand der Erfindung ist daher die Verwendung der Verbindung gemäß Formel (I) in einer elektronischen Vorrichtung. Dabei ist die elektronische Vorrichtung bevorzugt ausgewählt aus der Gruppe bestehend aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und besonders bevorzugt organischen Elektrolumineszenzvorrichtungen (OLEDs).

Weiterer Gegenstand der Erfindung ist, wie bereits oben ausgeführt, eine elektronische Vorrichtung, enthaltend mindestens eine Verbindung gemäß Formel (I). Dabei ist die elektronische Vorrichtung bevorzugt ausgewählt aus den oben genannten Vorrichtungen.

Besonders bevorzugt ist sie eine organische Elektrolumineszenzvorrichtung (OLED), enthaltend Anode, Kathode und mindestens eine emittierende Schicht, dadurch gekennzeichnet, dass mindestens eine organische Schicht, die eine emittierende Schicht, eine Lochtransportschicht oder eine andere Schicht sein kann, mindestens eine Verbindung gemäß Formel (I) enthält.

Außer Kathode, Anode und der emittierenden Schicht kann die organische Elektrolumineszenzvorrichtung noch weitere Schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*)* und/oder organischen oder anorganischen p/n-Übergängen.

Die Abfolge der Schichten der organischen Elektrolumineszenzvorrichtung enthaltend die Verbindung der Formel (I) ist bevorzugt die folgende: Anode-Lochinjektionsschicht-Lochtransportschicht-wahlweise weitere Lochtransportschicht-wahlweise Elektronenblockierschicht-emittierende Schicht-wahlweise Lochblockierschicht-Elektronentransportschicht-Elektroneninjektionsschicht-Kathode. Es können zusätzlich weitere Schichten in der OLED vorhanden sein.

Die erfindungsgemäße organische Elektrolumineszenzvorrichtung kann mehrere emittierende Schichten enthalten. Besonders bevorzugt weisen diese Emissionsschichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues, grünes, gelbes, orangefarbenes oder rotes Licht emittieren. Insbesondere bevorzugt sind Dreischichtsysteme, also Systeme mit drei emittierenden Schichten, wobei die drei Schichten blaue, grüne und orange oder rote Emission zeigen (für den prinzipiellen Aufbau siehe z. B. WO 2005/011013). Die erfindungsgemäßen Verbindungen sind dabei bevorzugt in der Lochtransportschicht, Lochinjektionsschicht oder der Elektronenblockierschicht vorhanden.

Es ist erfindungsgemäß bevorzugt, wenn die Verbindung gemäß Formel (I) in einer elektronischen Vorrichtung enthaltend einen oder mehrere phosphoreszierende emittierende Verbindungen eingesetzt wird. Dabei kann die Verbindung in unterschiedlichen Schichten, bevorzugt in einer Lochtransportschicht, einer Elektronenblockierschicht, einer Lochinjektionsschicht oder in einer emittierenden Schicht, enthalten sein.

Vom Begriff phosphoreszierende emittierende Verbindungen sind typischerweise Verbindungen umfasst, bei denen die Lichtemission durch einen spin-verbotenen Übergang erfolgt, beispielsweise einen Übergang aus einem angeregten Triplettzustand oder einem Zustand mit einer höheren Spinquantenzahl, beispielsweise einem Quintett-Zustand.

Als phosphoreszierende emittierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende emittierende Verbindungen Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten. Dabei werden im Sinne der vorliegenden Erfindung alle lumineszierenden Iridium-, Platin- oder Kupferkomplexe als phosphoreszierende emittierende Verbindungen angesehen.

Beispiele für die oben beschriebenen emittierenden Verbindungen können den Anmeldungen WO 00/70655, WO 01/41512, WO 02/02714, WO 02/15645, EP 1191613, EP 1191612, EP 1191614, WO 05/033244, WO 05/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind. Auch kann der Fachmann ohne erfinderisches Zutun weitere phosphoreszierende Komplexe in Kombination mit den Verbindungen gemäß Formel (I) in organischen Elektrolumineszenzvorrichtungen einsetzen. Weitere Beispiele sind in einer folgenden Tabelle aufgeführt.

Die Verbindung gemäß Formel (I) kann aber auch erfindungsgemäß in einer elektronischen Vorrichtung enthaltend eine oder mehrere fluoreszierende emittierende Verbindungen eingesetzt werden.

In einer bevorzugten Ausführungsform der Erfindung werden die Verbindungen gemäß Formel (I) als Lochtransportmaterial eingesetzt. Die Verbindungen liegen dann bevorzugt in einer Lochtransportschicht, einer Elektronenblockierschicht oder einer Lochinjektionsschicht vor.

Eine Lochtransportschicht gemäß der vorliegenden Anmeldung ist eine Schicht mit lochtransportierender Funktion, welche sich zwischen Anode und emittierender Schicht befindet.

Lochinjektionsschichten und Elektronenblockierschichten werden im Sinne der vorliegenden Anmeldung als spezielle Ausführungsformen von Lochtransportschichten verstanden. Eine Lochinjektionsschicht ist dabei im Fall von mehreren Lochtransportschichten zwischen Anode und emittierender Schicht eine Lochtransportschicht, welche sich direkt an die Anode anschließt oder nur durch eine einzelne Beschichtung der Anode von ihr getrennt ist. Eine Elektronenblockierschicht ist im Fall von mehreren Lochtransportschichten zwischen Anode und emittierender Schicht diejenige Lochtransportschicht, welche sich direkt anodenseitig an die emittierende Schicht anschließt.

Wird die Verbindung gemäß Formel (I) als Lochtransportmaterial in einer Lochtransportschicht, einer Lochinjektionsschicht oder einer Elektronenblockierschicht eingesetzt, so kann die Verbindung als Reinmaterial, d.h. in einem Anteil von 100 %, in der Lochtransportschicht eingesetzt werden, oder sie kann in Kombination mit einer oder mehreren weiteren Verbindungen eingesetzt werden. Gemäß einer bevorzugten Ausführungsform enthält die organische Schicht enthaltend die Verbindung der Formel (I) dann zusätzlich einen oder mehrere p-Dotanden. Als p-Dotanden werden gemäß der vorliegenden Erfindung bevorzugt solche organischen Elektronenakzeptorverbindungen eingesetzt, die eine oder mehrere der anderen Verbindungen der Mischung oxidieren können.

Besonders bevorzugte Ausführungsformen von p-Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709, US 2010/0096600, WO 2012/095143 und DE 102012209523 offenbarten Verbindungen.

Besonders bevorzugt als p-Dotanden sind Chinodimethanverbindungen, Azaindenofluorendione, Azaphenalene, Azatriphenylene, I₂, Metallhalogenide, bevorzugt Übergangsmetallhalogenide, Metalloxide, bevorzugt Metalloxide enthaltend mindestens ein Übergangsmetall oder ein Metall der 3. Hauptgruppe, und Übergangsmetallkomplexe, bevorzugt Komplexe von Cu, Co, Ni, Pd und Pt mit Liganden enthaltend mindestens ein Sauerstoffatom als Bindungsstelle. Bevorzugt sind weiterhin Übergangsmetalloxide als Dotanden, bevorzugt Oxide von Rhenium, Molybdän und Wolfram, besonders bevorzugt Re₂O₇, MoO₃, WO₃ und ReO₃.

Die p-Dotanden liegen bevorzugt weitgehend gleichmäßig verteilt in den p-dotierten Schichten vor. Dies kann beispielsweise durch Co-Verdampfung des p-Dotanden und der Lochtransportmaterial-Matrix erreicht werden.

Bevorzugt sind als p-Dotanden insbesondere die folgenden Verbindungen:

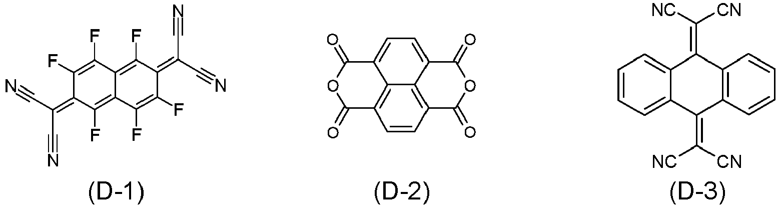

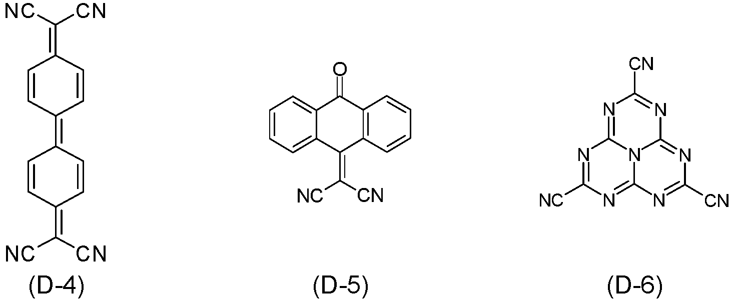

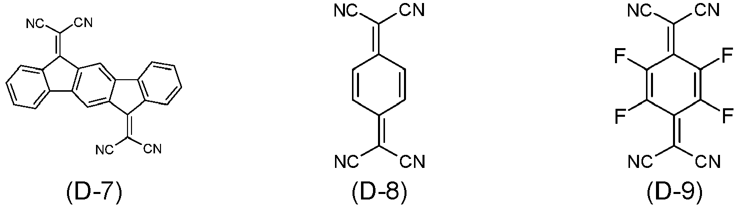

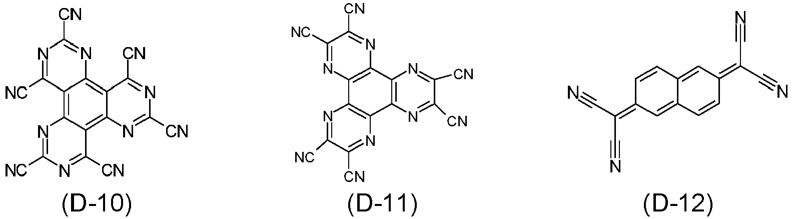

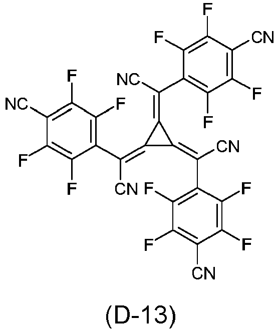

In einer weiteren bevorzugten Ausführungsform der Erfindung wird die Verbindung gemäß Formel (I) als Lochtransportmaterial in Kombination mit einem Hexaazatriphenylenderivat, wie in US 2007/0092755 beschrieben, verwendet. Besonders bevorzugt wird das Hexaazatriphenylenderivat dabei in einer separaten Schicht eingesetzt.

In einer weiteren Ausführungsform der vorliegenden Erfindung wird die Verbindung der Formel (I) in einer emittierenden Schicht als Matrixmaterial in Kombination mit einer oder mehreren emittierenden Verbindungen, vorzugsweise phosphoreszierenden emittierenden Verbindungen, eingesetzt.

Der Anteil des Matrixmaterials in der emittierenden Schicht beträgt in diesem Fall zwischen 50.0 und 99.9 Vol.-%, bevorzugt zwischen 80.0 und 99.5 Vol.-% und besonders bevorzugt für fluoreszierende emittierende Schichten zwischen 92.0 und 99.5 Vol.-% sowie für phosphoreszierende emittierende Schichten zwischen 85.0 und 97.0 Vol.-%.

Entsprechend beträgt der Anteil der emittierenden Verbindung zwischen 0.1 und 50.0 Vol.-%, bevorzugt zwischen 0.5 und 20.0 Vol.-% und besonders bevorzugt für fluoreszierende emittierende Schichten zwischen 0.5 und 8.0 Vol.-% sowie für phosphoreszierende emittierende Schichten zwischen 3.0 und 15.0 Vol.-%.

Eine emittierende Schicht einer organischen Elektrolumineszenzvorrichtung kann auch Systeme umfassend mehrere Matrixmaterialien (Mixed-Matrix-Systeme) und/oder mehrere emittierende Verbindungen enthalten. Auch in diesem Fall sind die emittierenden Verbindungen im Allgemeinen diejenigen Verbindungen, deren Anteil im System der kleinere ist und die Matrixmaterialien sind diejenigen Verbindungen, deren Anteil im System der größere ist. In Einzelfällen kann jedoch der Anteil eines einzelnen Matrixmaterials im System kleiner sein als der Anteil einer einzelnen emittierenden Verbindung.

Es ist bevorzugt, dass die Verbindungen gemäß Formel (I) als eine Komponente von Mixed-Matrix-Systemen verwendet werden. Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die Verbindung der Formel (I) stellt dabei bevorzugt das Matrixmaterial mit lochtransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt 1:20 bis 1:1, besonders bevorzugt 1:10 bis 1:1 und ganz besonders bevorzugt 1:4 bis 1:1 vorliegen. Bevorzugt werden Mixed-Matrix-Systeme in phosphoreszierenden organischen Elektrolumineszenzvorrichtungen eingesetzt. Genauere Angaben zu Mixed-Matrix-Systemen sind unter anderem in der Anmeldung WO 2010/108579 enthalten.

Die Mixed-Matrix-Systeme können einen oder mehrere emittierende Verbindungen umfassen, bevorzugt eine oder mehrere phosphoreszierende emittierende Verbindungen. Allgemein werden Mixed-Matrix-Systeme bevorzugt in phosphoreszierenden organischen Elektrolumineszenzvorrichtungen eingesetzt.

Besonders geeignete Matrixmaterialien, welche in Kombination mit den erfindungsgemäßen Verbindungen als Matrixkomponenten eines Mixed-Matrix-Systems verwendet werden können, sind ausgewählt aus den unten angegebenen bevorzugten Matrixmaterialien für phosphoreszierende emittierende Verbindungen oder den bevorzugten Matrixmaterialien für fluoreszierende emittierende Verbindungen, je nachdem welche Art von emittierender Verbindung im mixed-Matrix-System eingesetzt wird.

Bevorzugte phosphoreszierende emittierende Verbindungen zur Verwendung in Mixed-Matrix-Systemen sind dieselben, wie sie weiter oben als allgemein bevorzugte phosphoreszierende Emittermaterialien aufgeführt wurden.

Im Folgenden werden bevorzugte Ausführungsformen für die verschiedenen Funktionsmaterialien der elektronischen Vorrichtung aufgeführt.

Bevorzugte phosphoreszierende emittierende Verbindungen wurden bereits oben genannt.

Bevorzugte fluoreszierende emittierende Verbindungen sind ausgewählt aus der Klasse der Arylamine. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte emittierende Verbindungen sind Indenofluorenamine bzw. -diamine, beispielsweise gemäß WO 2006/108497 oder WO 2006/122630, Benzoindenofluorenamine bzw. -diamine, beispielsweise gemäß WO 2008/006449, und Dibenzoindenofluorenamine bzw. -diamine, beispielsweise gemäß WO 2007/140847, sowie die in WO 2010/012328 offenbarten Indenofluorenderivate mit kondensierten Arylgruppen. Ebenfalls bevorzugt sind die in WO 2012/048780 und die in WO 2013/185871 offenbarten Pyren-Arylamine. Ebenfalls bevorzugt sind die in WO 2014/037077 offenbarten Benzoindenofluoren-Amine, die in WO 2014/106522 offenbarten Benzofluoren-Amine und die in WO 2014/111269 offenbarten erweiterten Benzoindenofluorene.

Als Matrixmaterialien, bevorzugt für fluoreszierende emittierende Verbindungen, kommen Materialien verschiedener Stoffklassen in Frage. Bevorzugte Matrixmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052) oder der Benzanthracene (z. B. gemäß WO 2008/145239). Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind. Bevorzugt sind weiterhin die in WO 2006/097208, WO 2006/131192, WO 2007/065550, WO 2007/110129, WO 2007/065678, WO 2008/145239, WO 2009/100925, WO 2011/054442, und EP 1553154 offenbarten Anthracenderivate, sowie die in EP 1749809, EP 1905754 und US 2012/0187826 offenbarten Pyren-Verbindungen.

Bevorzugte Matrixmaterialien für phosphoreszierende emittierende Verbindungen sind neben den Verbindungen der Formel (I) aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109, WO 2011/000455 oder WO 2013/041176, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, überbrückte CarbazolDerivate, z. B. gemäß US 2009/0136779, WO 2010/050778, WO 2011/042107, WO 2011/088877 oder WO 2012/143080, Triphenylenderivaten, z. B. gemäß WO 2012/048781, oder Lactame, z. B. gemäß WO 2011/116865 oder WO 2011/137951.

Geeignete Ladungstransportmaterialien, wie sie in der Lochinjektions- bzw. Lochtransportschicht bzw. Elektronenblockierschicht oder in der Elektronentransportschicht der erfindungsgemäßen elektronischen Vorrichtung verwendet werden können, sind neben den Verbindungen der Formel (I) beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Bevorzugt umfasst die erfindungsgemäße OLED zwei oder mehr unterschiedliche lochtransportierende Schichten. Die Verbindung der Formel (I) kann dabei in einer oder in mehreren oder in allen lochtransportierende Schichten eingesetzt werden. Gemäß einer bevorzugten Ausführungsform wird die Verbindung der Formel (I) in genau einer lochtransportierenden Schicht eingesetzt, und in den weiteren vorhandenen loch transportierenden Schichten werden andere Verbindungen eingesetzt, bevorzugt aromatische Aminverbindungen.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise Alq₃, Zirkoniumkomplexe, beispielsweise Zrq₄, Lithiumkomplexe, beispielsweise Liq, Benzimidazolderivate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Als Kathode der elektronischen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die Vorrichtung wird entsprechend (je nach Anwendung) strukturiert, kontaktiert und schließlich versiegelt, um schädigende Effekte von Wasser und Luft auszuschließen.

In einer bevorzugten Ausführungsform ist die elektronische Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Dabei ist es jedoch auch möglich, dass der Anfangsdruck noch geringer ist, beispielsweise kleiner 10⁻⁷ mbar.

Bevorzugt ist ebenfalls eine elektronische Vorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronische Vorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen gemäß Formel (I) nötig. Hohe Löslichkeit lässt sich durch geeignete Substitution der Verbindungen erreichen.

Weiterhin bevorzugt ist es, dass zur Herstellung einer erfindungsgemäßen elektronischen Vorrichtung eine oder mehrere Schichten aus Lösung und eine oder mehrere Schichten durch ein Sublimationsverfahren aufgetragen werden.

Erfindungsgemäß können die elektronischen Vorrichtungen enthaltend eine oder mehrere Verbindungen gemäß Formel (I) in Displays, als Lichtquellen in Beleuchtungsanwendungen sowie als Lichtquellen in medizinischen und/oder kosmetischen Anwendungen (z.B. Lichttherapie) eingesetzt werden.

### Ausführungsbeispiele

### A) Synthesebeispiele

### Beispiel 1: Synthese der Verbindungen (1-1) bis (1-14)

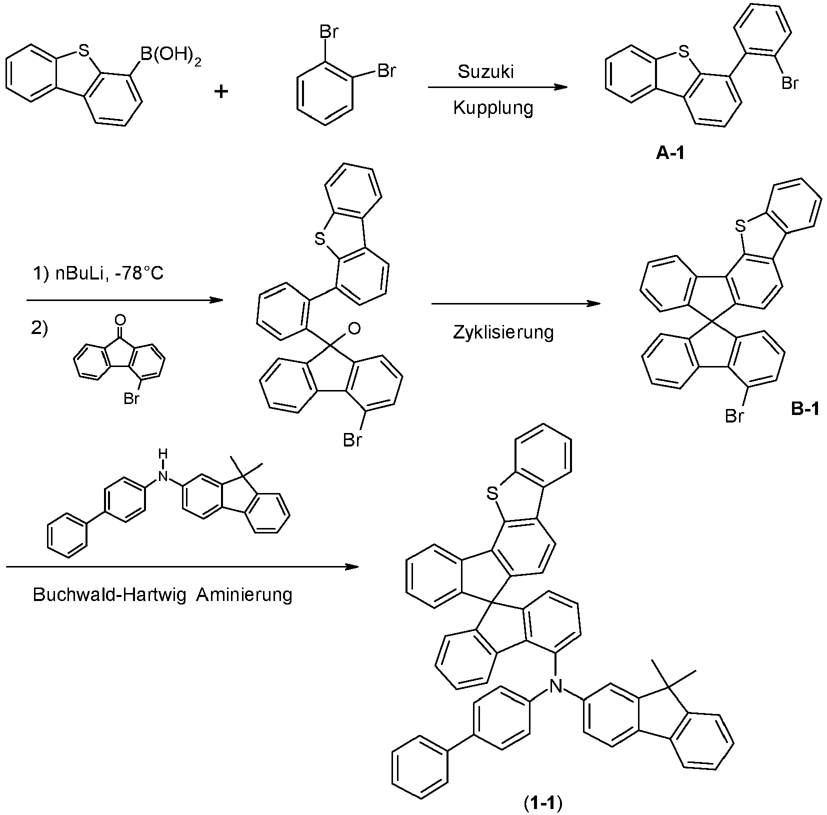

### Synthese von 4-(2-Bromo-phenyl)-dibenzothiophen A-1

80 g (351 mmol) Dibenzothiophen-4-Boronsäure (CAS: 108847-20-7), 83 g (351 mmol) 1,2-Dibrombenzol und 8,2g (7,02 mmol) Pd(Ph₃P)₄ werden in 700 mL Dioxan suspendiert. Zu dieser Suspension werden 440 mL (877 mmol) Kaliumcarbonat-Lösung (2 M) langsam addiert, und die Reaktionsmischung wird 18 h unter Rückfluss erhitzt. Nach Erkalten wird die organische Phase abgetrennt, über Kieselgel filtriert, dreimal mit 200 mL Wasser gewaschen und anschließend zur Trockne eingeengt. Der Rückstand wird durch Chromatographie an Kieselgel gereinigt. Ausbeute: 95 g (280 mmol), 80% d. Th., Reinheit nach HPLC >97%.

Analog zu der beschriebenen Synthese von Verbindung A-1 werden die folgenden Verbindungen hergestellt:

| | Edukt 1 | Edukt 2 | Produkt | Ausbeute |
|---|---|---|---|---|
| **A-2** | 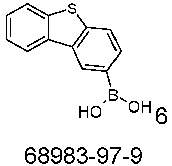 | 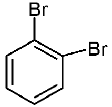 | 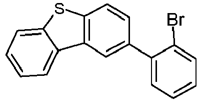 | 73% |
| **A-3** | 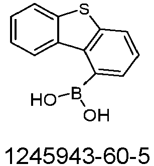 | 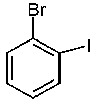 | 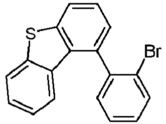 | 61% |
| **A-4** | 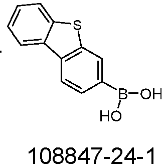 | 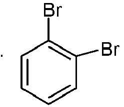 | 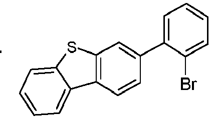 | 78% |
| **A-5** | 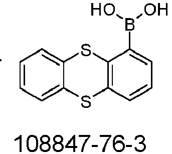 | 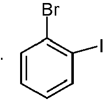 | 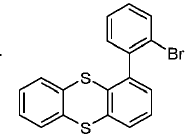 | 83% |
| **A-6** | 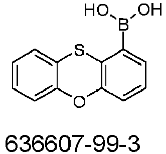 | 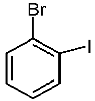 | 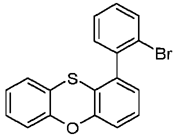 | 75% |

### Synthese der Zwischenstufe B-1

56,3g (166 mmol) 4-(2-Bromo-phenyl)-dibenzothiophen A-1 werden in 700 mL THF bei -78°C vorgelegt. Bei dieser Temperatur werden 70 mL BuLi (2,5 M in Hexan) zugetropft. Nach 1 Stunde werden 45,2 g (174 mmol) Fluoren-9-on in 200 mL THF zugetropft. Der Ansatz wird über Nacht bei Raumtemperatur rühren gelassen, auf Eiswasser gegeben und mit Dichlormethan extrahiert. Die vereinigten organischen Phasen werden mit Wasser gewaschen und über Natriumsulfat getrocknet. Das Lösungsmittel wird im Vakuum entfernt und der Rückstand wird ohne weitere Aufreinigung mit 90 mL HCl und 1L AcOH bei 75°C über Nacht erhitzt. Nach Erkalten saugt man vom ausgefallenen Feststoff ab, wäscht diesen zweimal mit 150 ml Wasser, dreimal mit je 150 ml Ethanol und kristallisiert abschließend aus Heptan um. Ausbeute: 54g (107 mmol), 65 %; Reinheit ca. 98 % nach ¹H-NMR.

Analog zu der beschriebenen Synthese von Verbindung B-1 werden die folgenden Verbindungen hergestellt:

| | Edukt 1 | Edukt 2 | Produkt | Ausbeute |
|---|---|---|---|---|
| **B-2** | 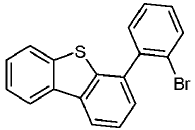 | 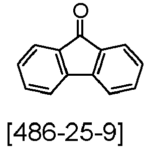 | 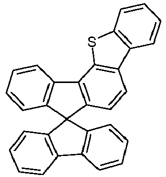 | 70% |
| **B-3** | 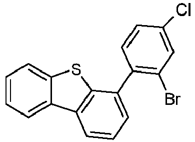 | 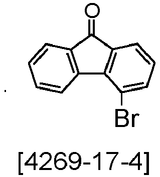 | 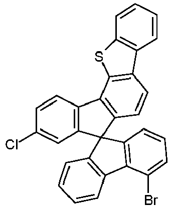 | 62% |
| **B-4** | 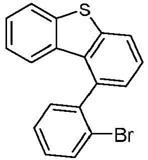 | 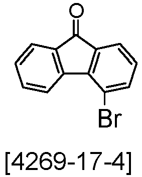 | 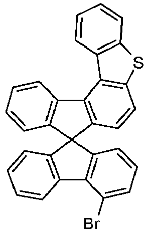 | 75% |
| **B-5** | 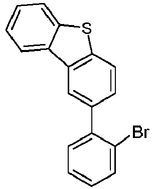 | 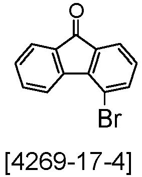 | 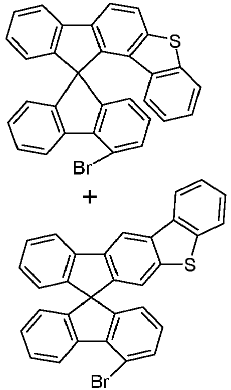 | 68% |
| **B-6** | 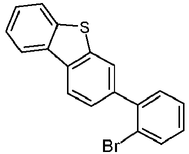 | 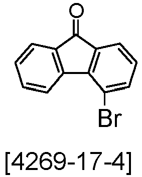 | 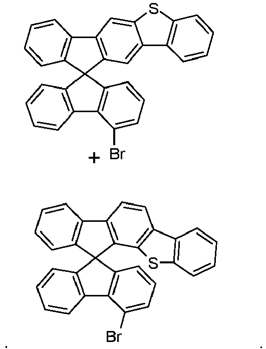 | 70% |
| **B-7** | 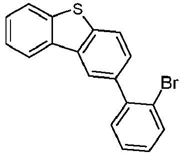 | 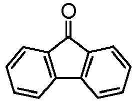 | 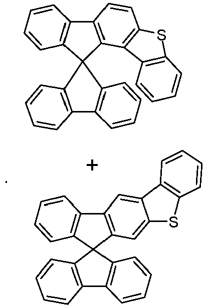 | 65% |
| **B-8** | 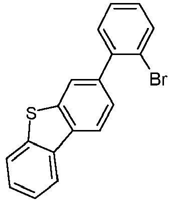 | 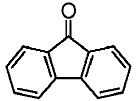 | 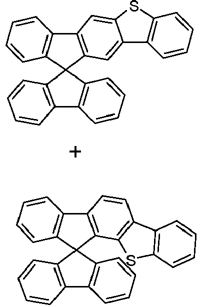 | 80% |
| **B-9** | 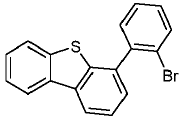 | 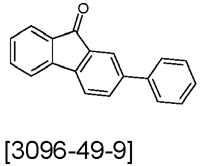 | 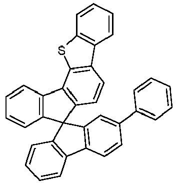 | |
| **B-10** | 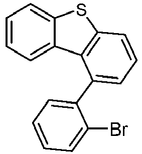 | 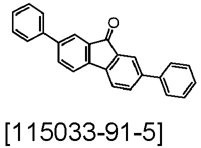 | 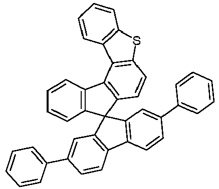 | 64% |
| **B-11** | 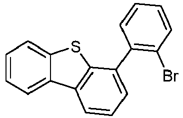 | 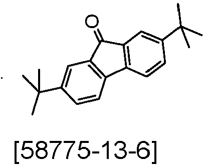 | 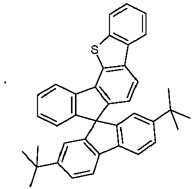 | 71% |
| **B-12** | 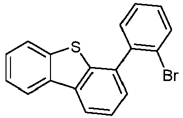 | 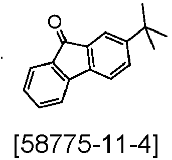 | 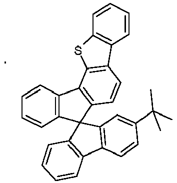 | 70% |
| **B-13** | 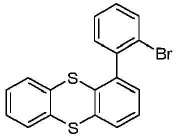 | 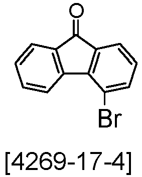 | 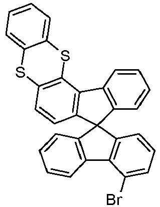 | 56% |
| **B-14** | 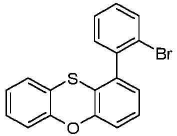 | 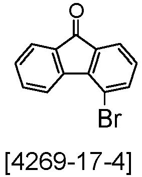 | 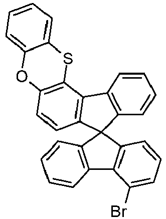 | 72% |

### Synthese der Verbindung (1-1)

14,3 g (39,5 mmol) Biphenyl-4-yl-(9,9-dimethyl-9H-fluoren-2-yl)-amin und 19,8 g (39,5 mol) des Bromo-Spiroderivats B-1 werden in 350 mL Toluol gelöst. Die Lösung wird entgast und mit N₂ gesättigt. Danach wird sie mit 1,55 mL (1,55 mmol) einer 1M Tri-tert-Butylphosphin Lösung und 173 mg (1,44 mmol) Pd(AcO)₂ versetzt und anschließend werden 9,5 g Natrium-tert-butylat (98,7 mmol) zugegeben. Die Reaktionsmischung wird 4 h unter Schutzatmosphäre zum Sieden erhitzt. Das Gemisch wird im Anschluss zwischen Toluol und Wasser verteilt, die organische Phase dreimal mit Wasser gewaschen und über Na₂SO₄ getrocknet und einrotiert. Nach Filtration des Rohproduktes über Kieselgel mit Toluol wird der verbleibende Rückstand aus Heptan/Toluol umkristallisiert und abschließend im Hochvakuum sublimiert. Die Reinheit beträgt 99.9%(HPLC). Die Ausbeute von Verbindung (1-1) beträgt 22 g (73% der Theorie).

### Synthese der Verbindungen (1-2) bis (1-14)

Analog zu der in Beispiel 1 beschriebenen Synthese von Verbindung (**1-1**) werden auch die folgenden Verbindungen (**1-2**) bis (**1-14**) hergestellt.

| | Edukt 1 | Edukt 2 | Produkt | Ausbeute |
|---|---|---|---|---|
| **1-2** | 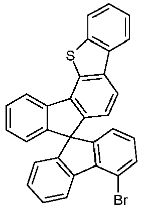 | 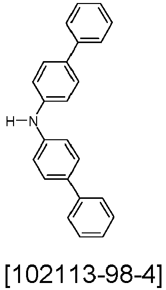 | 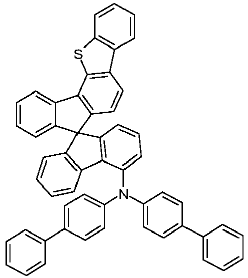 | 78% |
| **1-3** | 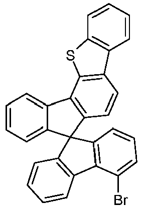 | 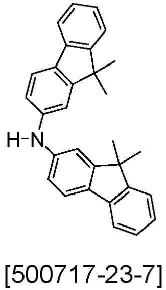 | 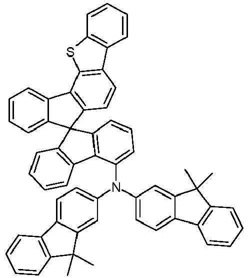 | 78% |
| **1-4** | 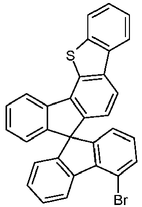 | 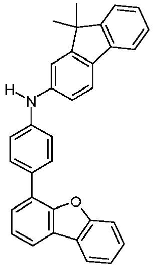 | 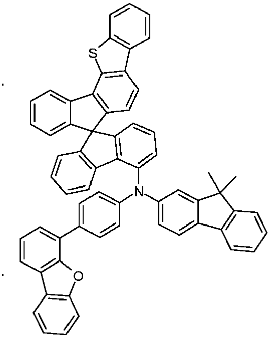 | 83% |
| **1-5** | 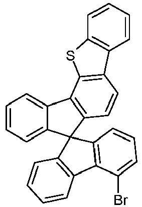 | 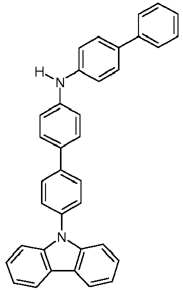 | 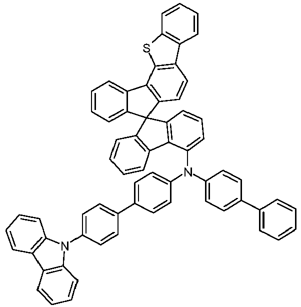 | 66% |
| **1-6** | 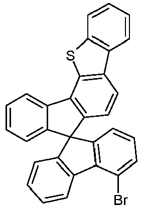 | 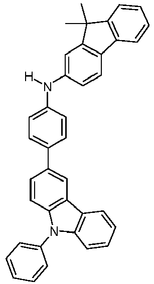 | 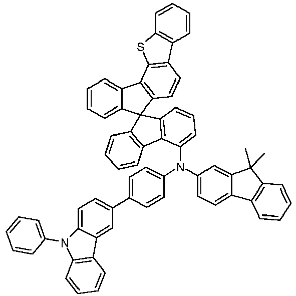 | 67% |
| **1-7** | 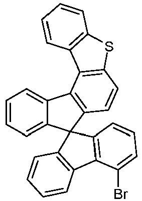 | 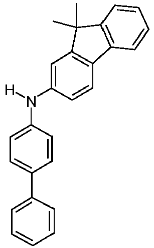 | 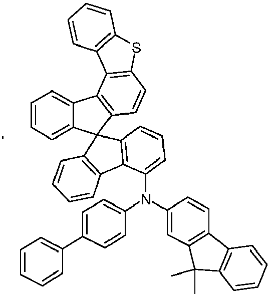 | 79% |
| **1-8** | 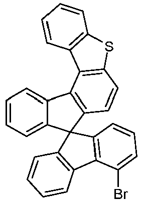 | 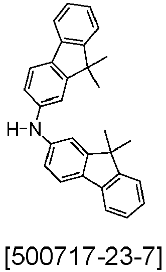 | 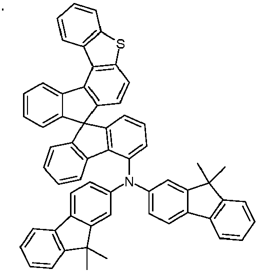 | 77% |
| **1-9** | 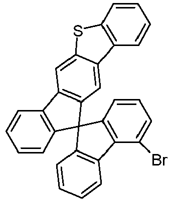 | 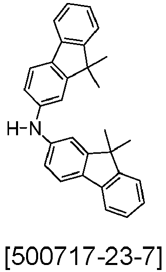 | 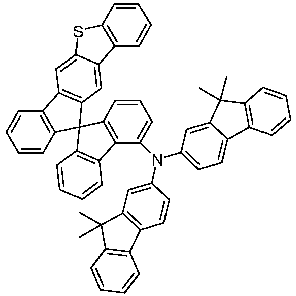 | 72% |
| **1-10** | 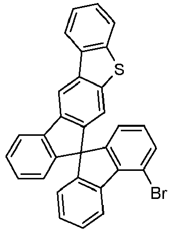 | 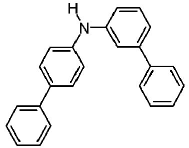 | 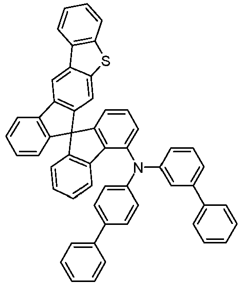 | 68% |
| **1-11** | 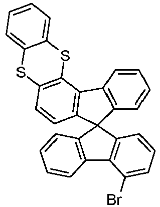 | 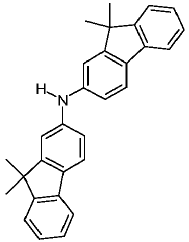 | 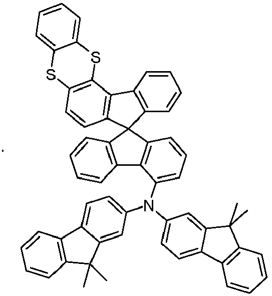 | 68% |
| **1-12** | 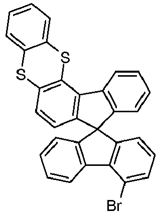 | 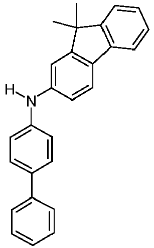 | 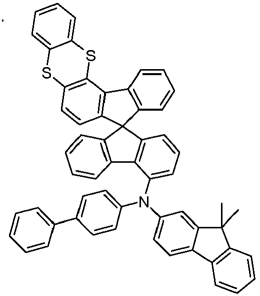 | 74% |
| **1-13** | 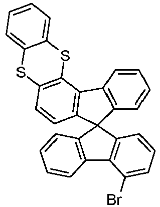 | 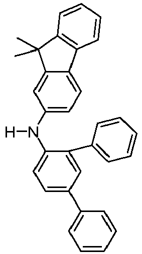 | 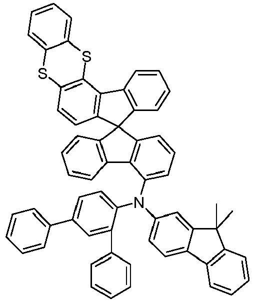 | 67% |
| **1-14** | 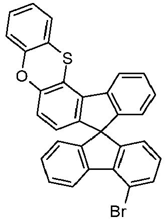 | 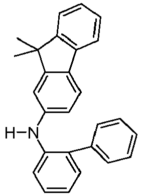 | 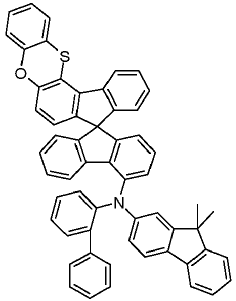 | 71% |

### Beispiel 2: Synthese der Verbindungen (2-1) bis (2-12)

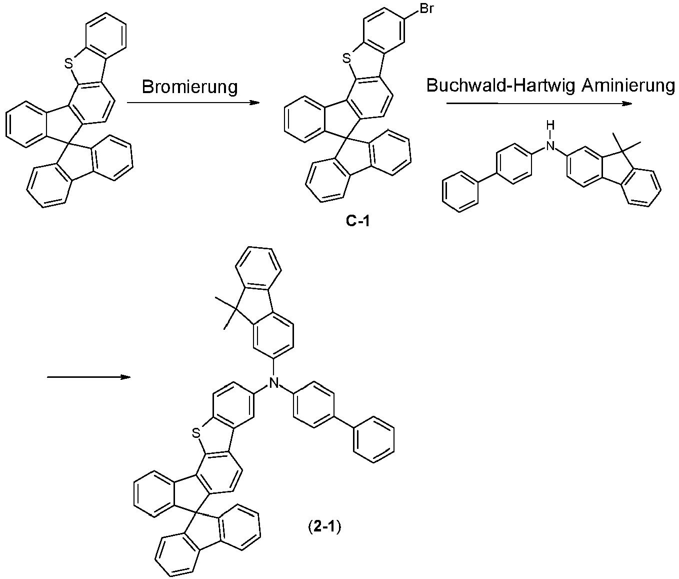

### Synthese der Zwischenstufe C-1

18 g (44 mmol) der Ausgangsverbindung werden in 200 mL Acetonitril gelöst und bei Raumtemperatur portionsweise mit 7,5 g (42 mmol) N-Bromsuccinimid versetzt. Nach vollständiger Umsetzung werden Wasser und Essigsäureethylester dazu gegeben, die organische Phase abgetrennt, getrocknet und eingeengt. Das Rohprodukt wird anschließend mit MeOH mehrfach heiß ausgerührt. Ausbeute: 16,13 g (75%) des Brom-Spiroderivats C-1.

Analog dazu werden die folgenden bromierten Verbindungen hergestellt:

| | Edukt 1 | Bromierung Reagenz | Produkt | Ausbeute |
|---|---|---|---|---|
| **C-2** | 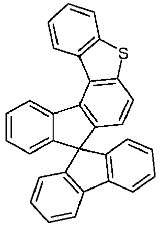 | NBS | 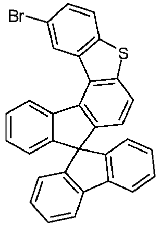 | 68 % |
| **C-3** | 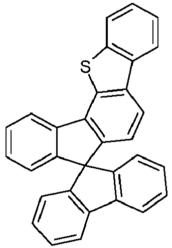 | 1) nBuLi, -78°C | 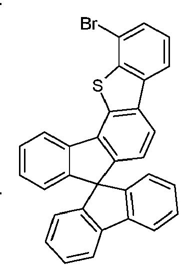 | 50% |
| | | 2) BrCH₂-CH₂Br | | |
| **C-4** | 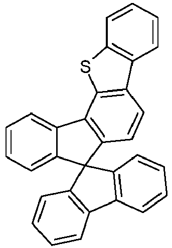 | 1) nBuLi, -78°C | 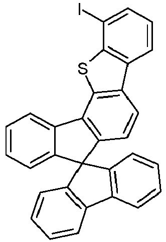 | 45% |
| | | 2) I2 | | |
| **C-5** | 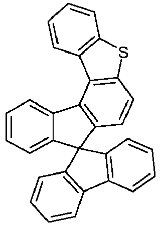 | 1) nBuLi, -78°C | 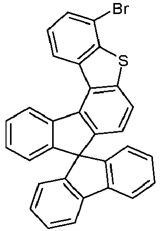 | 40 % |
| | | 2) BrCH₂-CH₂Br | | |
| **C-6** | 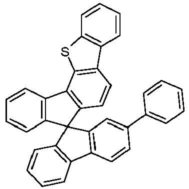 | 1) nBuLi, -78°C | 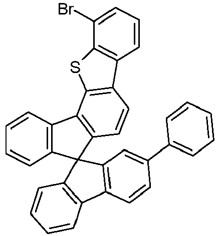 | 40% |
| | | 2) BrCH₂-CH₂Br | | |
| **C-7** | 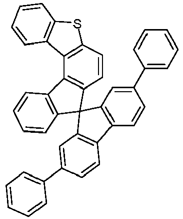 | NBS | 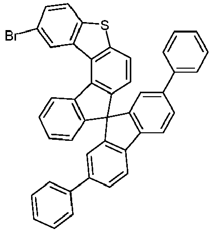 | 66% |
| **C-8** | 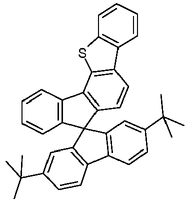 | 1) nBuLi, -78°C | 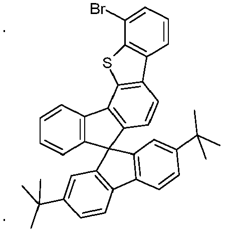 | 50% |
| | | 2) BrCH₂-CH₂Br | | |
| **C-9** | 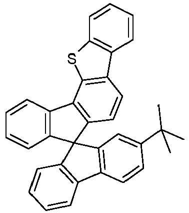 | 1) nBuLi, -78°C | 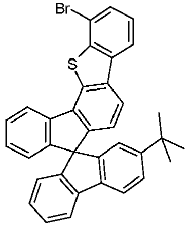 | 48% |
| | | 2) BrCH₂-CH₂Br | | |
| **C-10** | 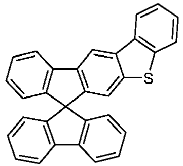 | NBS | 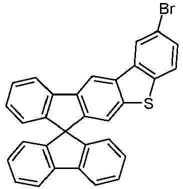 | 61% |
| **C-11** | 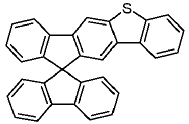 | NBS | 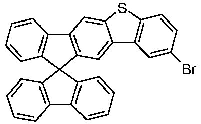 | 60% |

### Synthese der Verbindungen (2-1) bis (2-12)

Analog zu der in Beispiel 1 beschriebenen Synthese von Verbindung (**1-1**) werden auch die folgenden Verbindungen (**2-1**) bis (**2-12**) hergestellt.

| | Edukt 1 | Edukt 2 | Produkt | Ausbeute |
|---|---|---|---|---|
| **2-1** | 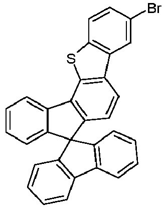 | 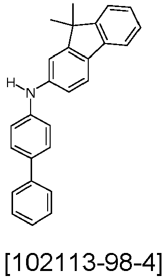 | 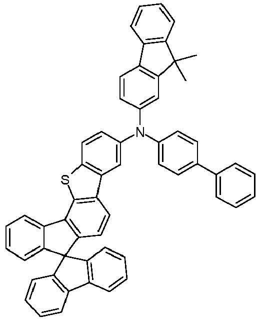 | 76% |
| **2-2** | 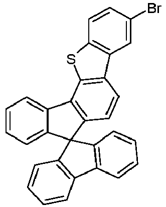 | 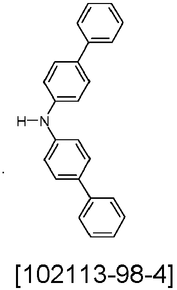 | 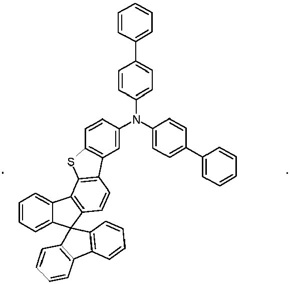 | 80% |
| **2-3** | 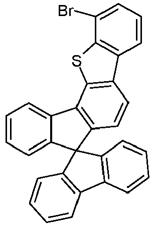 | 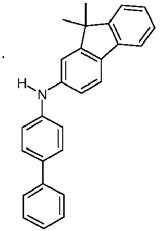 | 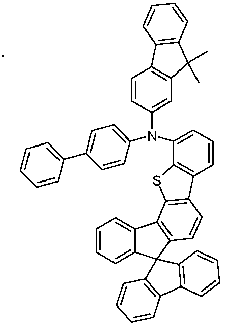 | 71% |
| **2-4** | 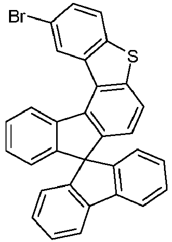 | 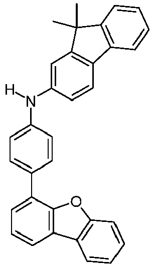 | 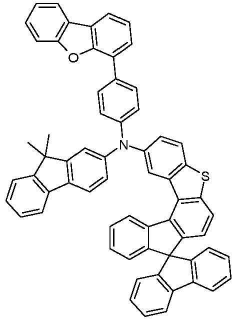 | 78% |
| **2-5** | 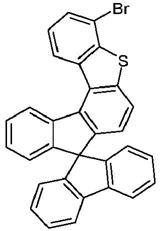 | 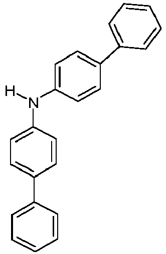 | 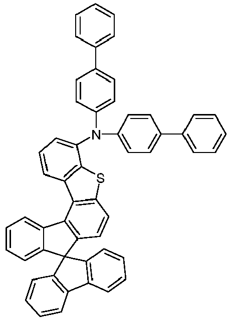 | 82% |
| **2-6** | 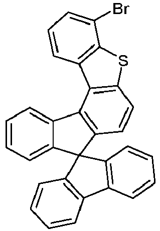 | 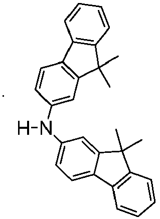 | 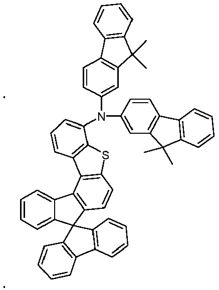 | 77% |
| **2-7** | 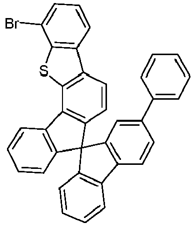 | 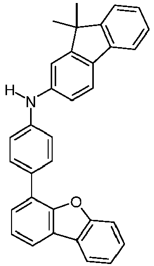 | 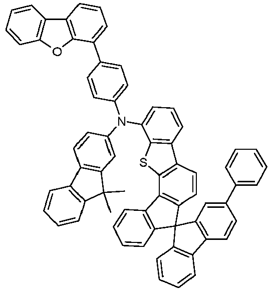 | 75% |
| **2-8** | 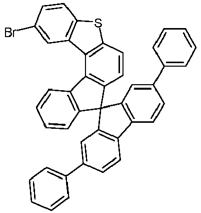 | 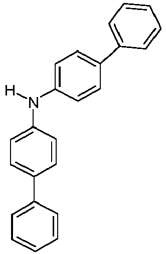 | 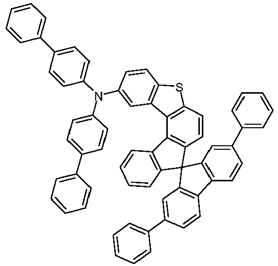 | 81% |
| **2-9** | 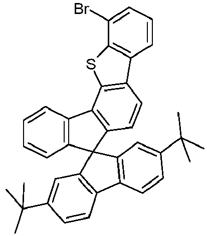 | 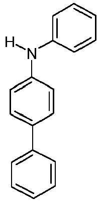 | 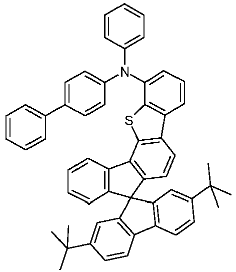 | 83% |
| **2-10** | 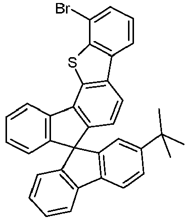 | 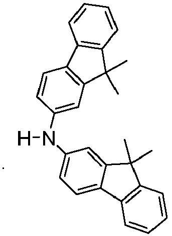 | 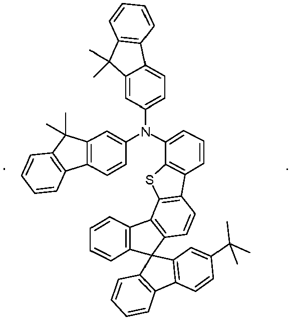 | 75% |
| **2-11** | 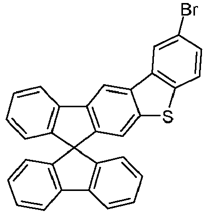 | 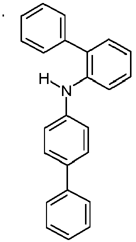 | 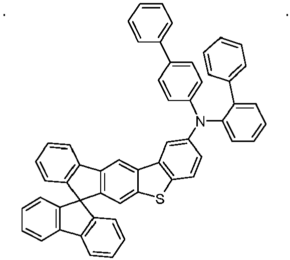 | 75% |
| **2-12** | 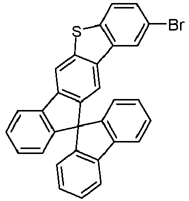 | 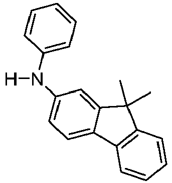 | 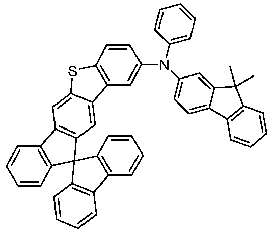 | 79% |

### Beispiel 3: Synthese der Verbindungen 3-1 bis 3-11

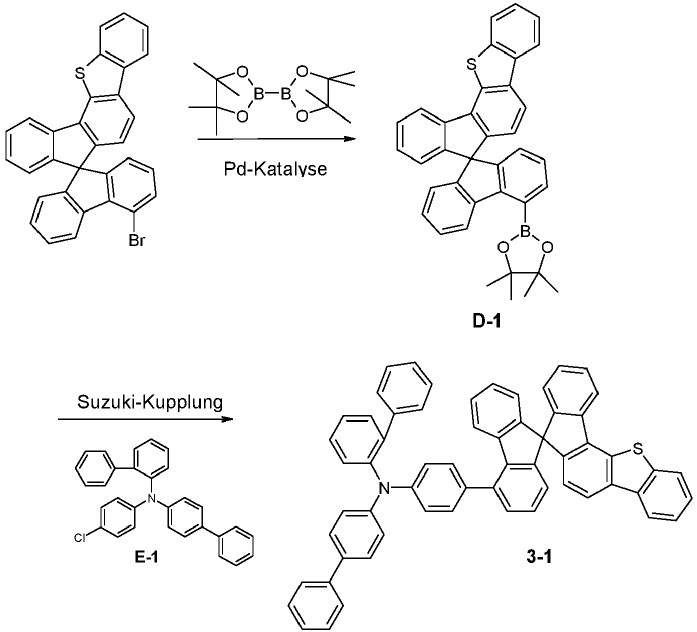

### Spirofluoren-boronester-Derivat (D-1)

25 g (49,9 mmol) des Spirofluoren-bromderivats, 14 g (55 mmol) Bis(pinacolato)diboran und 14,7 g (150 mmol) Kalliumacetat werden in 400 ml DMF suspendiert. Zu dieser Suspension werden 1,22 g (1,5 mmol) 1,1-Bis(diphenylphosphino)ferrocen-dichloropalladium(II) Komplex mit DCM gegeben. Die Reaktionsmischung wird 16 h unter Rückfluss erhitzt. Nach Erkalten wird die organische Phase abgetrennt, dreimal mit 400 mL Wasser gewaschen und anschließend zur Trockne eingeengt. Der Rückstand wird aus Toluol umkristallisiert (25 g, 92% Ausbeute).

Analog dazu werden folgende Verbindungen hergestellt:

| | Edukt 1 | Produkt | Ausbeute |
|---|---|---|---|
| **D-2** | 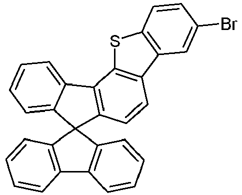 | 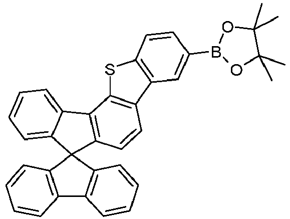 | 80% |
| **D-3** | 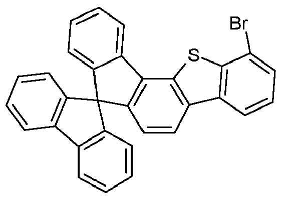 | 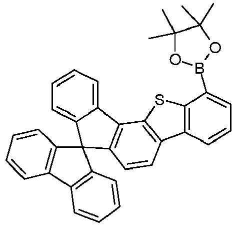 | 83% |
| **D-4** | 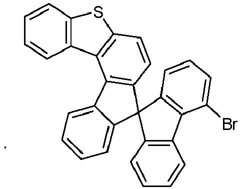 | 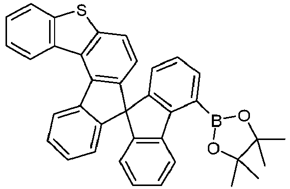 | 88% |
| **D-5** | 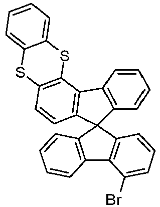 | 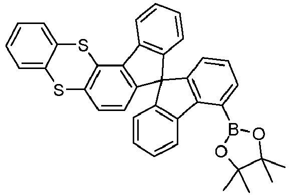 | 88% |
| **D-6** | 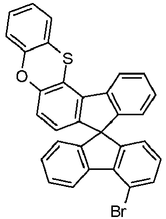 | 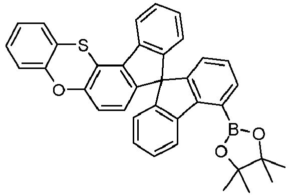 | 76% |

### Biphenyl-2-yl-biphenyl-4-yl-(4-chloro-phenyl)-amin (E-1)

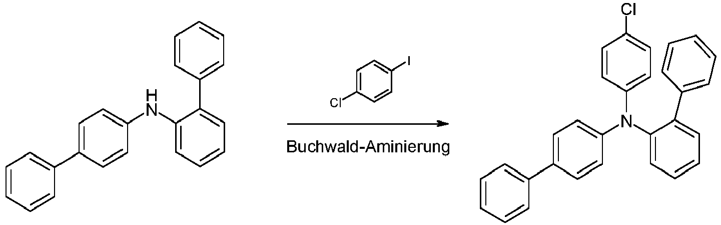

23,8 g Biphenyl-2-yl-biphenyl-4-yl-amin (74 mmol) und 21,2 g 4-Chloriodbenzol (89 mmol) werden in 500 mL Toluol gelöst. Die Lösung wird entgast und mit N₂ gesättigt. Danach wird sie mit 3 mL (3 mmol) einer Tri-tert-Butylphosphin 1M-Lösung und 0,33 g (1,48 mmol) Palladium(II)acetat versetzt und anschließend werden 10,7 g Natrium-tert-butylat (111 mmol) zugegeben. Die Reaktionsmischung wird 12 h unter Schutzatmosphäre zum Sieden erhitzt. Das Gemisch wird im Anschluss zwischen Toluol und Wasser verteilt, die organische Phase dreimal mit Wasser gewaschen und über Na₂SO₄ getrocknet und einrotiert. Nach Filtration des Rohproduktes über Kieselgel mit Toluol wird der verbleibende Rückstand aus Heptan/Toluol umkristallisiert. Die Ausbeute beträgt 29 g (90% d. Th).

Analog dazu werden folgende Verbindungen hergestellt:

| | Edukt 1 | Edukt 2 | Produkt | Ausbeute |
|---|---|---|---|---|
| **E-2** | 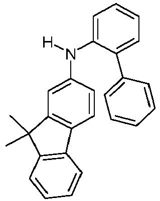 | 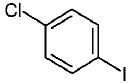 | 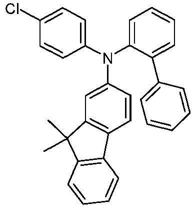 | 78% |
| **E-3** | 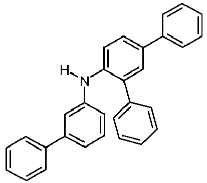 | 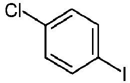 | 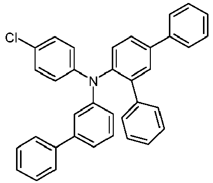 | 80% |
| **E-4** | 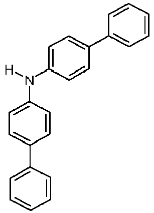 | 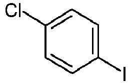 | 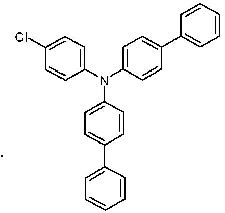 | 81% |
| **E-5** | 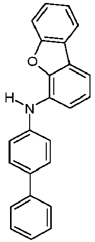 | 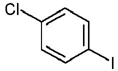 | 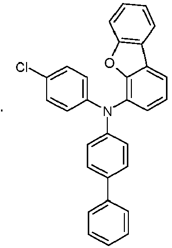 | 92% |
| **E-6** | 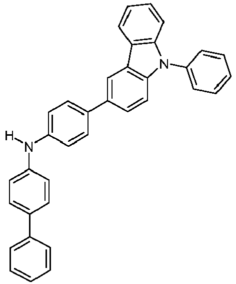 | 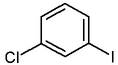 | 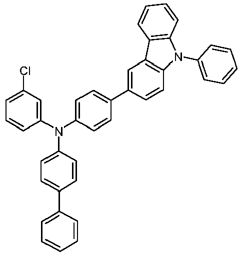 | 85% |
| **E-7** | 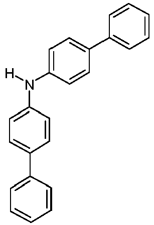 | 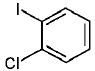 | 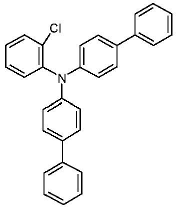 | 75% |

### Synthese der Verbindung (3-1)

19,05 g (35 mmol) Spirofluoren-pinacolboronester Derivat D-1 und 19,0 g (35 mmol) Chlor-Derivat E-1 werden in 300 mL Dioxan und 10,6 g Caesiumfluorid (69,4 mmol) suspendiert. Zu dieser Suspension werden 1,3 g (1,73 mmol) Palladium dichlorid-bis(tricyclohexylphosphin) gegeben, und die Reaktionsmischung wird 24 h unter Rückfluss erhitzt. Nach Erkalten wird die organische Phase abgetrennt, über Kieselgel filtriert, dreimal mit 100 mL Wasser gewaschen und anschließend zur Trockne eingeengt. Nach Filtration des Rohproduktes über Kieselgel mit Toluol wird der verbleibende Rückstand aus Heptan/Toluol umkristallisiert und abschließend im Hochvakuum sublimiert. Die Reinheit beträgt 99.9%. Die Ausbeute beträgt 21,3 g (75% d. Th).

### Synthese der Verbindungen (3-2) bis (3-11)

Analog zu der in Beispiel 1 beschriebenen Synthese von Verbindung (**3-1**) werden auch die folgenden Verbindungen (**3-2**) bis (**3-11**) hergestellt.

| | Edukt 1 | Edukt 2 | Produkt | Ausbeute |
|---|---|---|---|---|
| **3-2** | 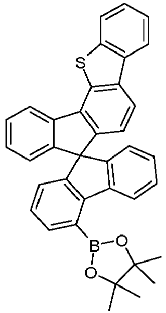 | 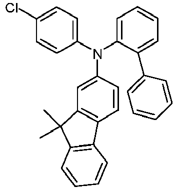 | 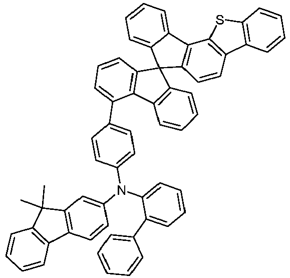 | 78 % |
| **3-3** | 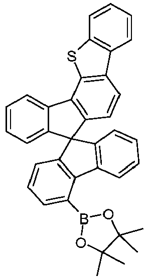 | 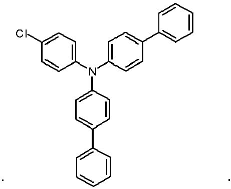 | 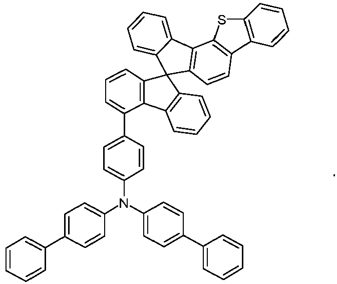 | 71% |
| **3-4** | 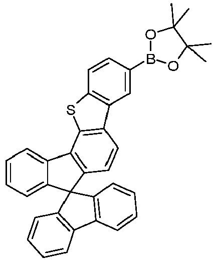 | 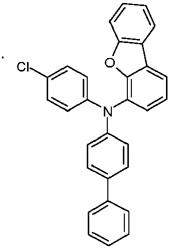 | 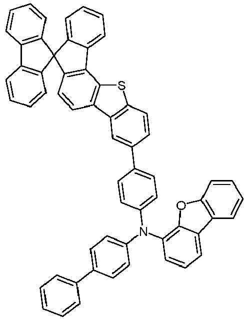 | 82% |
| **3-5** | 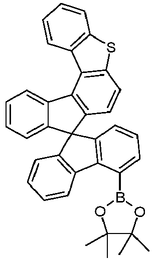 | 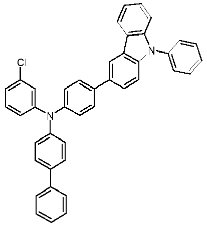 | 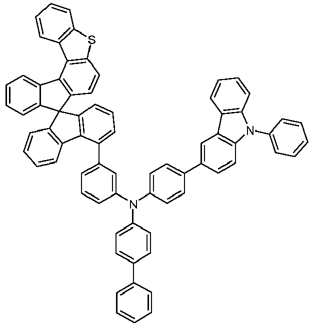 | 89% |
| **3-6** | 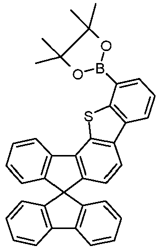 | 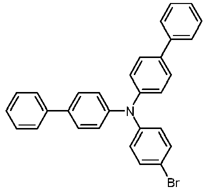 | 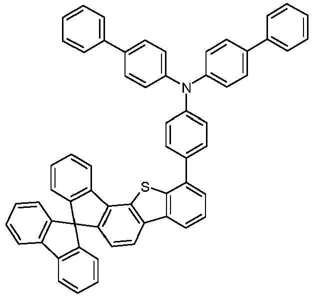 | 69% |
| **3-7** | 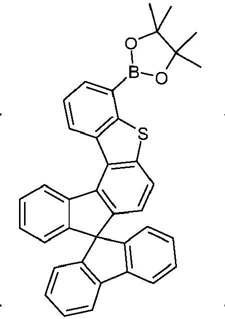 | 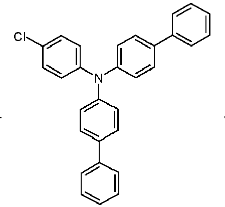 | 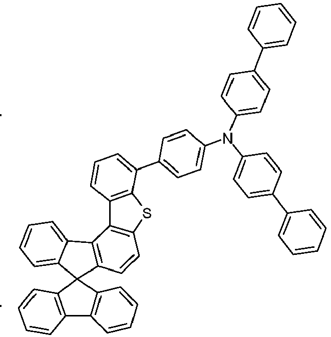 | 75% |
| **3-8** | 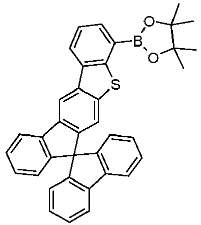 | 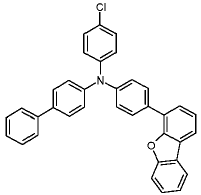 | 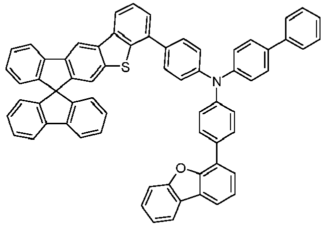 | 72% |
| **3-9** | 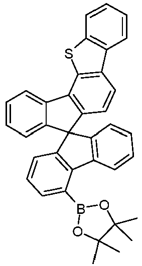 | 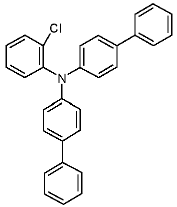 | 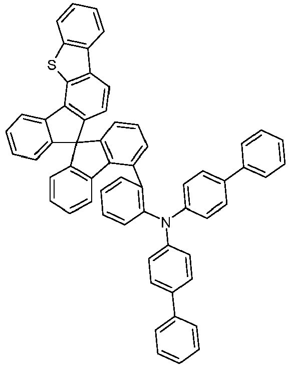 | 63% |
| **3-10** | 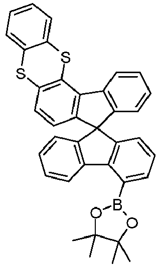 | 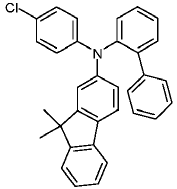 | 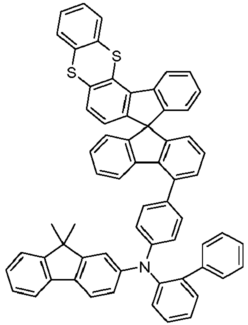 | 75% |
| **3-11** | 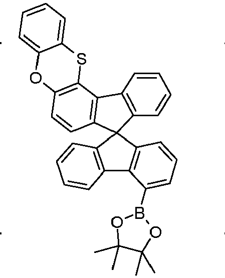 | 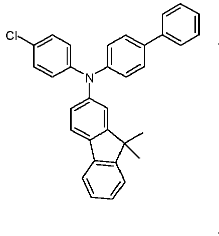 | 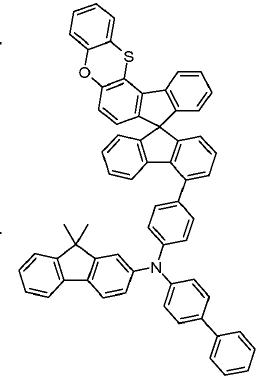 | 77% |

### Beispiel 4: Synthese der Verbindungen 4-1 bis 4-9

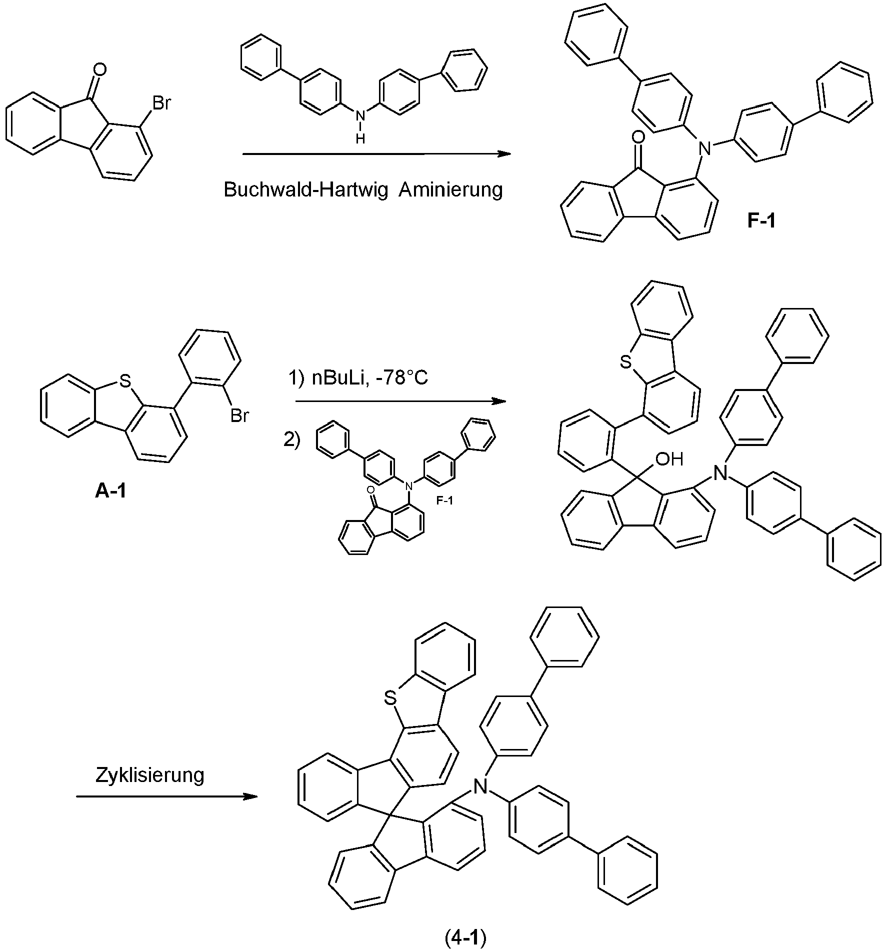

### Synthese der Verbindungen F-1 bis F-5

27 g (85 mmol) bis-Biphenyl-amin und 22,0 g (85m mol) des 1-Brom-fluorenon werden in 170 mL Toluol gelöst. Die Lösung wird entgast und mit N₂ gesättigt. Danach wird sie mit 4 mL (1,7 mmol) einer 10%igen Tri-tert-Butylphosphin Lösung und 0,2 g (0,89 mmol) Pd(AcO)₂ versetzt und anschließend werden 12,2 g Natrium-tert-butylat (127 mmol) zugegeben. Die Reaktionsmischung wird 12 h unter Schutzatmosphäre zum Sieden erhitzt. Das Gemisch wird im Anschluss zwischen Toluol und Wasser verteilt, die organische Phase dreimal mit Wasser gewaschen und über Na₂SO₄ getrocknet und einrotiert. Nach Filtration des Rohproduktes über Kieselgel mit Toluol wird der verbleibende Rückstand aus Heptan/Toluol umkristallisiert. Die Ausbeute von Verbindung F-1 beträgt 34 g (80% der Theorie).

| | Edukt 1 | Edukt 2 | Produkt | Ausbeute |
|---|---|---|---|---|
| **F-2** | 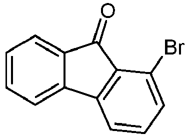 | 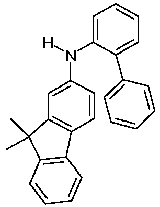 | 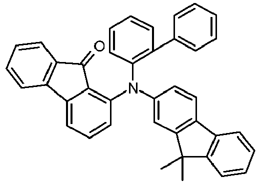 | 67% |
| **F-3** | 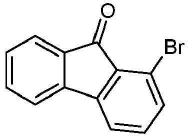 | 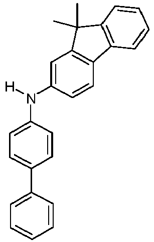 | 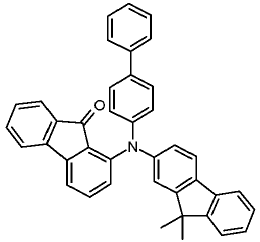 | 75% |
| **F-4** | 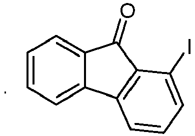 | 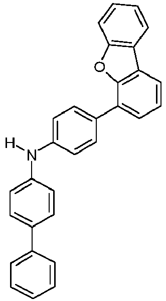 | 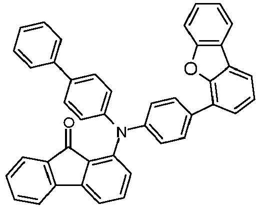 | 80% |
| **F-5** | 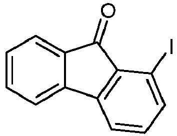 | 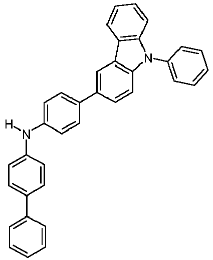 | 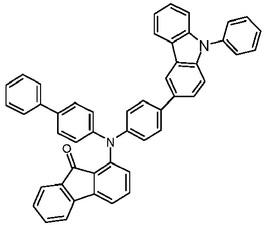 | 78% |

### Synthese der Verbindungen F-6 bis F-8

Analog zu der in Beispiel 1 beschriebenen Synthese von Verbindung (**3-1**) werden auch die folgenden Verbindungen (**F-6**) bis (**F-8**) hergestellt.

| | Edukt 1 | Edukt 2 | Produkt | Ausbeute |
|---|---|---|---|---|
| **F-6** | 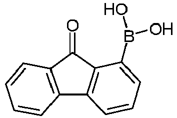 | 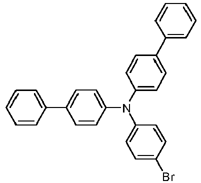 | 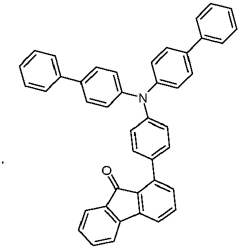 | 89% |
| **F-7** | 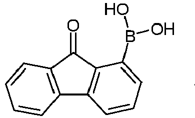 | 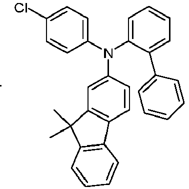 | 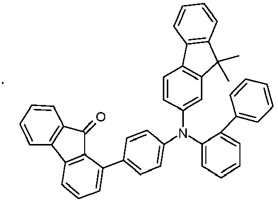 | 85% |
| **F-8** | 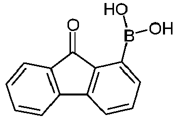 | 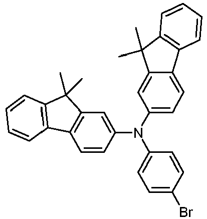 | 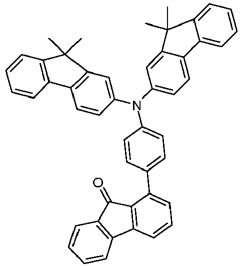 | 75% |

### Synthese der Verbindungen 4-1 bis 4-9

30 g (88 mmol) 4-(2-Bromo-phenyl)-dibenzothiophen wird in 300 mL THF bei -78°C vorgelegt. Bei dieser Temperatur werden 39 mL BuLi (2,5 M in Hexan) zugetropft. Nach 1 Stunde wird 44 g (88 mmol) Fluorenon F-1 in 200 mL THF zugetropft. Der Ansatz wird über Nacht bei Raumtemperatur rühren gelassen, auf Eiswasser gegeben und mit Dichlormethan extrahiert. Die vereinigten organischen Phasen werden mit Wasser gewaschen und über Natriumsulfat getrocknet. Das Lösungsmittel wird im Vakuum entfernt und der Rückstand wird ohne weitere Aufreinigung mit 100 mL HCl und 1200 mL AcOH bei 75°C über Nacht unter Rückfluß erhitzt. Nach Erkalten saugt man vom ausgefallenen Feststoff ab, wäscht diesen einmal mit 100 ml Wasser, dreimal mit je 100 ml Ethanol, kristallisiert aus Heptan um und abschließend im Hochvakuum sublimiert. Ausbeute: 40 g (53 mmol), 60 %; Reinheit ca. 99,9 % nach HPLC.

Analog können die weiteren Verbindungen 4-2 bis 4-9 hergestellt werden:

| | Edukt 1 | Edukt 2 | Produkt | Ausbeute |
|---|---|---|---|---|
| **4-2** | 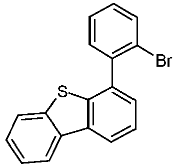 | 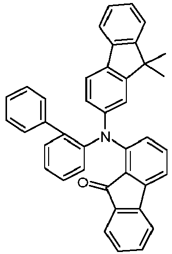 | 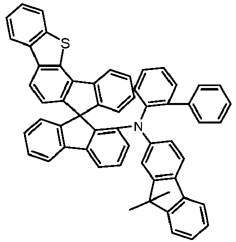 | 50% |
| **4-3** | 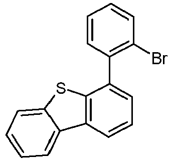 | 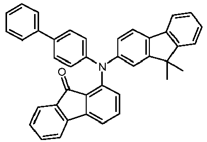 | 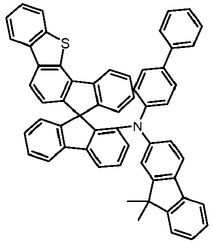 | 61% |
| **4-4** | 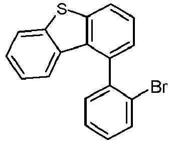 | 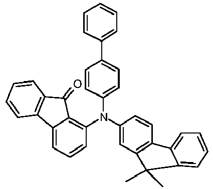 | 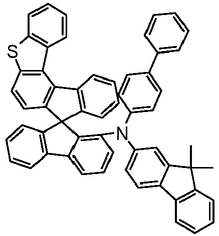 | 48% |
| **4-5** | 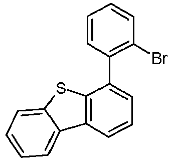 | 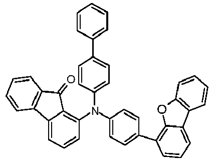 | 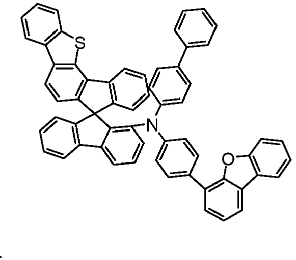 | 49% |
| **4-6** | 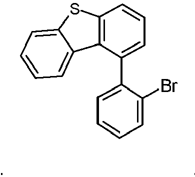 | 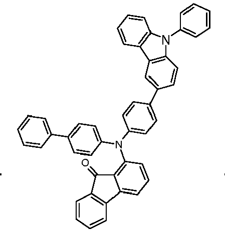 | 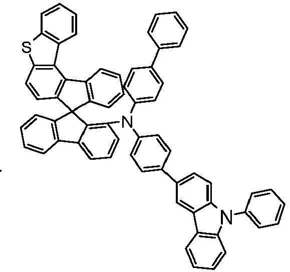 | 45% |
| **4-7** | 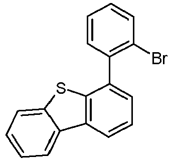 | 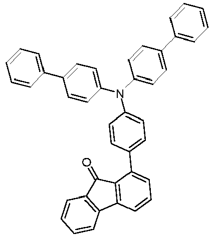 | 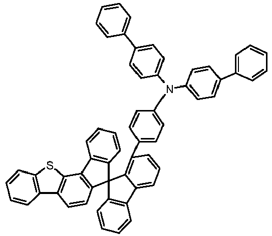 | 60% |
| | | | | |
| **4-8** | 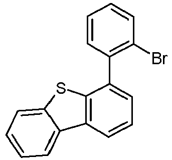 | 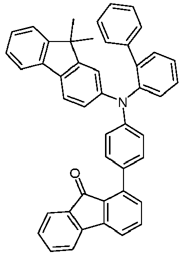 | 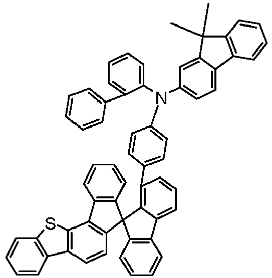 | 52% |
| **4-9** | 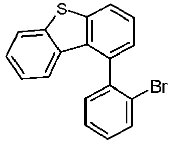 | 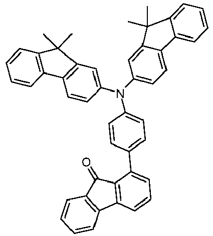 | 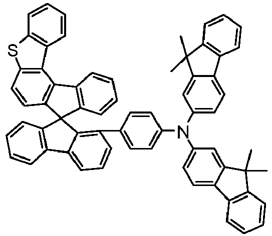 | 60% |

### Beispiel 5: Synthese der Verbindungen 5-1 bis 5-3

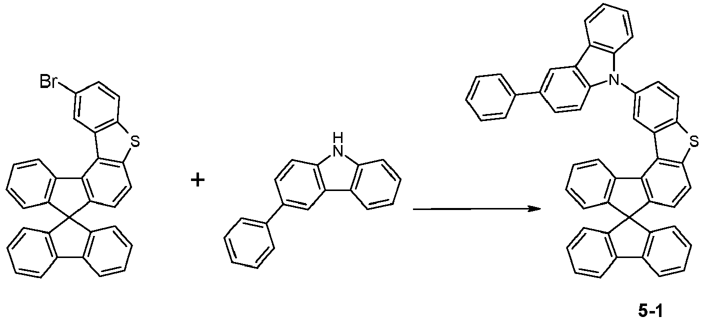

10,5 g (43 mmol) 3-Phenylcarbazol und 18 g (36 mmol) des Bromo-Spiroderivats werden in 30 mL Toluol gelöst. Die Lösung wird entgast und mit N₂ gesättigt. Danach wird sie mit 1,44 mL (1,44 mmol) einer 1M Tri-tert-Butylphosphin Lösung und 660 mg (0,72 mmol) Pd₂(dba)₃ versetzt und anschließend werden 5,28 g Natrium-tert-butylat (53,8 mmol) zugegeben. Die Reaktionsmischung wird 24 h unter Schutzatmosphäre zum Sieden erhitzt.

Das Gemisch wird im Anschluss zwischen Toluol und Wasser verteilt, die organische Phase dreimal mit Wasser gewaschen und über Na₂SO₄ getrocknet und einrotiert. Nach Filtration des Rohproduktes über Kieselgel mit Toluol wird der verbleibende Rückstand aus Heptan/Toluol umkristallisiert und abschließend im Hochvakuum sublimiert. Die Reinheit beträgt 99.9%(HPLC). Die Ausbeute von Verbindung (**5-1**) beträgt 14 g (60% der Theorie).

### Synthese der Verbindungen (5-2) und (5-3)

Analog zu der in Beispiel 1 beschriebenen Synthese von Verbindung (**5-1**) werden auch die folgenden Verbindungen (**5-2**) und (**5-3**) hergestellt.

Analog werden die folgenden Verbindungen erhalten:

| | Edukt 1 | Edukt 2 | Produkt | Ausbeute |
|---|---|---|---|---|
| **5-2** | 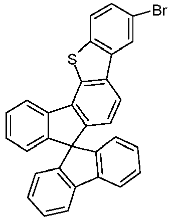 | 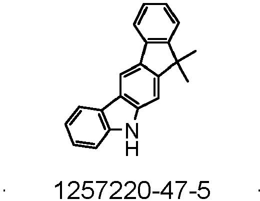 | 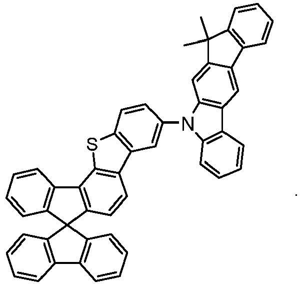 | 50% |
| **5-3** | 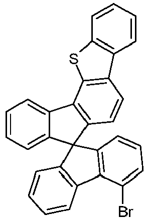 | 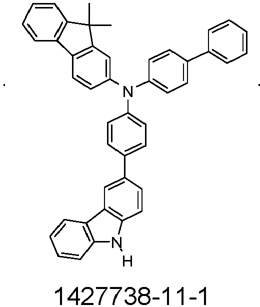 | 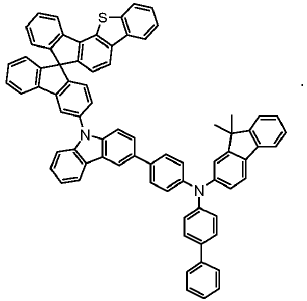 | 45% |

### B) Device-Beispiele

Die Herstellung von erfindungsgemäßen OLEDs sowie OLEDs nach dem Stand der Technik erfolgt nach einem allgemeinen Verfahren gemäß WO 04/058911, das auf die hier beschriebenen Gegebenheiten (z.B. Materialien) angepasst wird.

In den folgenden erfindungsgemäßen Beispielen werden die Daten verschiedener OLEDs vorgestellt. Als Substrate werden Glasplättchen verwendet, die mit strukturiertem ITO (Indium Zinn Oxid) der Dicke 50 nm beschichtet sind. Die OLEDs haben folgenden Schichtaufbau: Substrat / p-dotierte Lochtransportschicht (HIL1) / Lochtransportschicht (HTL) / p-dotierte Lochtransportschicht (HTL2) / Elektronenblockierschicht (EBL) / Emissionsschicht (EML) / Elektronentransportschicht (ETL) / Elektroneninjektionsschicht (EIL) und abschließend eine Kathode. Die Kathode wird durch eine 100 nm dicke Aluminiumschicht gebildet. Die zur Herstellung der OLEDs benötigten Materialien sind in Tabelle 1 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie H1:SEB(5%) bedeutet hierbei, dass das Material H1 in einem Volumenanteil von 95 % und SEB in einem Volumenanteil von 5 % in der Schicht vorliegt. Analog können auch die Elektronentransportschichten oder die Lochinjektionsschichten aus einer Mischung von zwei oder mehr Materialien bestehen.

Die OLEDs werden standardmäßig charakterisiert. Hierfür wird die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Angabe EQE @ 10 mA/cm² bezeichnet die externe Quanteneffizienz bei einer Stromdichte von 10mA/cm². LD80 @ 60 mA/cm² ist die Lebensdauer, bis zu der die OLED bei einer Starthelligkeit bei konstantem Strom von 60 mA/cm² auf 80 % der Anfangsintensität abgefallen ist.

| ***Tabelle 1: Strukturen der verwendeten Materialien*** | | |
|---|---|---|
| 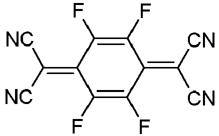 | 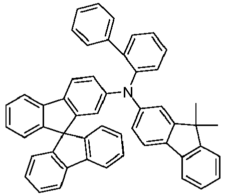 | 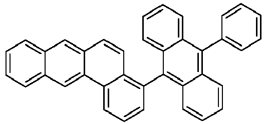 |
| F4TCNQ | HIM | H1 |
| 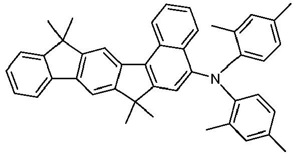 | 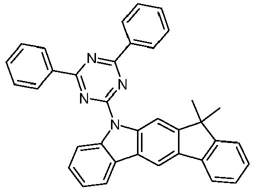 | 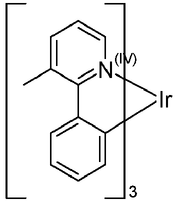 |
| SEB | H2 | TEG |
| 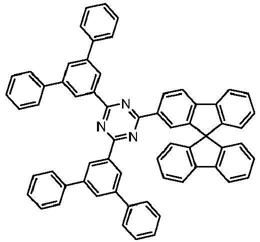 | 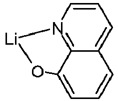 | |
| ETM | LiQ | |
| 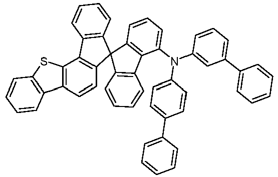 | 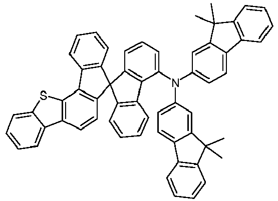 | 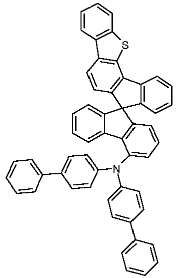 |
| HTM1 | HTM2 | HTM3 |
| 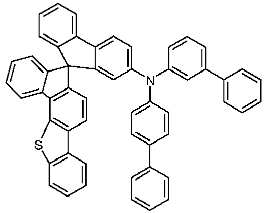 | 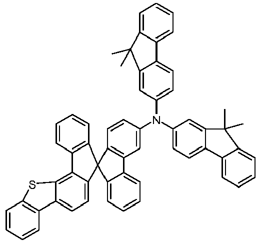 | |
| HTMv1 | HTMv2 | |

### Beispiel 1:

Es werden die erfindungsgemäße Verbindung HTM1 und die Vergleichsverbindung HTMv1 in einem blau emittierenden OLED-Stack miteinander verglichen. Der Aufbau des Stacks gliedert sich wie folgt: HIM:F4TCNQ(5%)(20nm) / HIM(155nm) / HTM1:F4TCNQ(5%)(20nm) / HTM1(20nm) / H1:SEB(5%)(20nm) / ETM:LiQ(50%)(30nm) / LiQ(1nm). Im Vergleichsbeispiel wird statt HTM1 in allen betroffenen Schichten HTMv1 verwendet.

Die Evaluation der externen Quanteneffizienzen bei 10mA/cm² zeigt für die durchgeführten Experimente die folgenden Ergebnisse: HTM1 erzielt 7,7% EQE, wohingegen HTMv1 nur 7,0% erreicht. Die Lebensdauern der erzeugten Devices bis zum Abfall auf 80% der Anfangsintensität bei einem konstanten Strom von 60mA/cm² zeigen den Vorteil von Verbindung HTM1 noch deutlicher. Diese belaufen sich auf 380 Stunden bei HTM1, wohingegen HTMv1 lediglich 270 Stunden erreicht.

### Beispiel 2:

Mit den gleichen zwei Materialien wie in Beispiel 1 wird ein Triplett-Grünbauteil hergestellt, dessen Aufbau sich wie folgt gliedert: HIM:F4TCNQ(5%)(20nm) / HIM(210nm) / HTM1:F4TCNQ(5%)(20nm) / HTM1(20nm) / H2:TEG(10%)(30nm) / ETM:LiQ(50%)(40nm) / LiQ(1nm). In dem Vergleichsbeispiel wird HTM1 durch HTMv1 ersetzt.

Die externen Quanteneffizienzen zeigen einen ähnlichen Trend wie in der blau emittierenden OLED des Beispiels 1. Die externe Quanteneffizienz für HTM1 liegt bei 2mA/cm² in diesem Versuch bei 19,4%. Das Bauteil mit HTMv1 erzielt 19,1%. Die Lebensdauer von HTM1 ist auch hier deutlich höher als beim Vergleichs-HTM. HTM1 hat bei 20mA/cm² eine Lebensdauer bis zum Abfall auf 80% der Anfangsintensität von 160 Stunden. HTMv1 besitzt eine LD80 von 110 Stunden.

### Beispiel 3:

In einem weiteren Versuch werden die Verbindungen HTM2 und HTMv2 verglichen. Hier sind die unterschiedlichen Leistungsdaten noch deutlicher zu unterscheiden. Es wird wieder der blaue Singulett-Stack (vgl. Beispiel 1) mit folgendem Aufbau verwendet: HIM:F4TCNQ(5%)(20nm) / HIM(155nm) / HTM2:F4TCNQ(5%)(20nm) / HTM2(20nm) / H1:SEB(5%)(20nm) / ETM:LiQ(50%)(30nm) / LiQ(1nm), wobei beim Vergleichsversuch statt HTM2 das HTMv2 an allen entsprechenden Stellen im Stack eingefügt wird.

Bei der Auswertung der Versuchsdaten zeigt das Experiment mit HTM2 eine externe Quanteneffizienz bei 10mA/cm² von 7,9%, wohingegen HTMv2 lediglich 7,3% zeigt. Die Lebensdauern zeigen einen deutlichen Unterschied der beiden Materialien. Der Stack mit HTM2 besitzt eine Lebensdauer LD80 bei 60mA/cm² von 330 Stunden. HTMv2 erreicht bei gleichen Bedingungen nur 190 Stunden.

### Beispiel 4:

Auch im getesteten Triplett-Grün-Bauteil sieht man ähnliche Trends. Der Stack ist analog zum vorher beschriebenen grün emittierenden OLED-Stack (vgl. Beispiel 3): HIM:F4TCNQ(5%)(20nm) / HIM(210nm) / HTM2:F4TCNQ(5%)(20) / HTM2(20) / H2:TEG(10%)(30nm) / ETM:LiQ(50%)(40nm) / LiQ(1nm).lm Vergleichsversuch wird wieder HTM2 durch HTMv2 ersetzt.

Bei der externen Quanteneffizienz bei 2mA/cm² liegt HTM2 bei 19,2%, HTMv2 erreicht lediglich 17,7%. Die LD80 @ 20mA/cm² beträgt im HTM2-Stack 170 Stunden und im Vergleichsaufbau mit HTMv2 bei 100 Stunden.

### Beispiel 5:

Schließlich wird noch die Verbindung HTM3 in einem Singulett-Blau-Stack getestet. Dieser hat den folgenden Aufbau (HIM:F4TCNQ(5%)(20nm) / HIM(155nm) / HTM3:F4TCNQ(5%)(20nm) / HTM3 (20nm) / H1:SEB(5%)(20nm) / ETM:LiQ(50%)(30nm) / LiQ(1nm)). Die Verbindung HTM3 zeigt hierbei eine externe Quanteneffizienz bei 10mA/cm² von 7,6%. Die Lebensdauer bis 80% und 60mA/cm² liegt bei 340 Stunden.

### Beispiel 6:

In einem Triplett-Grün-Bauteil mit der folgenden Struktur: HIM:F4TCNQ(5%)(20nm) / HIM(210nm) / HTM3:F4TCNQ(5%)(20nm) / HTM3(20nm) / H2:TEG(10%)(30nm) / ETM:LiQ(50%)(40nm) / LiQ(1nm) zeigt die Verbindung HTM3 eine externe Quanteneffizienz bei 2mA/cm² von 17,8% und eine Lebensdauer LD80 @20mA/cm² von 150 Stunden.

Zusammenfassend zeigen die Device-Beispiele, dass mit den erfindungsgemäßen Verbindungen hervorragende Performance-Daten in OLEDs erreicht werden, insbesondere hervorragende Lebensdauer und Quanteneffizienz, sowohl in Systemen mit fluoreszierenden Emittern als auch in Systemen mit phosphoreszierenden Emittern.

Die Substitution mit einer Arylaminogruppe in der spezifischen Position am Spirobifluoren, wie sie in den Verbindungen HTM1 bis HTM3 vorliegt, führt zudem zu deutlich verbesserter Device-Performance verglichen mit der Substitution in der 2- und 3-Position, wie sie in den Vergleichsbeispielen HTMv1 bzw. HTMv2 vorliegt.

## Patentansprüche

1. Verbindung der Formel (I) 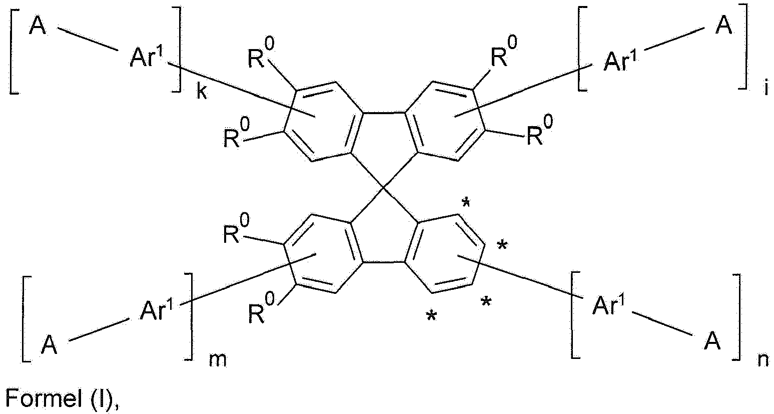
- die eine Gruppe der Formel (T) 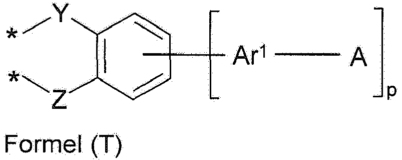 gebunden an zwei benachbarten mit * markierten Positionen an der Grundstruktur gemäß Formel (I) aufweist, wobei die Ankondensation derart ist, dass eine mit * markierte Bindung in Formel (T) jeweils an eine mit * markierte Position an der Grundstruktur gemäß Formel (I) anknüpft;
- die an einer oder mehreren unsubstituiert dargestellten Positionen an der Grundstruktur gemäß Formel (I) und der Gruppe der Formel (T) mit einem Rest R¹ substituiert sein kann; und
- die die folgenden Definitionen der Variablen aufweist:
A ist bei jedem Auftreten gleich oder verschieden eine Gruppe der Formel (A1), (A2) oder (A3), die über die mit # markierte Bindung gebunden ist, und die an einer oder mehreren unsubstituiert dargestellten Positionen mit einem Rest R² substituiert sein kann; 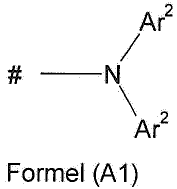 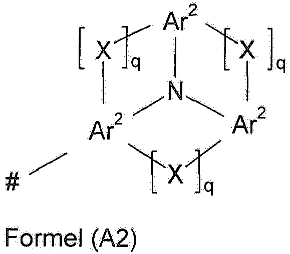 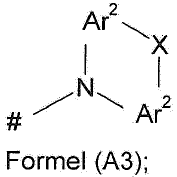
Ar¹ ist bei jedem Auftreten gleich oder verschieden eine Einfachbindung oder ein aromatisches oder heteroaromatisches Ringsystem mit 6 bis 30 aromatischen Ringatomen, das mit einem oder mehreren Resten R² substituiert sein kann;
Ar² ist bei jedem Auftreten gleich oder verschieden ein aromatisches oder heteroaromatisches Ringsystem mit 6 bis 30 aromatischen Ringatomen, das mit einem oder mehreren Resten R² substituiert sein kann;
X ist bei jedem Auftreten gleich oder verschieden eine Einfachbindung oder eine Gruppe gewählt aus BR², C(R²)₂, Si(R²)₂, C=O, O, S, S=O, SO₂, NR², PR² oder P(=O)R²;
Y ist gewählt aus O, S und Se;
Z ist gewählt aus O, S, Se und einer Einfachbindung, wobei Z nicht eine Einfachbindung ist, wenn Y gleich O ist;
R⁰ ist H;
R¹ ist bei jedem Auftreten gleich oder verschieden gewählt aus H, D, F, C(=O)R³, CN, Si(R³)₃, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³), -O-, -S-, SO oder SO₂ ersetzt sein können;
R² ist bei jedem Auftreten gleich oder verschieden gewählt aus H, D, F, C(=O)R³, CN, Si(R³)₃, N(R³)₂, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxy-gruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R² miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³),-O-, -S-, SO oder SO₂ ersetzt sein können;
R³ ist bei jedem Auftreten gleich oder verschieden gewählt aus H, D, F, C(=O)R⁴, CN, Si(R⁴)₃, N(R⁴)₂, P(=O)(R⁴)₂, OR⁴, S(=O)R⁴, S(=O)₂R⁴, geradkettigen Alkyl- oder Alkoxygruppen mit 1 bis 20 C-Atomen, verzweigten oder cyclischen Alkyl- oder Alkoxy-gruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ bzw. R² miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R⁴ substituiert sein können; und wobei eine oder mehrere CH₂-Gruppen in den genannten Alkyl-, Alkoxy-, Alkenyl- und Alkinylgruppen durch -R⁴C=CR⁴-, -C=C-, Si(R⁴)₂, C=O, C=NR⁴, -C(=O)O-, -C(=O)NR⁴-, NR⁴, P(=O)(R⁴), -O-, -S-, SO oder SO₂ ersetzt sein können;
R⁴ ist bei jedem Auftreten gleich oder verschieden gewählt aus H, D, F, CN, Alkylgruppen mit 1 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R⁴ miteinander verknüpft sein können und einen Ring bilden können; und wobei die genannten Alkylgruppen, aromatischen Ringsysteme und heteroaromatischen Ringsysteme mit F oder CN substituiert sein können;
q ist bei jedem Auftreten gleich oder verschieden 0 oder 1, wobei mindestens ein q in Formel (A2) gleich 1 ist;
i, k, m, n und p sind bei jedem Auftreten gleich oder verschieden 0 oder 1, wobei mindestens einer dieser Indices gleich 1 ist und
wobei die Gruppen in eckigen Klammern mit Index i, k, m, n und p nur in solchen Positionen am Spirobifluoren-Grundgerüst gebunden sein können, die unsubstituiert gezeichnet sind.

2. Verbindung nach Anspruch 1, **dadurch gekennzeichnet, dass** sie einer der folgenden Formeln entspricht:
| | |
|---|---|
| 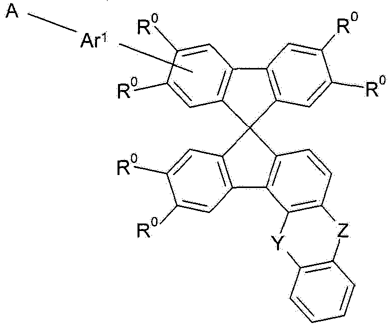 | 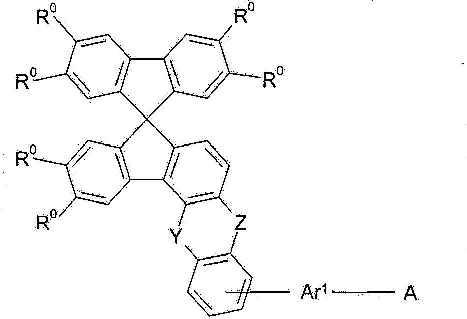 |
| Formel (I-1) | Formel (I-2) |
| | |
|---|---|
| 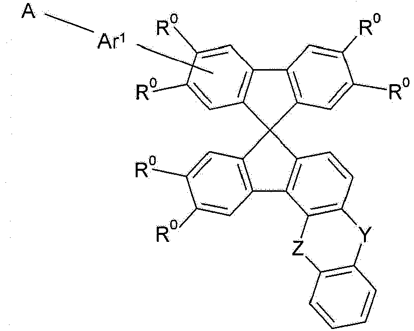 | 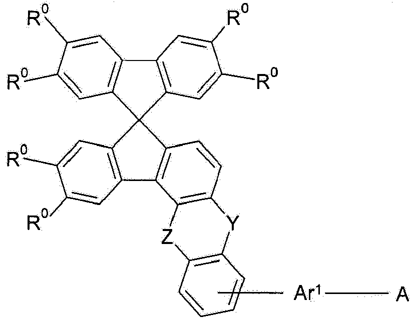 |
| **Formel (I-3)** | **Formel (I-4)** |
| 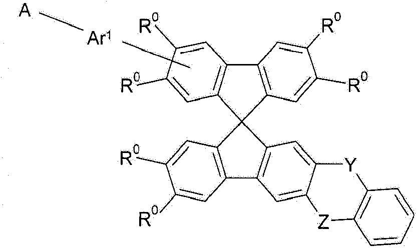 | 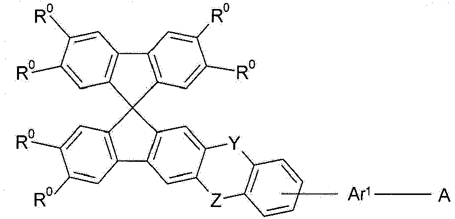 |
| **Formel (I-5)** | **Formel (I-6)** |
| 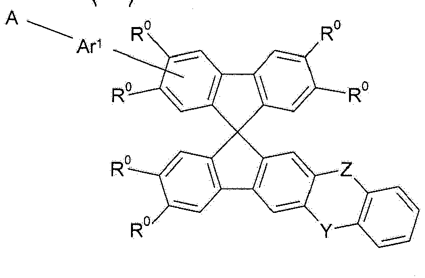 | 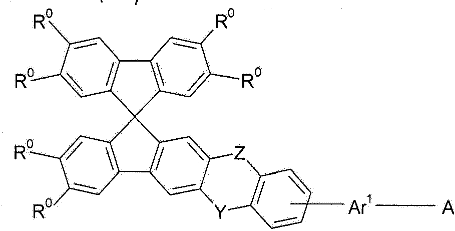 Formel (I-6) |
| **Formel (I-7)** | **Formel (I-8)** |
| 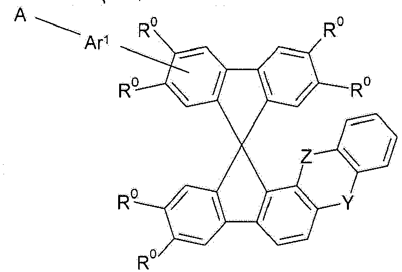 | 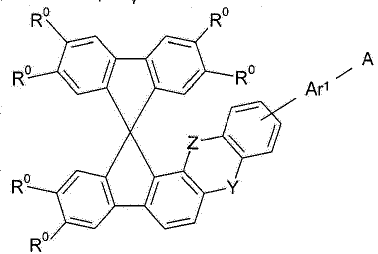 |
| **Formel (I-9)** | **Formel (I-10)** |
| 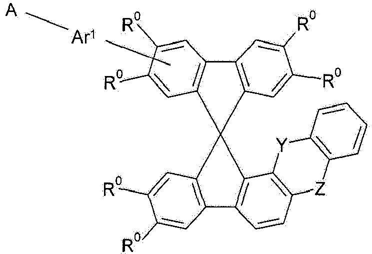 | 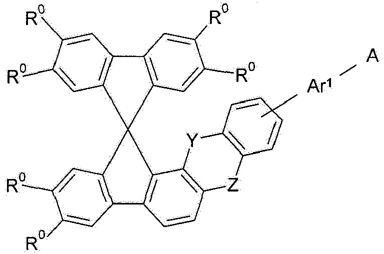 |
| Formel (I-11) | Formel (I-12) |
wobei die auftretenden Symbole wie in Anspruch 1 definiert sind, und die Verbindungen an unsubstituiert dargestellten Positionen mit Resten R¹ substituiert sein können.

3. Verbindung nach Anspruch 1 oder 2, **dadurch gekennzeichnet, dass** A eine Gruppe der Formel (A-1) ist.

4. Verbindung nach einem oder mehreren der Ansprüche 1 bis 3, **dadurch gekennzeichnet, dass** Ar¹ bei jedem Auftreten gleich oder verschieden gewählt ist aus einer Einfachbindung oder einer divalenten Gruppe abgeleitet von wahlweise mit Resten R² substituiertem Benzol, Biphenyl, Terphenyl, Fluoren, Spirobifluoren, Indenofluoren, Carbazol, Dibenzofuran, Dibenzothiophen, oder einer Kombination von zwei oder mehr dieser Gruppen, wobei jedoch nicht mehr als 30 aromatische Ringatome in Ar¹ vorliegen dürfen.

5. Verbindung nach einem oder mehreren der Ansprüche 1 bis 4, **dadurch gekennzeichnet, dass** Ar² bei jedem Auftreten gleich oder verschieden gewählt ist aus Phenyl, Biphenyl, Terphenyl, Fluorenyl, Spirobifluorenyl, Indenofluorenyl, Naphthyl, Phenanthrenyl, Furanyl, Benzofuranyl, Dibenzofuranyl, Thiophenyl, Benzothiophenyl, Dibenzothiophenyl, Carbazolyl, Indolocarbazolyl und Indenocarbazolyl, welche jeweils mit einem oder mehreren Resten R² substituiert sein können.

6. Verbindung nach einem oder mehreren der Ansprüche 1 bis 5, **dadurch gekennzeichnet, dass** X eine Einfachbindung ist.

7. Verbindung nach einem oder mehreren der Ansprüche 1 bis 6, **dadurch gekennzeichnet, dass** R¹ und R² bei jedem Auftreten gleich oder verschieden H, D, F, CN, eine geradkettige Alkylgruppe mit 1 bis 10 C-Atomen oder eine verzweigte oder cyclische Alkylgruppe mit 3 bis 10 C-Atomen, oder ein aromatisches oder heteroaromatisches Ringsystem mit 6 bis 25 aromatischen Ringatomen, wobei die genannten Alkyl- und Alkoxygruppen und die genannten aromatischen oder heteroaromatischen Ringsysteme jeweils mit einem oder mehreren Resten R³ substituiert sein können, sind.

8. Verbindung nach einem oder mehreren der Ansprüche 1 bis 7, **dadurch gekennzeichnet, dass** p gleich 1 ist, und dass alle anderen Indices k, i, m und n gleich 0 sind, oder **dadurch gekennzeichnet, dass** k gleich 1 ist, und dass alle anderen Indices i, m, n und p gleich 0 sind.

9. Verbindung nach einem oder mehreren der Ansprüche 1 bis 8, **dadurch gekennzeichnet, dass** die Summe der Indices i, k, m, n und p gleich 1 ist.

10. Verbindung nach einem oder mehreren der Ansprüche 1 bis 9, **dadurch gekennzeichnet, dass** die Gruppe Y gleich S ist, und die Gruppe Z gleich O, S oder eine Einfachbindung ist.

11. Verbindung nach einem oder mehreren der Ansprüche 1 bis 10, **dadurch gekennzeichnet, dass** die Gruppe Y gleich S ist, und die Gruppe Z eine Einfachbindung ist.

12. Verfahren zur Herstellung einer Verbindung nach einem oder mehreren der Ansprüche 1 bis 11, **dadurch gekennzeichnet, dass** entweder
A) zunächst das mit einer reaktiven Gruppe substituierte Spirobifluoren-Grundgerüst durch Reaktion eines Dibenzothiophenyl-Derivats mit einem Fluorenon-Derivat, welches die reaktive Gruppe trägt, hergestellt wird, und in einem späteren Schritt über eine metallorganische Kupplungsreaktion eine Diarylamino- oder eine Carbazolgruppe oder eine Aryl- oder Heteroarylgruppe, die mit einer Diarylamino- oder Carbazolgruppe substituiert ist, an der Position der reaktiven Gruppe eingeführt wird, oder
B) die Reaktion eines Dibenzothiophenyl-Derivats mit einem Fluorenon, welches eine Diarylamino- oder eine Carbazolgruppe oder eine Aryl- oder Heteroarylgruppe, die mit einer Diarylamino- oder Carbazolgruppe substituiert ist, trägt, umfasst ist, oder
C) zunächst ein Spirobifluoren-Grundgerüst durch Reaktion eines Dibenzothiophenyl-Derivats mit einem Fluorenon-Derivat hergestellt wird, dieses dann mit einer reaktiven Gruppe funktionalisiert wird, und in einem späteren Schritt über eine metallorganische Kupplungsreaktion eine Diarylamino- oder eine Carbazolgruppe oder eine Aryl- oder Heteroarylgruppe, die mit einer Diarylamino- oder Carbazolgruppe substituiert ist, an der Position der reaktiven Gruppe eingeführt wird.

13. Oligomer, Polymer oder Dendrimer, enthaltend eine oder mehrere Verbindungen der Formel (I) nach einem oder mehreren der Ansprüche 1 bis 11, wobei die Bindung(en) zum Polymer, Oligomer oder Dendrimer an beliebigen, in Formel (I) mit R⁰, R¹ oder R² substituierten Positionen lokalisiert sein können.

14. Formulierung, enthaltend mindestens eine Verbindung nach einem oder mehreren der Ansprüche 1 bis 11, oder mindestens ein Polymer, Oligomer oder Dendrimer nach Anspruch 13, sowie mindestens ein Lösungsmittel.

15. Verwendung einer Verbindung nach einem oder mehreren der Ansprüche 1 bis 11 oder eines Oligomers, Polymers oder Dendrimers nach Anspruch 13 in einer elektronischen Vorrichtung.

16. Elektronische Vorrichtung, enthaltend mindestens eine Verbindung nach einem oder mehreren der Ansprüche 1 bis 11 oder mindestens ein Oligomer, Polymer oder Dendrimer nach Anspruch 13.

17. Elektronische Vorrichtung nach Anspruch 16, gewählt aus der Gruppe bestehend aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs).

18. Organische Elektrolumineszenzvorrichtung nach Anspruch 17, **dadurch gekennzeichnet, dass** die mindestens eine Verbindung oder das mindestens eine Oligomer, Polymer oder Dendrimer in einer Schicht gewählt aus Lochtransportschichten und emittierenden Schichten vorliegt.

19. Organische Elektrolumineszenzvorrichtung nach Anspruch 18, **dadurch gekennzeichnet, dass** die mindestens eine Verbindung oder das mindestens eine Oligomer, Polymer oder Dendrimer in einer emittierenden Schicht zusammen mit einem oder mehreren phosphoreszierenden Emittern vorliegt.

20. Organische Elektrolumineszenzvorrichtung nach Anspruch 18, **dadurch gekennzeichnet, dass** die mindestens eine Verbindung oder das mindestens eine Oligomer, Polymer oder Dendrimer in einer Lochtransportschicht zusammen mit einem oder mehreren p-Dotanden vorliegt.

## Claims

1. Compound of the formula (I) 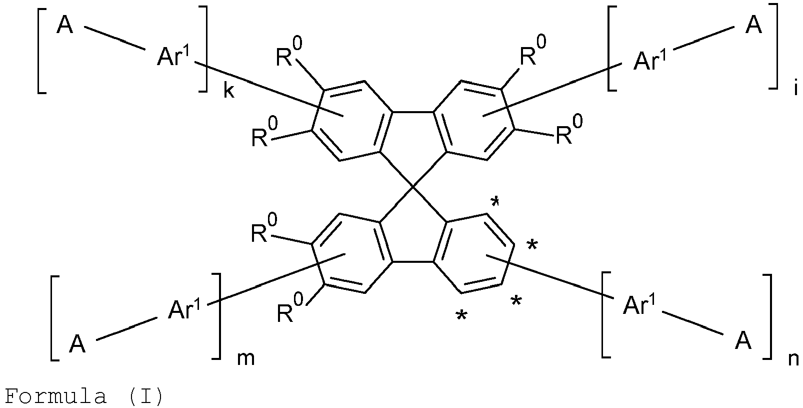
- which has a group of the formula (T) 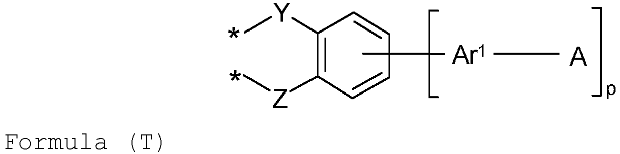 bonded at two adjacent positions marked by * to the base structure of formula (I), where the condensation is such that any bond marked by * in formula (T) is attached in each case at a position marked by * to the base structure of formula (I);
- which may be substituted at one or more positions shown as unsubstituted in the base structure of formula (I) and the group of the formula (T) by an R¹ radical; and
- which has the following definitions of the variables:
A is the same or different at each instance and is a group of the formula (A1), (A2) or (A3) which is bonded via the bond marked by # and may be substituted at one or more positions shown as unsubstituted by an R² radical; 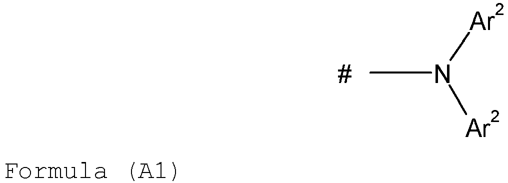 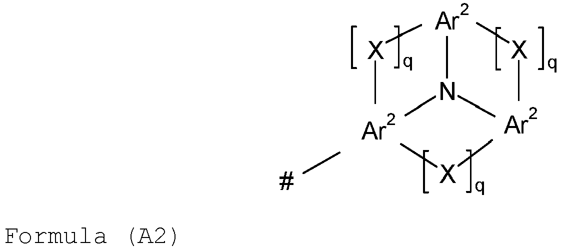 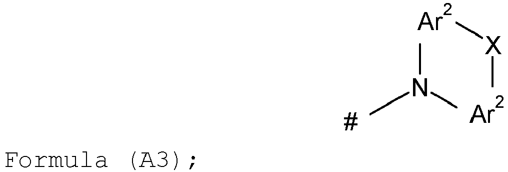
Ar¹ is the same or different at each instance and is a single bond or an aromatic or heteroaromatic ring system which has 6 to 30 aromatic ring atoms and may be substituted by one or more R² radicals;
Ar² is the same or different at each instance and is an aromatic or heteroaromatic ring system which has 6 to 30 aromatic ring atoms and may be substituted by one or more R² radicals;
X is the same or different at each instance and is a single bond or a group selected from BR², C(R²)₂, Si (R²)₂, C=O, O, S, S=O, SO₂, NR², PR² and P(=O)R²;
Y is selected from O, S and Se;
Z is selected from O, S, Se and a single bond, where Z is not a single bond when Y is O;
R° is H;
R¹ is the same or different at each instance and is selected from H, D, F, C(=O)R³, CN, Si(R³)₃, P(=O)(R³)₂, OR³, S(=O)R³, S(=O)₂R³, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more R¹ radicals may be joined to one another and may form a ring; where the alkyl, alkoxy, alkenyl and alkynyl groups mentioned and the aromatic ring systems and heteroaromatic ring systems mentioned may each be substituted by one or more R³ radicals; and where one or more CH₂ groups in the alkyl, alkoxy, alkenyl and alkynyl groups mentioned may be replaced by -R³C=CR³-, -C≡C-, Si(R³)₂, C=O, C=NR³, -C(=O)O-, -C(=O)NR³-, NR³, P(=O)(R³), -O-, -S-, SO or SO₂;
R² is the same or different at each instance and is selected from H, D, F, C(=O)R³, CN, Si(R³)₃, N(R³)₂, P(=O) (R³)₂, OR³, S(=O)R³, S(=O)₂R³, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more R² radicals may be joined to one another and may form a ring; where the alkyl, alkoxy, alkenyl and alkynyl groups mentioned and the aromatic ring systems and heteroaromatic ring systems mentioned may each be substituted by one or more R³ radicals; and where one or more CH₂ groups in the alkyl, alkoxy, alkenyl and alkynyl groups mentioned may be replaced by -R³C=CR³-, -C≡C-, Si(R³)₂, C=O, C=NR³, -C(=O)O-, -C(=O)NR³-, NR³, P(=O)(R³), -O-, -S-, SO or SO₂;
R³ is the same or different at each instance and is selected from H, D, F, C(=O)R⁴, CN, Si(R⁴)₃, N(R⁴)₂, P(=O)(R⁴)₂, OR⁴, S(=O)R⁴, S(=O)₂R⁴, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more R¹ or R² radicals may be joined to one another and may form a ring; where the alkyl, alkoxy, alkenyl and alkynyl groups mentioned and the aromatic ring systems and heteroaromatic ring systems mentioned may each be substituted by one or more R⁴ radicals; and where one or more CH₂ groups in the alkyl, alkoxy, alkenyl and alkynyl groups mentioned may be replaced by-R⁴C=CR⁴-, -C≡C-, Si(R⁴)₂, C=O, C=NR⁴, -C(=O)O-, -C(=O)NR⁴-, NR⁴, P(=O) (R⁴), -O-, -S-, SO or SO₂; R⁴ is the same or different at each instance and is selected from H, D, F, CN, alkyl groups having 1 to 20 carbon atoms, aromatic ring systems having 6 to 40 aromatic ring atoms and heteroaromatic ring systems having 5 to 40 aromatic ring atoms; where two or more R⁴ radicals may be joined to one another and may form a ring; and where the alkyl groups, aromatic ring systems and heteroaromatic ring systems mentioned may be substituted by F or CN; qis the same or different at each instance and is 0 or 1, where at least one q in formula (A2) is 1; i, k, m, n and p are the same or different at each instance and are 0 or 1, where at least one of these indices is 1 and where the groups in square brackets with the indices i, k, m, n and p may be bonded to the spirobifluorene base skeleton only in those positions shown as unsubstituted.

2. Compound according to Claim 1, **characterized in that** it corresponds to one of the following formulae:
| | |
|---|---|
| 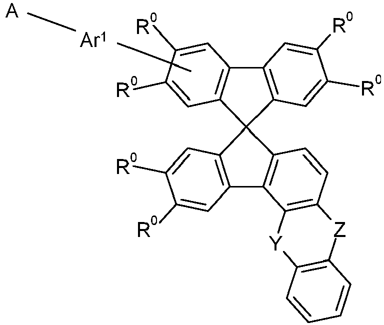 | 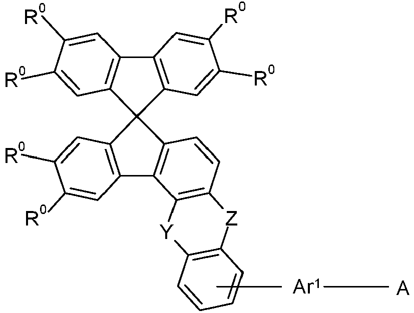 |
| Formula (I-1) | Formula (I-2) |
| 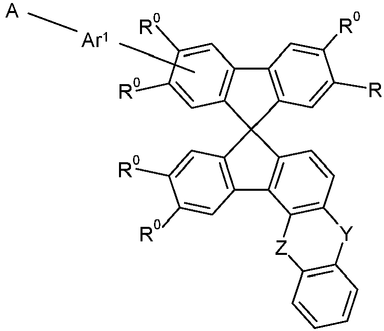 | 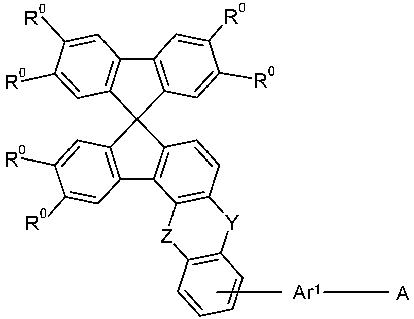 |
| Formula (I-3) | Formula (I-4) |
| 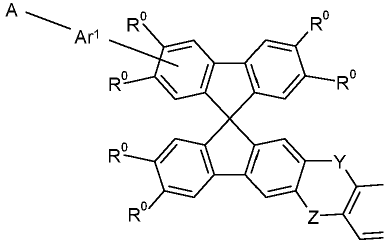 | 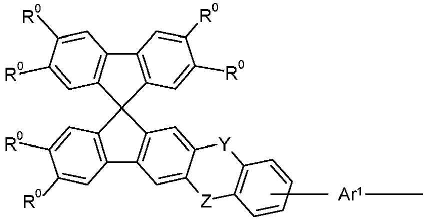 |
| Formula (I-5) | Formula (I-6) |
| 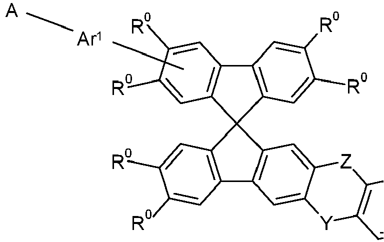 | 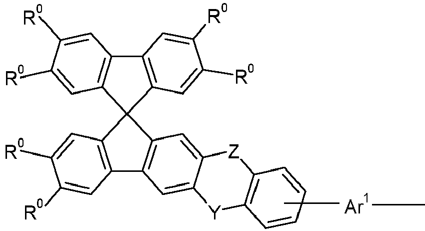 |
| Formula (I-7) | Formula (I-8) |
| 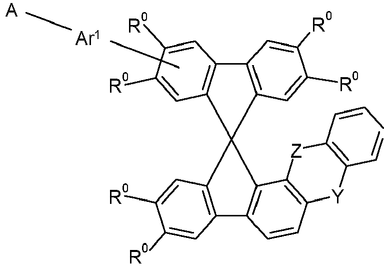 | 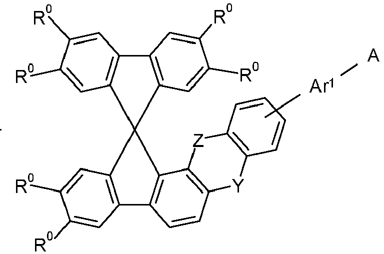 |
| Formula (I-9) | Formula (I-10) |
| 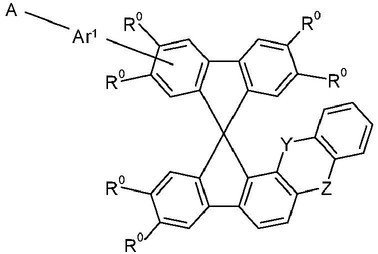 | 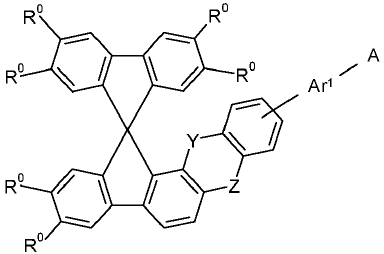 |
| Formula (I-11) | Formula (I-12) |
where the symbols that occur are as defined in Claim 1, and the compounds may be substituted at positions shown as unsubstituted by R¹ radicals.

3. Compound according to Claim 1 or 2, **characterized in that** A is a group of the formula (A-1).

4. Compound according to one or more of Claims 1 to 3, **characterized in that** Ar¹ is the same or different at each instance and is selected from a single bond and a divalent group derived from benzene, biphenyl, terphenyl, fluorene, spirobifluorene, indenofluorene, carbazole, dibenzofuran or dibenzothiophene, each optionally substituted by R² radicals, or a combination of two or more of these groups, but not more than 30 aromatic ring atoms may be present in Ar¹.

5. Compound according to one or more of Claims 1 to 4, **characterized in that** Ar² is the same or different at each instance and is selected from phenyl, biphenyl, terphenyl, fluorenyl, spirobifluorenyl, indenofluorenyl, naphthyl, phenanthrenyl, furanyl, benzofuranyl, dibenzofuranyl, thiophenyl, benzothiophenyl, dibenzothiophenyl, carbazolyl, indolocarbazolyl and indenocarbazolyl, each of which may be substituted by one or more R² radicals.

6. Compound according to one or more of Claims 1 to 5, **characterized in that** X is a single bond.

7. Compound according to one or more of Claims 1 to 6, **characterized in that** R¹ and R² are the same or different at each instance and are H, D, F, CN, a straight-chain alkyl group having 1 to 10 carbon atoms or a branched or cyclic alkyl group having 3 to 10 carbon atoms, or an aromatic or heteroaromatic ring system having 6 to 25 aromatic ring atoms, where the alkyl and alkoxy groups mentioned and the aromatic or heteroaromatic ring systems mentioned may each be substituted by one or more R³ radicals.

8. Compound according to one or more of Claims 1 to 7, **characterized in that** p is 1, and **in that** all the other indices k, i, m and n are 0, or **characterized in that** k is 1, and **in that** all the other indices i, m, n and p are 0.

9. Compound according to one or more of Claims 1 to 8, **characterized in that** the sum total of the indices i, k, m, n and p is 1.

10. Compound according to one or more of Claims 1 to 9, **characterized in that** the Y group is S, and the Z group is O, S or a single bond.

11. Compound according to one or more of Claims 1 to 10, **characterized in that** the Y group is S, and the Z group is a single bond.

12. Process for preparing a compound according to one or more of Claims 1 to 11, **characterized in that** either
A) first the spirobifluorene base skeleton substituted by a reactive group is prepared by reacting a dibenzothiophenyl derivative with a fluorenone derivative bearing the reactive group and, in a later step, via an organometallic coupling reaction, a diarylamino or carbazole group or an aryl or heteroaryl group substituted by a diarylamino or carbazole group is introduced at the position of the reactive group, or
B) the reaction of a dibenzothiophenyl derivative with a fluorenone bearing a diarylamino or carbazole group or an aryl or heteroaryl group substituted by a diarylamino or carbazole group is involved, or
C) first a spirobifluorene base skeleton is prepared by reacting a dibenzothiophenyl derivative with a fluorenone derivative, then the latter is functionalized with a reactive group and, in a later step, via an organometallic coupling reaction, a diarylamino or carbazole group or an aryl or heteroaryl group substituted by a diarylamino or carbazole group is introduced at the position of the reactive group.

13. Oligomer, polymer or dendrimer containing one or more compounds of the formula (I) according to one or more of Claims 1 to 11, wherein the bond(s) to the polymer, oligomer or dendrimer may be localized at any desired positions substituted by R°, R¹ or R² in formula (I) .

14. Formulation comprising at least one compound according to one or more of Claims 1 to 11, or at least one polymer, oligomer or dendrimer according to Claim 13, and at least one solvent.

15. Use of a compound according to one or more of Claims 1 to 11, or of an oligomer, polymer or dendrimer according to Claim 13, in an electronic device.

16. Electronic device comprising at least one compound according to one or more of Claims 1 to 11 or at least one oligomer, polymer or dendrimer according to Claim 13.

17. Electronic device according to Claim 16, selected from the group consisting of organic integrated circuits (OICs), organic field-effect transistors (OFETs), organic thin-film transistors (OTFTs), organic lightemitting transistors (OLETs), organic solar cells (OSCs), organic optical detectors, organic photoreceptors, organic field-quench devices (OFQDs), organic lightemitting electrochemical cells (OLECs), organic laser diodes (O-lasers) and organic electroluminescent devices (OLEDs).

18. Organic electroluminescent device according to Claim 17, **characterized in that** the at least one compound or the at least one oligomer, polymer or dendrimer is present in a layer selected from hole transport layers and emitting layers.

19. Organic electroluminescent device according to Claim 18, **characterized in that** the at least one compound or the at least one oligomer, polymer or dendrimer is present in an emitting layer together with one or more phosphorescent emitters.

20. Organic electroluminescent device according to Claim 18, **characterized in that** the at least one compound or the at least one oligomer, polymer or dendrimer is present in a hole transport layer together with one or more p-dopants.

## Revendications

1. Composé de formule (I) 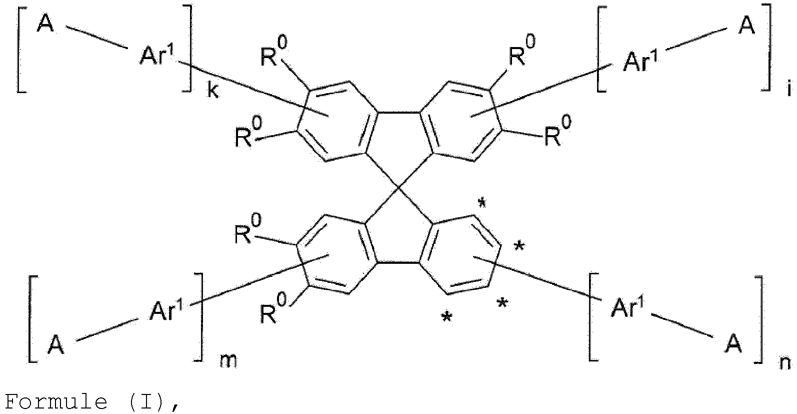
- qui comporte un groupe de formule (T) 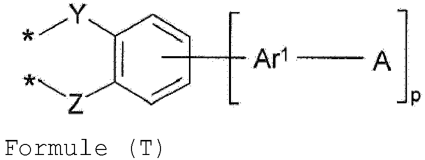 lié en deux positions voisines désignées par * à la structure de base selon la formule (I), la condensation étant telle qu'une liaison désignée par * dans la formule (T) est chaque fois attachée en une position désignée par * à la structure de base selon la formule (I)
- qui peut être substitué par un radical R¹ en une ou plusieurs positions représentées comme étant non substituées sur la structure de base selon la formule (I) et le groupe de formule (T) ; et
- qui présente les définitions suivantes des variables :
A est, identique ou différent à chaque occurrence, un groupe de formule (A1), (A2) ou (A3) qui est lié par la liaison désignée par #, et qui peut être substitué par un radical R² en une ou plusieurs positions représentées comme étant non substituées ; 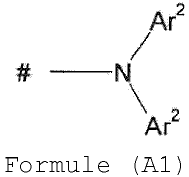 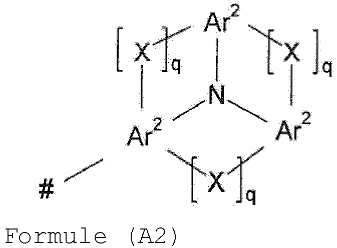 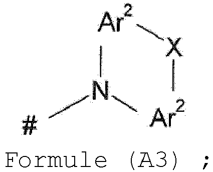
Ar¹ est, identique ou différent à chaque occurrence, une liaison simple ou un système cyclique aromatique ou hétéroaromatique ayant de 6 à 30 atomes formant le cycle aromatique, qui peut être substitué par un ou plusieurs radicaux R² ;
Ar² est, identique ou différent à chaque occurrence, un système cyclique aromatique ou hétéroaromatique ayant de 6 à 30 atomes formant le cycle aromatique, qui peut être substitué par un ou plusieurs radicaux R2 ;
X est, identique ou différent à chaque occurrence, une liaison simple ou un groupe choisi parmi BR², C(R²)₂, Si (R²)₂, C=O, O, S, S=O, SO₂, NR², PR² ou P(=O)R² ;
Y est choisi parmi O, S et Se ;
Z est choisi parmi O, S et Se et une liaison simple, Z n'étant pas une liaison simple lorsque Y représente O ;
R⁰ est H ;
R¹ est choisi, identique ou différent à chaque occurrence, parmi H, D, F, C(=O)R³, CN, Si(R³)₃, P(=O) (R³)₂, OR³, S(=O)R³, S(=O)₂R³, les groupes alkyle ou alcoxy à chaîne droite ayant de 1 à 20 atomes de carbone, les groupes alkyle ou alcoxy ramifiés ou cycliques ayant de 3 à 20 atomes de carbone, les groupes alcényle ou alcynyle ayant de 2 à 20 atomes de carbone, les systèmes cycliques aromatiques ayant de 6 à 40 atomes formant le cycle aromatique, et les systèmes cycliques hétéroaromatiques ayant de 5 à 40 atomes formant le cycle aromatique ; deux ou plus de deux radicaux R¹ pouvant être liés entre eux et pouvant former un cycle ; les groupes alkyle, alcoxy, alcényle et alcynyle cités et les systèmes cycliques aromatiques et systèmes cycliques hétéroaromatiques cités pouvant être substitués chacun par un ou plusieurs radicaux R³ ; et un ou plusieurs groupes CH₂ dans les groupes alkyle, alcoxy, alcényle et alcynyle cités pouvant être remplacés par -R³C=CR³-, -C≡C-, Si(R³)₂, C=O, C=NR³, -C(=O)O-, -C(=O)NR³, NR³, P(=O)(R³), -O-, -S-, SO ou SO₂ ;
R² est choisi, identique ou différent à chaque occurrence, parmi H, D, F, C(=O)R³, CN, Si(R³)₃, N(R³)₂, P (=O)(R³)₂, OR³, S(=O)R³, S (=O)₂R³, les groupes alkyle ou alcoxy à chaîne droite ayant de 1 à 20 atomes de carbone, les groupes alkyle ou alcoxy ramifiés ou cycliques ayant de 3 à 20 atomes de carbone, les groupes alcényle ou alcynyle ayant de 2 à 20 atomes de carbone, les systèmes cycliques aromatiques ayant de 6 à 40 atomes formant le cycle aromatique, et les systèmes cycliques hétéroaromatiques ayant de 5 à 40 atomes formant le cycle aromatique ; deux ou plus de deux radicaux R² pouvant être liés entre eux et pouvant former un cycle ; les groupes alkyle, alcoxy, alcényle et alcynyle cités et les systèmes cycliques aromatiques et systèmes cycliques hétéroaromatiques cités pouvant être substitués chacun par un ou plusieurs radicaux R³ ; et un ou plusieurs groupes CH₂ dans les groupes alkyle, alcoxy, alcényle et alcynyle cités pouvant être remplacés par -R³C=CR³-, -C≡C-, Si(R³)₂, C=O, C=NR³, -C(=O)O-, -C(=O)NR³, NR³, P(=O)(R³), -O-, -S-, SO ou SO₂ ;
R³ est choisi, identique ou différent à chaque occurrence, parmi H, D, F, C(=O)R⁴, CN, Si(R⁴)₃, N(R⁴)₂, P(=O)(R⁴)₂, OR⁴, S(=O)R⁴, S(=O)₂R⁴, les groupes alkyle ou alcoxy à chaîne droite ayant de 1 à 20 atomes de carbone, les groupes alkyle ou alcoxy ramifiés ou cycliques ayant de 3 à 20 atomes de carbone, les groupes alcényle ou alcynyle ayant de 2 à 20 atomes de carbone, les systèmes cycliques aromatiques ayant de 6 à 40 atomes formant le cycle aromatique, et les systèmes cycliques hétéroaromatiques ayant de 5 à 40 atomes formant le cycle aromatique ; deux ou plus de deux radicaux R¹ ou R² pouvant être liés entre eux et pouvant former un cycle ; les groupes alkyle, alcoxy, alcényle et alcynyle cités et les systèmes cycliques aromatiques et systèmes cycliques hétéroaromatiques cités pouvant être substitués chacun par un ou plusieurs radicaux R⁴ ; et un ou plusieurs groupes CH₂ dans les groupes alkyle, alcoxy, alcényle et alcynyle cités pouvant être remplacés par -R⁴C=CR⁴-, -C≡C-, Si(R⁴)₂, C=O, C=NR⁴, -C(=O)O-, -C(=O)NR⁴, NR⁴, P(=O)(R⁴), -O-, -S-, SO ou SO₂ ;
R⁴ est choisi, identique ou différent à chaque occurrence, parmi H, D, F, CN, les groupes alkyle ayant de 1 à 20 atomes de carbone, les systèmes cycliques aromatiques ayant de 6 à 40 atomes formant le cycle aromatique et les systèmes cycliques hétéroaromatiques ayant de 5 à 40 atomes formant le cycle aromatique ; deux ou plus de deux radicaux R⁴ pouvant être liés entre eux et pouvant former un cycle ; et les groupes alkyle, systèmes cycliques aromatiques et systèmes cycliques hétéroaromatiques cités pouvant être substitués par F ou CN ;
q est, identique ou différent à chaque occurrence, 0 ou 1, au moins un q dans la formule (A2) étant égal à 1 ;
i, k, m, n et p sont, identiques ou différents à chaque occurrence, 0 ou 1, au moins un de ces indices étant égal à 1 et
les groupes entre crochets portant l'un des indices i, k, m, n, n et p ne pouvant être liés au squelette de base spirobifluorène qu'en les positions qui sont figurées comme étant non substituées.

2. Composé selon la revendication 1, **caractérisé en ce qu'**il correspond à l'une des formules suivantes :
| | |
|---|---|
| 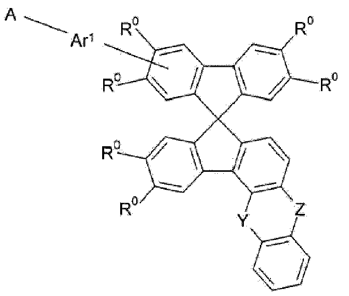 | 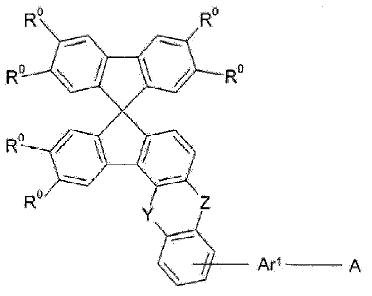 |
| Formule (I-1) | Formule (I-2) |
| 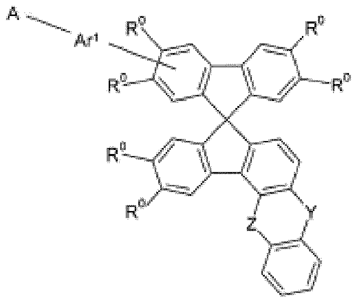 | 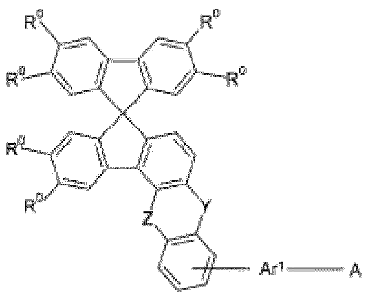 |
| Fomule (I-3) | Formule (I-4) |
| 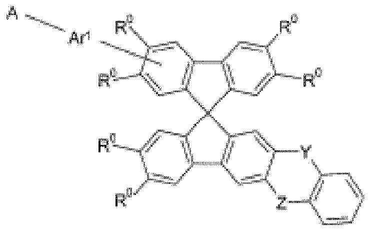 | 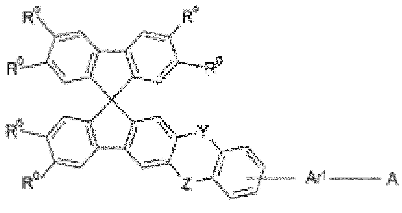 |
| Formule (I-5) | Forumle (I-6) |
| 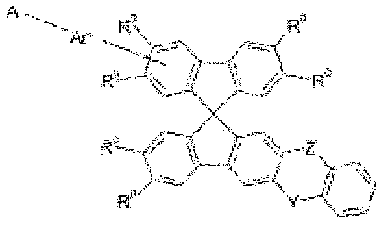 | 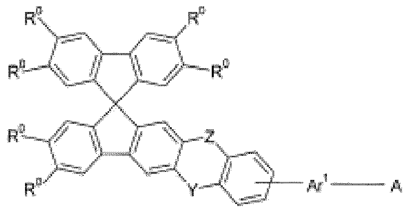 |
| Formule (I-7) | Formule (I-8) |
| 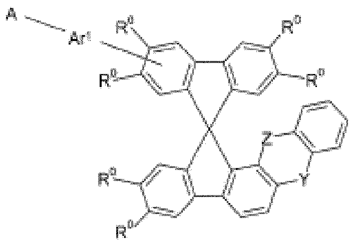 | 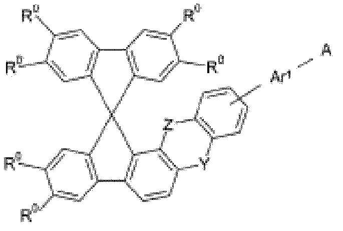 |
| Formule (I-9) | Formule (I-10) |
| 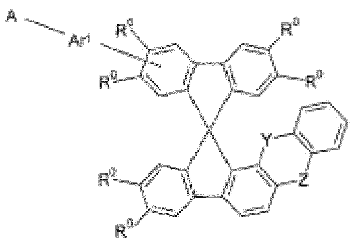 | 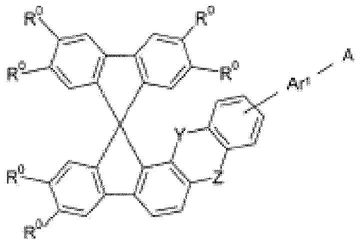 |
| **Formule (I-11)** | **Formule (I-12)** |
où les symboles apparaissant sont tels que définis dans la revendication 1, et les composés peuvent être substitués par des radicaux R¹ aux positions qui sont représentées comme étant non substituées.

3. Composé selon la revendication 1 ou 2, **caractérisé en ce que** A est un groupe de formule (A-1).

4. Composé selon une ou plusieurs des revendications 1 à 3, **caractérisé en ce que** Ar¹ est choisi, identique ou différent à chaque occurrence parmi une liaison simple ou un groupe divalent dérivé de benzène, biphényle, terphényle, fluorène, spirobifluorène, indénofluorène, carbazole, dibenzofurane, dibenzothiophène, en option substitué par des radicaux R², ou une combinaison de deux ou plus de deux de ces groupes, mais pas plus de 30 atomes formant le cycle aromatique ne pouvant être présents dans Ar¹

5. Composé selon une ou plusieurs des revendications 1 à 4, **caractérisé en ce que** Ar² est choisi, identique ou différent à chaque occurrence parmi les groupes phényle, biphényle, terphényle, fluorényle, spirobifluorényle, indénofluorényle, naphtyle, phénanthrényle, furanyle, benzofuranyle, dibenzofuranyle, thiophényle, benzothiophényle, dibenzothiophényle, carbazolyle, indolocarbazolyle et indénocarbazolyle, qui peuvent être substitués chacun par un ou plusieurs radicaux R².

6. Composé selon une ou plusieurs des revendications 1 à 5, **caractérisé en ce que** X est une liaison simple.

7. Composé selon une ou plusieurs des revendications 1 à 6, **caractérisé en ce que** R¹ et R² sont, identiques ou différents à chaque occurrence, H, D, F, CN, un groupe alkyle à chaîne droite ayant de 1 à 10 atomes de carbone ou un groupe alkyle ramifié ou cyclique ayant de 3 à 10 atomes de carbone, ou un système cyclique aromatique ou hétéroaromatique ayant de 6 à 25 atomes formant le cycle aromatique, les groupes alkyle et alcoxy cités et les systèmes cycliques aromatiques ou hétéroaromatiques cités pouvant être substitués chacun par un ou plusieurs radicaux R³.

8. Composé selon une ou plusieurs des revendications 1 à 7, **caractérisé en ce que** p est égal à 1, et **en ce que** tous les autres indices k, i, m et n sont égaux à 0, ou **caractérisé en ce que** k est égal à 1, et **en ce que** tous les autres indices i, m, n et p sont égaux à 0.

9. Composé selon une ou plusieurs des revendications 1 à 8, **caractérisé en ce que** la somme des indices i, k, m, n et p est égale à 1.

10. Composé selon une ou plusieurs des revendications 1 à 9, **caractérisé en ce que** le groupe Y représente S et le groupe Z représente O, S ou une liaison simple.

11. Composé selon une ou plusieurs des revendications 1 à 10, **caractérisé en ce que** le groupe Y représente S, et le groupe Z est une liaison simple.

12. Procédé pour la préparation d'un composé selon une ou plusieurs des revendications 1 à 11, **caractérisé en ce que** soit
A) d'abord la structure de base spirobifluorène substituée par un groupe réactif est préparée par réaction d'un dérivé de dibenzothiophényle avec un dérivé de fluorénone, qui porte le groupe réactif, et dans une étape ultérieure un groupe diarylamino ou un groupe carbazole ou un groupe aryle ou hétéroaryle qui est substitué par un groupe diarylamino ou carbazole, est introduit, par une réaction de couplage organométallique, à la position du groupe réactif, soit
B) est comprise la réaction d'un dérivé de dibenzothiophényle avec une fluorénone qui porte un groupe diarylamino ou un groupe carbazole ou un groupe aryle ou hétéroaryle qui est substitué par un groupe diarylamino ou carbazole, ou
C) d'abord une structure de base spirobifluorène est préparée par réaction d'un dérivé de dibenzothiophényle avec un dérivé de fluorénone, puis elle est fonctionnalisée avec un groupe réactif, et dans une étape ultérieure un groupe diarylamino ou un groupe carbazole ou un groupe aryle ou hétéroaryle qui est substitué par un groupe diarylamino ou carbazole, est introduit, par une réaction de couplage organométallique, à la position du groupe réactif.

13. Oligomère, polymère ou dendrimère, contenant un ou plusieurs composés de formule (I) selon une ou plusieurs des revendications 1 à 11, la/les liaison(s) au polymère, à l'oligomère ou au dendrimère pouvant être localisée(s) en des quelconques positions substituées par R⁰, R¹ ou R² dans la formule (I).

14. Formulation, contenant au moins un composé selon une ou plusieurs des revendications 1 à 11, ou au moins un polymère, oligomère ou dendrimère selon la revendication 13, ainsi qu'au moins un solvant.

15. Utilisation d'un composé selon une ou plusieurs des revendications 1 à 11 ou d'un oligomère, polymère ou dendrimère selon la revendication 13 dans un dispositif électronique.

16. Dispositif électronique, contenant au moins un composé selon une ou plusieurs des revendications 1 à 11 ou au moins un oligomère, polymère ou dendrimère selon la revendication 13.

17. Dispositif électronique selon la revendication 16, choisi dans le groupe constitué par les circuits intégrés organiques (OIC), les transistors à effet de champ organiques (OFET), les transistors en couches minces organiques (OTFT), les transistors électroluminescents organiques (OLET), les cellules solaires organiques (OSC), les détecteurs optiques organiques, les photorécepteurs organiques, les dispositifs à extinction de champ organiques (OFQD), les cellules électrochimiques électroluminescentes organiques (OLEC), les diodes laser organiques (O-Laser) et les dispositifs électroluminescents organiques (OLED).

18. Dispositif électroluminescent organique selon la revendication 17, **caractérisé en ce que** ledit au moins un composé ou ledit au moins un oligomère, polymère ou dendrimère est présent dans une couche choisie parmi les couches de transport de trous et les couches émettrices.

19. Dispositif électroluminescent organique selon la revendication 18, **caractérisé en ce que** ledit au moins un composé ou ledit au moins un oligomère, polymère ou dendrimère est présent dans une couche émettrice conjointement avec un ou plusieurs émetteurs phosphorescents.

20. Dispositif électroluminescent organique selon la revendication 18, **caractérisé en ce que** ledit au moins un composé ou ledit au moins un oligomère, polymère ou dendrimère est présent dans une couche de transport de trous avec un ou plusieurs dopants p.
